(19) Europäisches Patentamt
European Patent Office
Office européen des brevets

(11) EP 2 261 301 A1

(12) EUROPEAN PATENT APPLICATION

(43) Date of publication:
15.12.2010 Bulletin 2010/50

(51) Int Cl.:
*C09K 11/06* (2006.01) *H05B 33/14* (2006.01)

(21) Application number: 10182429.0

(22) Date of filing: 27.08.2003

(84) Designated Contracting States:
DE FR GB

(30) Priority: 27.08.2002 JP 2002247815
27.08.2002 JP 2002247816
14.02.2003 JP 2003037329

(62) Document number(s) of the earlier application(s) in accordance with Art. 76 EPC:
03791337.3 / 1 550 707

(71) Applicant: Fujifilm Corporation
Minato-ku
Tokyo (JP)

(72) Inventor: The designation of the inventor has not yet been filed

(74) Representative: Thun, Clemens
Mitscherlich & Partner
Patent- und Rechtsanwälte
Sonnenstrasse 33
80331 München (DE)

Remarks:
This application was filed on 29.09.2010 as a divisional application to the application mentioned under INID code 62.

(54) **Organometallic complexes, organic electroluminescent devices and organic electroluminescent displays**

(57) An object of the present invention is to provide an organic EL element which has excellent lifetime, light-emitting efficiency, color conversion efficiency, etc., and the like, and the organic EL element includes at least one selected from (1) a organometallic complex including a rhenium atom; one ligand which has a coordinated nitrogen atom and a coordinated oxygen atom, each coordinated with the rhenium atom, and has at least one $\pi$ conjugation part; and the other ligand coordinated with the rhenium atom in such a way that the ligand saturates the coordination number of the rhenium atom and the charge of the whole organometallic complex is neutral, (2) an organometallic complex including an rhenium atom; one ligand which has a coordinated nitrogen atom, a coordinated carbon atom, each coordinated with the rhenium atom, and has at least one $\pi$ conjugation part; and the other ligand coordinated with the rhenium atom in such a way that the ligand saturate the coordination number of the rhenium atom and the charge of the whole organometallic complex is neutral, and (3) an organometallic complex including at least one of Group 8 metal atoms selected from Group 8 metal element; one ligand which has at least one $\pi$ conjugation part and is coordinated with the atom; and a ligand which is selected from an aliphatic dithiolate ligand and a heteroaromatic dithiolate ligand, and is coordinated with the atom.

FIG. 1

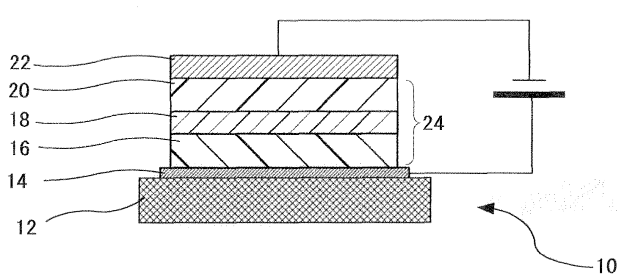


EP 2 261 301 A1

## Description

Technical Field

The present invention relates to an organometallic complex which exhibits phosphorescent luminescence and is suitable as a luminescent material and color conversion material etc., an organic EL element using the organometallic complex, and an organic EL display using the organometallic complex or organic EL element.

Background Art

An organic electroluminescent (EL) element has a structure in which one or a plurality of thin organic material layers is interposed between a negative electrode and a positive electrode. In the organic EL, a hole and an electron are injected into the organic material layer from the positive electrode and the negative electrode, respectively, the recombination energy, which is generated when the hole and electron is recombined in the organic material layer, causes the emission center of the luminescent material in the organic material layer excited, and when electrons in the luminescent material falls from an excited state to a ground state, light is emitted. The organic EL is a light-emitting element which uses this emitted light. The organic EL element has features such as self-luminousness and rapid response, exhibits satisfactory visual properties, is super-slim and lightweight, and is excellent in rapid response and movie display. Thus, it receives high expectations to be applied to flat panel displays. Particularly, since a two-layer (multi-layer) organic EL element comprising an organic thin film having positive hole transport properties (positive hole transport layer) and an organic thin film having electron transport properties (electron transport layer) has been reported (C. W. Tang and S. A. VanSlyke, Applied Physics Letters vol.51, p. 913 (1987)), organic EL elements have recently been attracting attention as a large area light-emitting element which emits light at a low voltage of 10V or less.

In a full color display, it is necessary to have pixels emitting light of three primary colors, blue (B), green (G) and red (R) arranged on a display panel. As the first method, for example, a method in which three types of organic EL elements, each emitting blue (B) light, green (G) light, and red (R) light are arrayed, is known (Japanese Patent Application Laid-Open (JP-A) No. 03-214593). As the second method, for example, a method in which light from an organic EL element emitting white light (which is a mixture of blue (B), green (G) and red (R)) is separated into three primary colors by color filters, is known (JP-A No. 03-19485). However, in the first method, three types of organic EL elements emitting three types of color light must be formed at predetermined position on the substrate in order, thus much time and cost are required for manufacturing a display and it is difficult to manufacture a display having high definition. Further, since each of the three types of organic EL elements have different lifetime, there are difficult problems to solve, for example, change in color tone of display with time occurs. In the second method, since white light (a mixture of blue (B), green (G) and red (R)) is separated into blue (B), green (G) and red (R), there is a fundamental problem that the method has low light-emitting efficiency in principle. Therefore, until now, a full color display having low light-emitting efficiency and long lifetime has not been obtained.

As the third method, for example, a method in which emission from an organic EL element emitting blue light is converted into green (G) light and red (R) light by a color conversion layer using fluorescence (JP-A No. 03-152897). In this third method, since a blue organic EL element is formed over the entire surface of the substrate, at blue pixels, emission is taken out without any conversion, and, at green pixels and red pixels, emission is taken out by converting the wavelength of light-emitting light from the blue organic EL element, display can be efficiently manufactured and theoretical value of light-emitting efficiency is expected to be high. Moreover, since only luminescent material in the blue organic EL element is used as a luminescent material, there is an advantage in that change in color tone of the display with time dose not occur. However, in the case of third method, since color conversion efficiency of the color conversion layer is low, color balance in the display cannot be controlled. In conventional techniques, color balance have been controlled by controlling the current value applied to an organic EL element, however, in this case, deterioration of pixels having specific color of emission the light emitted in a organic EL element is accelerated and depending on the operating time, overall color tone of the display is changed. There has also been proposed a method in which color balance is controlled by controlling luminescent area of each color pixel (JP-A No. 10-39791), however, in this case, since it is required that the luminescent area of pixels, there are problems, for example, that light-emitting efficiency and luminance are decreased and production cost increases.

Therefore, a full color display which is manufactured by the third method, in which an average driving current is constant regardless of light-emitting pixels and color balance is satisfactory without changing light emitting area, has not yet been provided and provision of such full color display are strongly desired.

In order to obtain such full color display, efficiency of color conversion in the color conversion layer are required to be improved. In the color conversion layer, fluorescent material is generally used, for example, when blue light-emitting light emitted by blue organic EL element are converted into red light by a color conversion layer, it is required that the luminescent material contained in the color conversion layer efficiently absorb blue light-emitting emitted from the blue

organic EL element and conversion into red light is carried out at high quantum efficiency. However, red fluorescent material having a luminescence peak in red-light wavelength region (600 to 650nm) has usually absorption peak in green-light wavelength region (500 to 600nm), therefore, the red fluorescent material cannot efficiently absorb the blue light-emitting light emitted by blue organic EL element. Therefore, in general, in a color conversion layer where blue light-emitting light are converted in color to red light, a host material which efficiently absorbs blue light is used in combination with the red fluorescent material. In the color conversion layer here the red fluorescent material is used in combination with the host material, blue light is converted in color to red light as follows. Specifically, the host material becomes an excited state by absorbing the blue light and when the host material returns to ground state from the excited state, energy is emitted. The energy is absorbed by the red fluorescent material to thereby become an excited state and when the red fluorescent material returns to ground state from the excited state, red light is released.

However, in the color conversion layer where the red fluorescent material is used in combination with the host material, most of the red fluorescent material forms association state called excimer when it is dispersed in the host material at high concentration so that emitted light is remarkably weakened (concentration quenching) and light having a different wavelength from that of the original emitted light. Thus, in order to obtain original emitted light, it is required that the red fluorescent material be dispersed in the host material at low concentration. On the contrary, from the viewpoint of the energy transfer efficiency from the host material, it is required that the red fluorescent material be dispersed in the host material at some level of high concentration. There is a problem in that it is extremely difficult to allow the red fluorescent material to be dispersed in the host material at concentration where the excimer is not formed and to allow the energy to be efficiently transferred from the host material to the red fluorescent material. Such color conversion layer and the material therefor to overcome the problem and have excellent color conversion efficiency has not been provided yet.

Separately, proposals have been made to improve light-emitting efficiency in the organic EL element. For example, from the viewpoint of obtaining an organic EL element having high light-emitting efficiency, it has been proposed to dope a small amount of molecules of pigment with high fluorescence as a guest material in a host material which is a main material so as to for a light-emitting layer having high light-emitting efficiency (C. W. Tang, S. A. VanSlyke, and C. H. Chen, Journal of Applied Physics vol.65, p. 3610 (1989)). Although proposals regarding improvement of light-emitting efficiency has been made, they have not been studied in terms of stability, lifetime or the like which are important properties for the organic EL element. It has gradually become clear that organic EL elements deteriorate according to various factors, for example, thermal factors, electrochemical factors, factors due to interface phenomena, etc. Although various kinds of organic EL element has been proposed in the related art (JP-A No. 2002-334787), an organic EL element which exhibits satisfactory light-emitting efficiency, lifetime and stability, etc. simultaneously has not been provided yet.

Further, as luminescent material in the organic EL element, the use of material exhibiting phosphorescent luminescence (JP-A No. 2002-334787). However, in this material, aromatic dithiol is used as a ligand and when the ligand is used as a luminescent material, there is a problem that not only PL quantum efficiency is reduced but also light-emitting efficiency is reduced and half-brightness lifetime is extremely shortened due to decrease of resistance to light.

Non-patent Document 1
C. W. Tang and S. A. VanSlyke, Applied Physics Letters vol.51, 913 (1987)
Non-patent Document 2
C. W. Tang, S. A. VanSlyke, and C. H. Chen, Journal of Applied Physics vol.65, 3610 (1989)
Patent Document 1
Japanese Patent Application Laid-Open No. 03-19485
Patent Document 2
Japanese Patent Application Laid-Open No. 03-19485
Patent Document 3
Japanese Patent Application Laid-Open No. 03-152897
Patent Document 4
Japanese Patent Application Laid-Open No. 10-39791
Patent Document 5
Japanese Patent Application Laid-Open No. 2002-334787

The present invention was carried out in view of the current situation and has an object to solve conventional problems and to provide an organometallic complex exhibiting phosphorescent luminescence suitable for use as a luminescent material, color conversion material, etc. in an organic EL element, an organic EL element which has excellent lifetime, light emission efficiency, thermal and electrical stability, color conversion efficiency, etc. and is suitable for lighting units, display devices, etc., and an organic EL display using the organometallic complex or the organic EL element, which has high performance and long lifetime, and is suitable for a color display in which a constant average

driving current can be achieved regardless of light-emitting pixels and color balance is satisfactory without changing light-emitting area.

Disclosure of Invention

Inventors of the present invention have investigated vigorously in order to solve the problems described above, and have found the following experiences or discoveries. Specifically, certain organometallic complex exhibiting phosphorescent luminescence is suitable as a luminescent material and color conversion material in an organic EL element and an organic EL element and an organic EL display using the organometallic complex, for example, as a luminescent material, color conversion material, etc. have excellent lifetime and light-emitting efficiency, thermal and electrical stability, etc. and high performance.

A first organometallic complex of the present invention is an organic rhenium complex and includes a rhenium (Re) atom; one ligand which has a coordinated nitrogen atom and a coordinated oxygen atom, each coordinated with the rhenium (Re) atom, and has at least one $\pi$ conjugation part; and the other ligand coordinated with the rhenium (Re) atom in such a way that the ligand saturates the coordination number of the rhenium (Re) atom and the charge of the whole organic rhenium complex is neutral.

A second organometallic complex of the present invention is an organic rhenium complex and includes a rhenium (Re) atom; one ligand which has a coordinated nitrogen atom and a coordinated carbon atom, each coordinated with the rhenium (Re) atom, and has at least one $\pi$ conjugation part; and the other ligand coordinated with the rhenium (Re) atom in such a way that the ligand saturates the coordination number of the rhenium (Re) atom and the charge of the whole organic rhenium complex is neutral.

A third organometallic complex of the present invention includes at least one of Group 8 metal atoms selected from Group 8 metal element; one ligand which includes at least one $\pi$ conjugation part and is coordinated with the Group 8 metal atom; and a dithiolate ligand which is selected from an aliphatic dithiolate ligand and a heteroaromatic dithiolate ligand, and is coordinated with the Group 8 metal atom.

By the way, emission from organic substance is classified into fluorescence and phosphorescence by the properties of the excited state, but from the reason that organic substance does not generally generate phosphorescence, fluorescent materials have been conventionally used as a luminescent material, color conversion material, etc. in an organic EL element. However, from the EL emission mechanism it is anticipated that phosphorescent luminescence state is generated 4 times as much as the luminescence state, therefore, it is effective to apply a heavy metal complex generating phosphorescent luminescence at room temperature to a luminescent material for high efficiency of EL element and such complex has attracted attention in recent years. In the organometallic complexes from the first organometallic complex to the third organometallic complex, since phosphorescent luminescence is generated, high light-emitting efficiency of 100% at maximum can be achieved theoretically compared to the internal quantum efficiency of 25% at maximum of the EL element using fluorescent material. Thus, the organometallic complex is suitable as a luminescent material, color conversion material, etc. in an organic EL element, etc. When the organometallic complexes from the first organometallic complex to the third organometallic complex is used as a color conversion material of color conversion layer in the organic EL element, etc., it is not required to use a host material together in the color conversion layer and, for example, ultraviolet light or blue light can be directly converted into red light using only the organometallic complex.

In each of the organometallic complexes from the first organometallic complex to the third organometallic complex, the color of the emitted light can be modified by varying the skeletal structure or substituents of the one ligand, or the other ligand or dithiolate ligand. As the metal center is rhenium (Re), which is a heavy metal with very high melting point and boiling point, or the Group 8 metal element, the whole organometallic complex has excellent thermal and electrical stability. Moreover, in the third organometallic complex when the dithiolate ligand is a aliphatic dithiolate ligand or a heteroaromatic dithiolate ligand, the complex has more excellent stability to light and light-emitting quantum efficiency, stronger color intensity and satisfactory shelf stability compared with the case of an aromatic dithiolate ligand, if this complex is used for an organic EL element, high light-emitting efficiency, long lifetime and high color conversion efficiency can be achieved.

Moreover, the one ligand is a bidentate ligand. In the first organometallic complex, a nitrogen atom and oxygen atom in the bidentate ligand are directly bonded to the rhenium (Re) atom, in the second organometallic complex, a nitrogen atom and carbon atom in the bidentate ligand are directly bonded to the rhenium (Re) atom, and in the third organometallic complex, two ligand atoms in the bidentate ligand are directly bonded to the Group 8 metal atom. In each case, the one ligand (the bidentate ligand) exhibits strong interaction between the rhenium (Re) atom or the Group 8 metal atom. Thus, in an organic EL element or the like where each of the organometallic complexes from the first organometallic complex to the third organometallic complex is used as luminescent material, color conversion material, etc., when electric field is applied to the organic EL element, strong interaction between the one ligand and the rhenium (Re) atom or Group 8 metal atom effectively prevents singlet and triplet excitons that are generated in the organic rhenium complex from deactivating as thermal energy, rotational energy or the like without radiation, and the energy is

efficiently changed into light energy as fluorescence and phosphorescence. Hence, if the organometallic complex is, for example, used as a luminescent material, color conversion material, etc. in an organic EL element, emission having excellent lifetime, high light-emitting efficiency, color conversion efficiency, etc. is obtained.

A first organic EL element of the present invention includes an organic thin film layer disposed between a positive electrode and a negative electrode. In the organic EL element, the organic thin film layer includes any one of the organometallic complexes from the first organometallic complex to the third organometallic complex at least as a luminescent material. As the first organic EL element contains the organometallic complex of the present invention, it is excellent in lifetime and light-emitting efficiency, durability, etc.

A second organic element of the present invention includes a color conversion layer, wherein the color conversion layer includes any one of the organometallic complexes from the first organometallic complex to the third organometallic complex as a color conversion material. In the second organic EL element, as the color conversion layer includes the organometallic complex of the present invention as a color conversion material, the second organic EL element is excellent in lifetime and color conversion efficiency, and by using only the organometallic complex without using host material together, for example, ultraviolet light or blue light can be directly converted into red light.

Theses organic EL elements of the present invention are, for example, particularly suitable for lighting units, display devices, etc.

The organic EL display of the present invention uses at least one of the organic EL elements from the first organic EL element to the second organic EL of the present invention. As the organic EL display uses the organic EL element of the present invention, it is excellent in lifetime and light-emitting efficiency, color conversion efficiency, etc.

Brief Description of the Drawings

FIG. 1 is a schematic cross sectional view describing an example of the layer structure in an organic EL element according to the present invention.

FIG. 2 is a schematic view describing an example of the structure of an organic EL display (passive matrix panel) of a passive matrix method.

FIG. 3 is a schematic view describing a circuit of an organic EL display (passive matrix panel) of a passive matrix method shown in FIG. 2.

FIG. 4 is a schematic view describing an example of the structure of an organic EL display (active matrix panel) of an active matrix method.

FIG. 5 is a schematic view describing a circuit of an organic EL display (active matrix panel) of an active matrix method shown in FIG. 4.

FIG. 6 is a schematic view describing an example of the structure of an organic EL display.

FIG. 7 is a schematic view describing an example of the structure of an organic EL display.

FIG. 8 is a schematic view describing an example of the structure of an organic EL display.

FIG. 9 is a graph of emission spectrum of an example of the organometallic complex (organic platinum complex) of the present invention.

FIG. 10 is a graph of emission spectrum of an example of the organometallic complex (organic platinum complex) of the present invention.

FIG. 11 is a graph of emission spectrum of an example of the organometallic complex (organic platinum complex) of the present invention.

FIG. 12 is a graph of emission spectrum of an example of the organometallic complex (organic platinum complex) of the present invention.

FIG. 13 is a graph of emission spectrum of an example of the organometallic complex (organic platinum complex)

of the present invention.

FIG. 14 is a graph of emission spectrum of an example of the organometallic complex (organic platinum complex) of the present invention.

FIG. 15 is a graph of emission spectrum of an example of the organometallic complex (organic platinum complex) of the present invention.

FIG. 16 is a graph of emission spectrum of an example of the organometallic complex (organic platinum complex) of the present invention.

FIG. 17 is a graph of emission spectrum of an example of the organometallic complex (organic platinum complex) of the present invention.

FIG. 18 is a graph of emission spectrum of an example of the organometallic complex (organic platinum complex) of the present invention.

FIG. 19 is a graph of emission spectrum of an example of the organometallic complex (organic platinum complex) of the present invention.

FIG. 20 is a graph of emission spectrum of an example of the organometallic complex (organic platinum complex) of the present invention.

FIG. 21 is a graph of emission spectrum of an example of the organometallic complex (organic platinum complex) of the present invention.

FIG. 22 is a graph of emission spectrum of an example of the organometallic complex (organic platinum complex) of the present invention.

FIG. 23 is a graph of emission spectrum of an example of the organometallic complex (organic platinum complex) of the present invention.

FIG. 24 is a graph of emission spectrum of an example of the organometallic complex (organic platinum complex) of the present invention.

FIG. 25 is a graph of emission spectrum of an example of the organometallic complex (organic platinum complex) of the present invention.

FIG. 26 is a graph of emission spectrum of an example of the organometallic complex (organic platinum complex) of the present invention.

FIG. 27 is a graph of emission spectrum of an example of the organometallic complex (organic platinum complex) of the present invention.

FIG. 28 is a graph of emission spectrum of an example of the organometallic complex (organic platinum complex) of the present invention.

FIG. 29 is a graph of emission spectrum of an example of the organometallic complex (organic platinum complex) of the present invention.

FIG. 30 is a graph of emission spectrum of an example of the organometallic complex (organic platinum complex) of the present invention.

FIG. 31 is a graph of emission spectrum of an example of the organometallic complex (organic platinum complex) of the present invention.

FIG. 32 is a graph of emission spectrum of an example of the organometallic complex (organic platinum complex) of the present invention.

FIG. 33 is a graph of emission spectrum of an example of the organometallic complex (organic platinum complex) for comparison.

FIG. 34 is a graph of emission spectrum of an example of the organometallic complex (organic platinum complex) for comparison.

Best Mode for Carrying Out the Invention

<Organometallic complex>

An organometallic complex of the present invention is preferably each aspect of the following first aspect to the third aspect.

The first organometallic complex of the present invention is an organic rhenium complex and comprises a rhenium (Re) atom; one ligand which has a coordinated nitrogen atom and a coordinated oxygen atom, each coordinated with the rhenium (Re) atom, and has at least one π conjugation part; and the other ligand coordinated with the rhenium (Re) atom in such a way that the ligand saturates the coordination number of the rhenium (Re) atom and the charge of the whole organic rhenium complex is neutral.

The second organometallic complex of the present invention, is an organic rhenium complex and comprises a rhenium (Re) atom; one ligand which has a coordinated nitrogen atom and a coordinated carbon atom, each coordinated with the rhenium (Re) atom, and has at least one π conjugation part; and the other ligand coordinated with the rhenium (Re) atom in such a way that the ligand saturates the coordination number of the rhenium (Re) atom and the charge of the whole organic rhenium complex is neutral.

The third organometallic complex of the present invention comprises at least one of Group 8 metal atoms selected from Group 8 metal element; one ligand which comprises at least one π conjugation part and is coordinated with the Group 8 metal atom; and a dithiolate ligand which is selected from an aliphatic dithiolate ligand and a heteroaromatic dithiolate ligand, and is coordinated with the Group 8 metal atom.

-First organometallic complex (organic rhenium complex)-

There is no particular limitation on the first organometallic complex (organic rhenium complex) provided that it comprises a rhenium (Re) atom; one ligand which has a coordinated nitrogen atom and a coordinated oxygen atom, each coordinated with the rhenium (Re) atom, and has at least one π conjugation part; and the other ligand coordinated with the rhenium (Re) atom in such a way that the ligand saturates the coordination number of the rhenium (Re) atom and the charge of the whole organic rhenium complex is neutral, and it can be selected according to the purpose, but it is preferred that there is an overlap between an electron orbit of the one ligand and an electron orbit of the rhenium (Re) atom wherein electrons can be transferred between them. Among these, organic rhenium complex where the one ligand has two ring structures in which one ring structure has a nitrogen atom coordinated with the rhenium (Re) atom the other ring structure has an oxygen atom coordinated with the rhenium (Re) atom, is preferred, Moreover, organic rhenium complex where the one ring and the other ring is one of 5-or 6-membered ring and the two carbon atoms, each a member of the two rings, are bonded, or a part of the carbon of each ring is shared, is particularly preferred.

Preferable and specific examples of the first organic rhenium complex are represented by the following formulae (1) to (4):

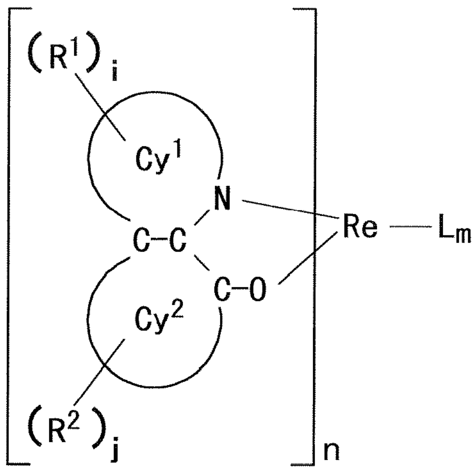

Formula (1)

In the formula (1), $R^1$ and $R^2$ may be the same or different, and each represent a hydrogen atom or a substituent group.

There is no particular limitation on the substituent group, and may be selected according to the purpose, for example, a halogen atom, an alkoxy group, an amino group, an alkyl group, a cycloalkyl group, an aryl group which may contain a nitrogen atom or a sulfur atom, or an aryloxy group which may contain a nitrogen atom or a sulfur atom, and these themselves may be substituted.

An adjacent pair of $R^1$ and $R^2$ may be joined together to form an aromatic ring which contains a nitrogen atom, a sulphur atom or an oxygen atom, and the aromatic ring may themselves be substituted by any substituent known in the art.

In the formula (1), "i" and "j" are integers.

In the formula (1), $Cy^1$ is a ring having a coordinated nitrogen atom which is coordinated with a rhenium (Re) atom, and two carbon atoms which are bonded to this coordinated nitrogen and are shared with $Cy_2$.

In the formula (1), $Cy^2$ is a ring which is bonded to the oxygen atom bonded to a rhenium (Re) atom and contains the two carbon atoms shared with $Cy^1$.

There is no particular limitation on the ring represented by the $Cy^1$ or $Cy^2$, and may be selected according to the purpose, suitable examples being 5-membered rings and 6-membered rings, and these rings may contain a carbon atom, a nitrogen atom, an oxygen atom or a sulfur atom.

In the formula (1), "n" is 1, 2, or 3, representing a coordination number of the one ligand coordinated with the rhenium (Re) atom bidentately, the one ligand comprising $Cy^1$ and $Cy^2$.

When n is two or more, each of the one ligands may be the same or different.

In the formula (1), the letter "L" represents the other ligand which saturates the coordination number of the rhenium (Re) atom, and neutralizes the charge of the whole complex. By suitably modifying the "L" ligand, the wavelength of the light emitted by the organic rhenium complex can be varied or adjusted as desired, such that a red light-emitting material, a green light-emitting material or a blue light-emitting material can be obtained.

There is no particular limitation on the other ligand provided that it saturates the coordination number of the rhenium (Re) atom and neutralizes the charge of the whole complex, and it may be selected according to the purpose, but suitable example is a group selected from a halogen atom, a carbonyl group, a cyano group, a hydroxyaryl group, a phenylisocyanide group, a pyridine group, an acetylacetonato group, a 2,2'-bipyridyl group, a 1,10-phenanthroline group, a cyclometalate and ligand group, and a triphenylphosphine group represented as follow. These groups may also be substituted by any substituents known in the art.

| -X | -CO | -CN | -O-Ar |
|---|---|---|---|
| halogen | carbonyl | cyano | hydroxyaryl |

(continued)

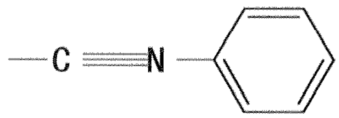

phenylisocyanide

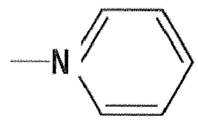

pyridine

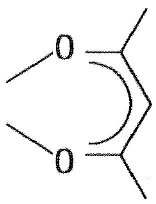

acetylacetonato

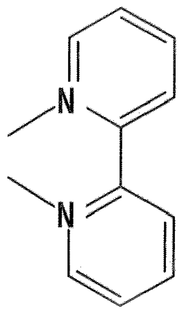

2,2'bipyridyl

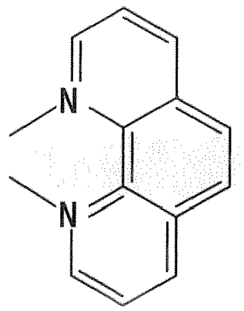

1,10-phenanthroline

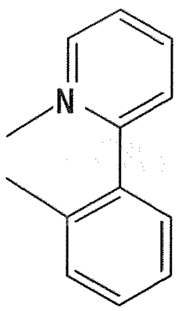

cyclometalate

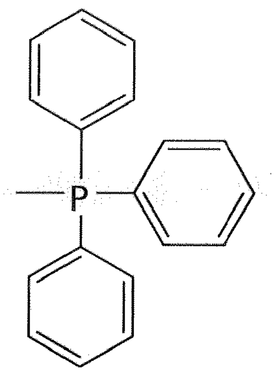

triphenylphosphine

where, in the above formula, Ar represents an aromatic ring or aromatic heterocyclic ring and these may also be substituted by any substituents.

In the formula (1), "m" represents an integer of 0 to 4. It is preferable to select "m" so that the coordination number of the rhenium (Re) atom in the organic rhenium complex is 6, which is a stable coordination number. If n is 1, m is preferably 4, if n is 2, m is preferably 2, and if n is 3, m is preferably 0.

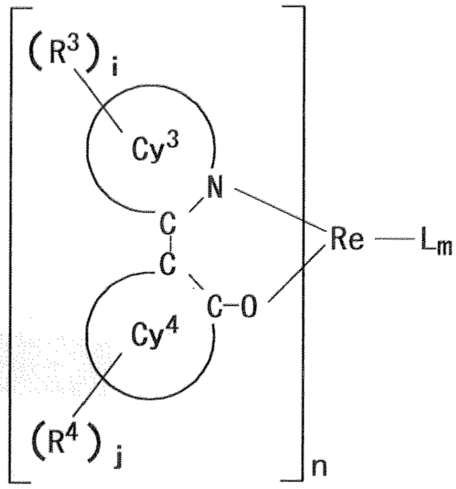

Formula (2)

In the formula (2), $R^3$ and $R^4$ is the same as $R^1$ and $R^2$ in the formula (1). Moreover, "i" and "j", "n", and, "L" and "m" are the same as those in the formula (1).

The $Cy^3$ is a ring having a coordinated nitrogen atom which is coordinated with a rhenium (Re) atom, and a carbon atom which is bonded to this coordinated nitrogen and a carbon atom in $Cy^4$.

The $Cy^4$ is a ring having a carbon atom which is bonded to the oxygen atom bonded to a rhenium (Re) atom and a carbon atom which is bonded to carbon atom in $Cy^3$.

There is no particular limitation on the ring represented by the $Cy^3$ and $Cy^4$, and may be selected according to the purpose, suitable examples being 5-membered rings and 6-membered rings, and these rings may contain a carbon atom, a nitrogen atom, an oxygen atom or a sulfur atom.

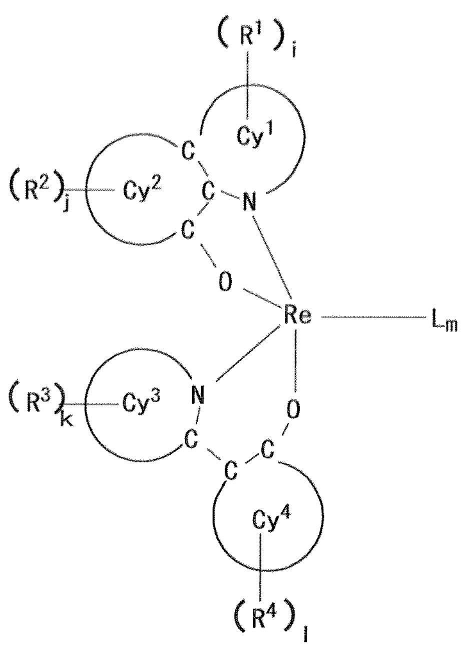

Formula (3)

In the formula (3), $R^1$ to $R^4$ may be the same or different, represent a hydrogen atom or substituent group and are the same as $R^1$ and $R^2$ in the formula (1).

"i", "j", "k" and "l" represent an integer and are the same as "i" and "j" in the formula (1).

$Cy^1$ is a ring having a coordinated nitrogen atom which is coordinated with a rhenium (Re) atom and two carbon atoms which are bonded to this coordinated nitrogen and are shared with $Cy^2$, and is the same as the $Cy^1$ in the formula (1).
$Cy^2$ is a ring which is bonded to the oxygen atom bonded to a rhenium (Re) atom and which contains the two carbon atoms shared with $Cy^1$, and is the same as the $Cy^2$ in the formula (1).
$Cy^3$ is a ring having a coordinated nitrogen atom which is coordinated with a rhenium (Re) atom and a carbon atom which is bonded to this coordinated nitrogen and carbon atom in $Cy^4$, and is the same as the $Cy^3$ in the formula (2).
$Cy^4$ is a ring having carbon atom which is bonded to the oxygen atom bonded to a rhenium (Re) atom and carbon atom which is bonded to carbon atom in $Cy^3$, and is the same as the $Cy^4$ in the formula (2).
The letter "L" represents the other ligand which saturates the coordination of the rhenium (Re) atom, and neutralizes the charge of the whole organic rhenium complex, and is the same as the "L" in the formula (1).
"m" represents 1 or 2.

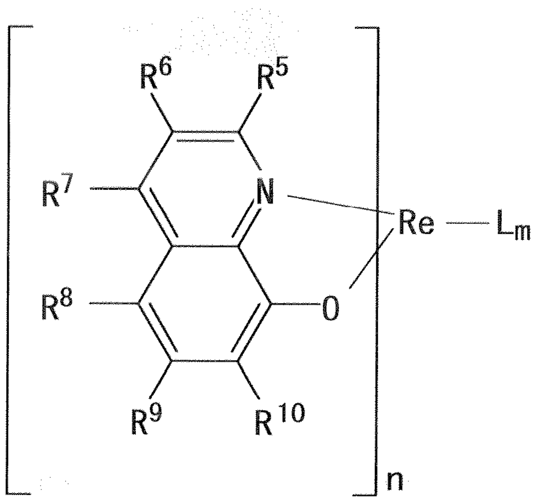

Formula (4)

In the formula (4), $R^5$ to $R^{10}$ may be the same or different, and represent a hydrogen atom or substituent group. The substituent group is the same as in the formula (1). "n" represents a coordination number. The letter "L" represents the other ligand which saturates the coordination number of the rhenium (Re) atom, and neutralizes the charge of the whole organic rhenium complex. "m" represents an integer of 0 to 4.
As the first organic rhenium complex, organic rhenium complexes represented by the following formula (5) to (7) are also suitably exemplified:

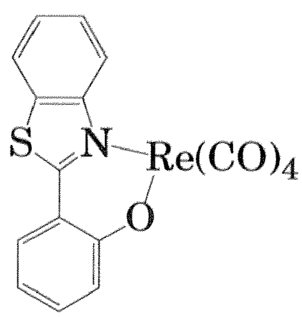

Formula (5)

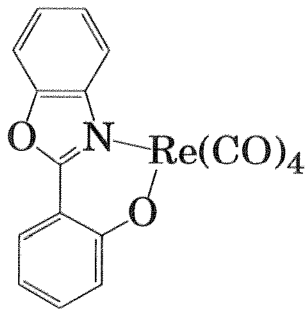

Formula (6)

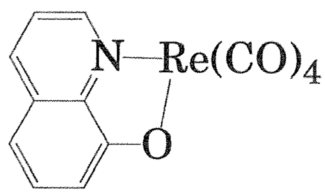

Formula (7)

There is no particular limitation on the method of manufacturing the first organic rhenium complex which may be suitably selected from the methods known in the art. Suitable example includes the method described in Inorg. Chem. 1993,1,32,398-401. For example, in the synthesis of $Re(CO)_4$(8-quinolinate), $Re(CO)_5Cl$ and 8-quinolinate are reacted in toluene with stirring under reflux until the generation of HCl gas stops. The toluene is evaporated to concentrate the solution and, then add diethyl ether and let the solution cool. A yellow precipitate is filtrated and obtained precipitate is washed with diethyl ether. Then, recrystallization is performed twice using mixed solvent of acetone and diethyl and thus $Re(CO)_4$(8-quinolmate) as an objective substance can be synthesized.

The number of the one ligand (bidentate ligand) can be set to 2 when $Re(CO)_5Cl$ is used, and can be set to 3 when $ReCl_3$ is used.

-Second organometallic complex (organic rhenium complex)-

There is no particular limitation on the second organometallic complex (organic rhenium complex) provided that it comprises a rhenium (Re) atom; one ligand which has a coordinated nitrogen atom and a coordinated carbon atom, each coordinated with the rhenium (Re) atom, and has at least one $\pi$ conjugation part; and the other ligand coordinated with the rhenium (Re) atom in such a way that the ligand saturates the coordination number of the rhenium (Re) atom and the charge of the whole organic rhenium complex is neutral, and it can be selected according to the purpose, but it is preferred that there is an overlap between an electron orbit of the one ligand and an electron orbit of the rhenium (Re) atom wherein electrons can be transferred between them. Among these, the organic rhenium complex where the one ligand has at least two ring structures in which one ring structure has a nitrogen atom coordinated with the rhenium (Re) atom and the other ring structure has a carbon atom coordinated with the rhenium (Re) atom, is preferred. Moreover, a structure in which the one ring and the other ring is one of 5-or 6-membered ring and the two carbon atoms, each a member of the two rings, are bonded, or a structure in which the one ring and the other ring is one of 5-or 6-membered ring and the one ring and the other ring are each coupled by the third ring structure, is particularly preferred.

A preferable and specific example of the second organic rhenium complex is represented by the following formula (8):

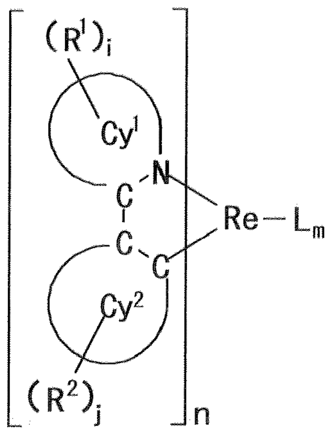

Formula (8)

In the formula (8), $R^1$ and $R^2$ may be the same or different, and each represent a hydrogen atom or a substituent group.

There is no particular limitation on the substituent group, and may be selected according to the purpose, for example, a halogen atom, an alkoxy group, an amino group, an alkyl group, a cycloalkyl group, an aryl group which may contain a nitrogen atom or a sulfur atom, or an aryloxy group which may contain a nitrogen atom or a sulfur atom, and these themselves may be substituted.

An adjacent pair of $R^1$ and $R^2$ may be joined together to form an aromatic ring which contains a nitrogen atom, a sulphur atom or an oxygen atom, and the aromatic ring may themselves be substituted by any substituent known in the art.

In the formula (8), "i" and "j" are integers.

In the formula (8), $Cy^1$ represents one ring structure having a coordinated nitrogen atom which is coordinated with a rhenium (Re) atom, and a carbon atom which is bonded to a carbon atom in $Cy^2$.

In the formula (8), $Cy^2$ represents the other ring having a carbon atom which is bonded to a rhenium (Re) atom, and a carbon atom which is bonded to carbon atom and a carbon atom in $Cy^1$.

There is no particular limitation on the ring represented by the $Cy^1$ or $Cy^2$, and may be selected according to the purpose, suitable examples being 5-membered rings and 6-membered rings, and these rings may contain a carbon atom, a nitrogen atom, an oxygen atom or a sulfur atom.

In the formula (8), "n" is 1, 2, or 3, representing a coordination number of the one ligand coordinated with the rhenium (Re) atom, the one ligand comprising $Cy^1$ and $Cy^2$.

When n is two or more, each of the one ligands may be the same or different.

In the formula (8), the letter "L" represents the other ligand which saturates the coordination number of the rhenium (Re) atom, and neutralizes the charge of the whole organic rhenium complex. By suitably modifying this L, the wavelength of the light emitted by the organic rhenium complex can be varied or adjusted as desired, such that a red light-emitting material, a green light-emitting material or a blue light-emitting material can be obtained.

There is no particular limitation on the other ligand provided that it saturates the coordination number of the rhenium (Re) atom and neutralizes the charge of the whole complex, and it may be selected according to the purpose, but suitable example is a group selected from a halogen atom, a carbonyl group, a cyano group, a hydroxyaryl group, a phenylisocyanide group, a pyridine group, an acetylacetonato group, a 2,2'-bipyridyl group, a 1,10-phenanthroline group, a cyclometalate and ligand group, and a triphenylphosphine group represented as follow. These groups may also be substituted by any substituents known in the art.

| -X | -CO | -CN | -O-Ar |
|---|---|---|---|
| halogen | carbonyl | cyano | hydroxyaryl |

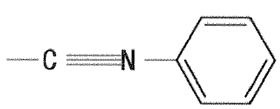

phenylisocyanide

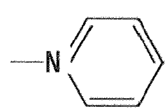

pyridine

(continued)

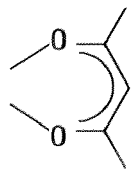

acetylacetonato

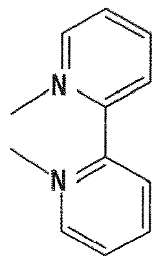

2,2'bipyridyl

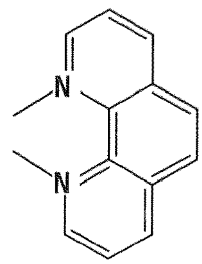

1,10-phenanthroline

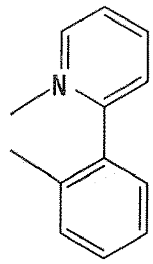

cyclometalate

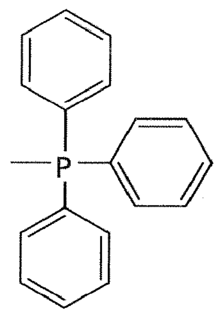

triphenylphosphine

-X -CO -CN -O-Ar cyano hydroxyaryl

where, in the above formula, Ar represents an aromatic ring or aromatic heterocyclic ring and these may also be substituted by any substituents.

In the formula (8), "m" represents an integer of 0 to 4. It is preferable to select "m" so that the coordination number of the rhenium (Re) atom in the organic rhenium complex is 6, which is a stable coordination number.

Of the organic rhenium complexes represented by the formula (8), an organic rhenium complex represented by the formula (9) in which the one ligand contains 7,8-benzoquinoline skeleton, an organic rhenium complex represented by the formula (10) in which the one ligand contains 2-phenylpyridine skeleton, an organic rhenium complex represented by the formula (11) in which the one ligand contains 2-phenyloxazoline skeleton, an organic rhenium complex represented by the formula (12) in which the one ligand contains 2-phenylthiozoline skeleton, an organic rhenium complex represented by the formula (13) in which the one ligand contains 2-(2'-thienyl)pyridine skeleton, an organic rhenium complex represented by the formula (14) in which the one ligand contains 2-(2'-thienyl)thiozoline skeleton, an organic rhenium complex represented by the formula (15) in which the one ligand contains 3-(2'-thiozolyl)-2H-pyran-2-one skeleton, a Re(CO)4 (7,8-benzoquinoline) complex represented by the formula (16), and the like are preferred.

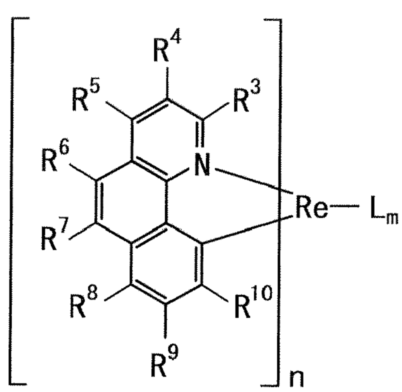

Formula (9)

In the formula (9), $R^3$ to $R^{10}$ may be the same or different, each representing a hydrogen atom or a substituent

group which may optionally be substituted, wherein an adjacent pair thereof may join together to form an aromatic ring which contains one of a nitrogen atom, a sulphur atom and an oxygen atom. "n" represents an, integer of 1 to 3. The letter "L" represents the other ligand which saturates the coordination number of the rhenium (Re) atom, and neutralizes the charge of the whole organic rhenium complex. "m" represents an integer of 0 to 4.

The details of the substituent group, n and m are the same as in the formula (8).

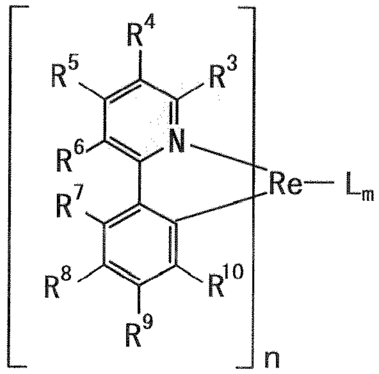

Formula (10)

In the formula (10), $R^3$ to $R^{10}$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole organic rhenium complex. "m" represents an integer of 0 to 4.

The details of the substituent group, n and m are the same as in the formula (8).

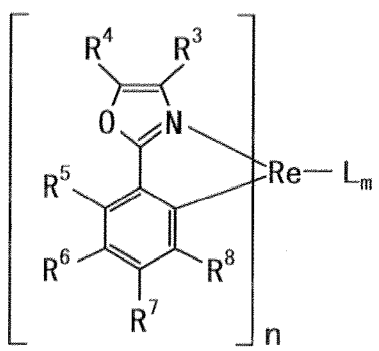

Formula (11)

In the formula (11), $R^3$ to $R^8$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole organic rhenium complex. "m" represents an integer of 0 to 4.

The details of the substituent group, n and m are the same as in the formula (8).

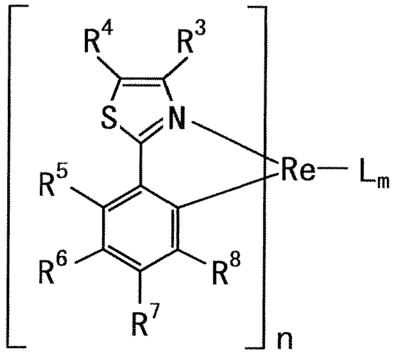

Formula (12)

In the formula (12), $R^3$ to $R^8$ may be the same or different, each representing a hydrogen atom or a substituent group which may optionally be substituted wherein an adjacent pair thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole organic rhenium complex. "m" represents an of 0 to 4.

The details of the substituent group, n and m are the same as in the formula (8).

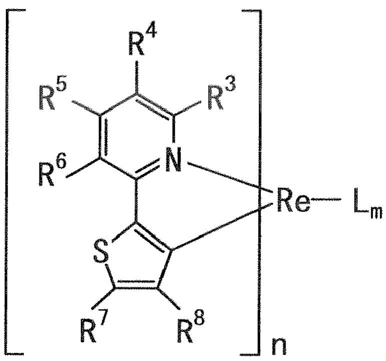

Formula (13)

In the formula (13), $R^3$ to $R^8$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole organic rhenium complex. "m" represents an integer of 0 to 4.

The details of the substituent group, n and m are the same as in the formula (8).

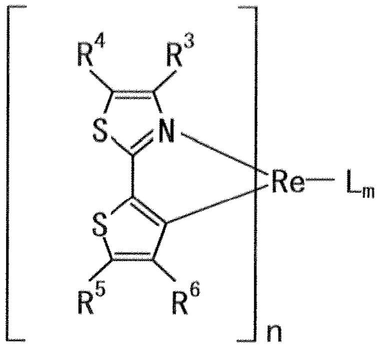

Formula (14)

In the formula (14), $R^3$ to $R^8$ may be the same or different, each representing a hydrogen atom or a substituent group which may optionally be substituted, wherein an adjacent thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole organic rhenium complex. "m" represents an integer of 0 to 4.

The details of the substituent group, n and m are the same as in the formula (8).

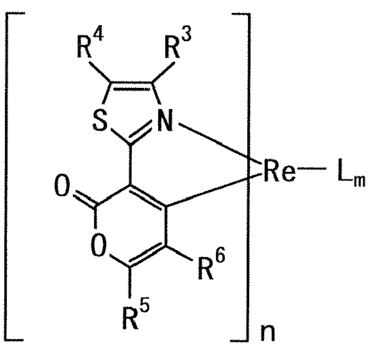

Formula (15)

In the formula (15), $R^3$ to $R^6$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole organic rhenium complex. "n" represents an integer of 0 to 4.

The details of the substituent group, n and m are the same as in the formula (8).

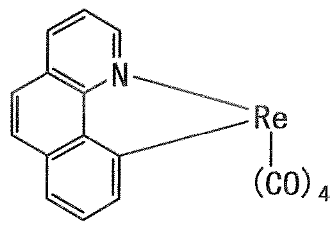

Formula (16)

There is no particular limitation on the method of manufacturing the second organic rhenium complex which may be suitably selected from the methods known in the art. Suitable example includes the method described in Inorg. Chem. 1993, 32, 5633-5636. For example, in the synthesis of $Re(CO)_4$ (7,8-benzoquinoline), $Re(CO)_5Cl$ and 7,8-benzoquinoline are reacted in toluene deaerated with nitrogen gas with stirring under reflux for several hours. Next, hot hexane is added to the reaction product remaining after evaporating the toluene, followed by extracting the reaction product to obtain a yellow crude product. Then, by recrystallizing the obtained yellow crude product several times with hexane and removing unreacted 7,8-benzoquinoline, $Re(CO)_4$ (7,8-benzoquinoline) as an objective substance can be synthesized.
The number of the one ligand (bidentate ligand) can be set to 2 when $Re(CO)_5Cl$ is used, and can be set to 3 when $ReCl_3$ is used.

-Third organometallic complex-

There is no particular limitation on the third organometallic complex provided that it comprises at least one of Group 8 metal atoms selected from Group 8 metal element in the periodic table; one ligand which comprises at least one $\pi$ conjugation part and is coordinated with the Group 8 metal atom; and a dithiolate ligand which is selected from an aliphatic dithiolate ligand and a heteroaromatic dithiolate ligand, and is coordinated with the Group 8 metal atom, and it can be selected according to the purpose, but it is preferred that there is an overlap between an electron orbit of the one ligand and an electron orbit of the Group 8 metal atom wherein electrons can be transferred between them.
Among these, the organometallic complex in which the one ligand has at least two ring structures in which one ring structure has a nitrogen atom coordinated with the Group 8 metal atom and the other ring structure has a nitrogen atom coordinated with the Group 8 metal atom, is preferred. Moreover, a structure in which the one ring and the other ring are one of 5-or 6-membered ring and the two carbon atoms, each a member of the two rings, are bonded, or a structure in which the one ring and the other ring are one of 5-or 6-membered ring, and the one ring and the other ring are each coupled by the third ring structure, is particularly preferred.
Further, the third organometallic complex is preferably an organometallic complex in which the other ligand contains two sulfur atoms and the two sulfur atoms are dithiolate ligands capable of being coordinated with the Group 8 metal atom. Of these, the organometallic complex in which the other ligand is one selected from an aliphatic dithiolate ligand and a heteroaromatic dithiolate ligand are preferred.
Specific example of the third organometallic complex is preferably the organometallic complex represented by the following formula (17). Among these, organometallic complexes represented by the following formula (18) or (19) are more preferred.

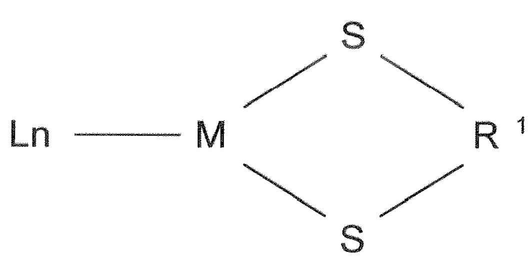

Formula (17)

In the formula (17), "M" represents a Group 8 metal atom. The letter "L" represents the one ligand which is

bonded to the Group 8 metal atom one of unidentately and bidentately or more and comprises at least one π conjugation part. "n" represents an integer of 1 to 4. $R^1$ represents a divalent aliphatic organic group or a divalent heteroaromatic organic group.

The Group 8 metal atom is extremely stable metal to oxygen, water, acid and alkaline. Examples thereof include Fe, Co, Ni, Ru, Rh, Pd, Os, Ir, and Pt. Of these, Pt is particularly preferred. At least one of the Group 8 metal elements is contained in the organometallic complex.

The letter "L" represents the one ligand which is bonded to the M in such a way that the ligand satisfies the stable coordination number of the M and comprises at least one π conjugation part. Since the stable coordination number of the M is 4 to 8, the "L" is preferably selected so as to have the stable coordination number of 4 to 8.

The "n" represents the number of the "L" and an integer of 1 to 6. By changing the number and type of the L, The emission wavelength of the organometallic complex can be changed to a desired emission wavelength.

There is no particular limitation on the specific example of the "L" and may be suitably selected according the purpose. Suitable example includes a ligand which comprises an aromatic ring and an atom capable of being coordinated with the Group 8 metal atom one of unidentately and bidentately or more, the atom being in a portion of the aromatic ring.

Preferable example of the atom is one selected from a nitrogen atom, oxygen atom, chalcogen (sulfur atom, selenium atom, tellurium atom, and polonium atom), and phosphorus atom.

Of the "L"s, those having 1- to 5-member aromatic ring containing a nitrogen atom are preferred. Specifically, preferable examples thereof include pyridine, quinoline, 2,2'-bipyridine, phenanthroline, 2,2'-bipyrazine, 2,2'-biquinoline, pyrimidine, pyrimidazole and derivatives thereof. Of the these, pyridine, quinoline, 2,2'-bipyridine, phenanthroline, 2,2'-bipyrazine, and 2,2'-biquinoline, which are represented by the following formulae, are more preferred.

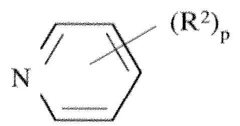

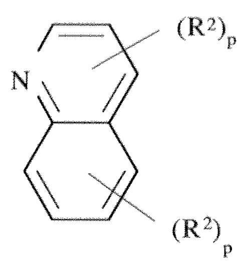

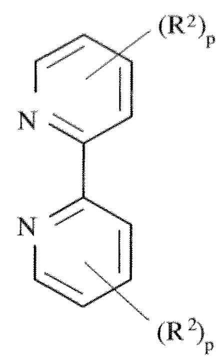

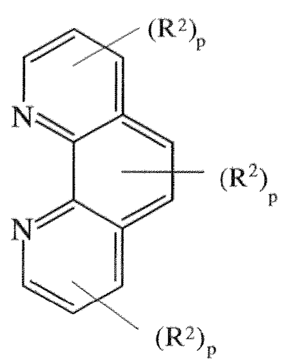

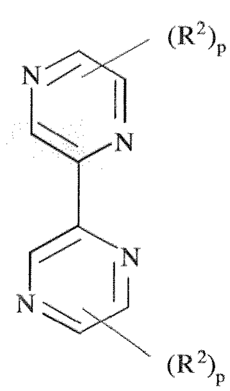

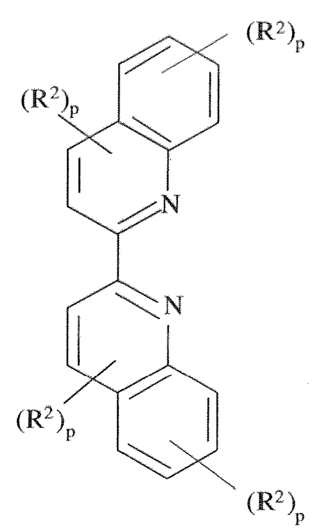

In each of these formulae, $R^2$ represents one or plurality of substituent groups which are bonded to any position of ring structure, for example, a halogen atom, cyano group, alkoxy group, amino group, alkyl group, alkyl acetate group,

cycloalkyl group, aryl group, or aryloxy group, and these themselves may be substituted with substituent groups. When the $R^2$ is two or more, the $R^2$ may be the same or different, any adjacent pair of $R^2$s may be joined together to form an aromatic ring which contains a nitrogen atom, a sulphur atom or an oxygen atom, and the aromatic ring may themselves be substituted by substituent groups. "p" represents an integer of 0 to 5.

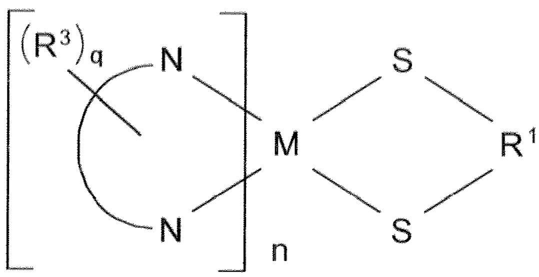

Formula (18)

In the formula (18), "M" represents a Group 8 metal atom. The ligand which is bonded to the And contains a nitrogen atom, represents a ligand comprising at least one $\pi$ conjugation part and is coordinated with the M one of unidentately and bidentately or more. In the ligand comprising at least one $\pi$ conjugation part, $R^3$ represents a hydrogen atom, halogen atom, cyano group, alkoxy oup, amino group, alkyl group, alkyl acetate group, cycloalkyl group, nitrogen atom, aryl group, or aryloxy group, these themselves may be substituted with substituent groups, and "q" represents an integer of 0 to 8. "n" represents an integer of 1 to 4. A ligand which is bonded to the M and contains a sulfur atom represents a dithiolate ligand selected from an aliphatic dithiolate ligand and heteroaromatic dithiolate ligand. In the dithiolate ligand selected from an aliphatic dithiolate ligand and heteroaromatic dithiolate ligand, $R^1$ represents a divalent aliphatic organic group or divalent heteroaromatic organic group.

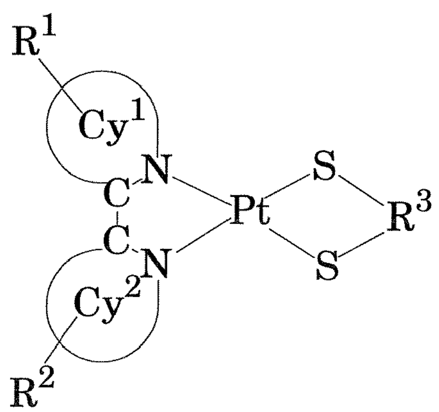

Formula (19)

In the formula (19), $R^1$ and $R^2$ may be the same or different, and each represent a hydrogen atom or a substituent group. $Cy^1$ represents one ring structure having a coordinated nitrogen atom which is coordinated with a platinum (Pt) atom, and a carbon atom which is bonded to the nitrogen atom and a carbon atom in $Cy^2$. $Cy^2$ represents the other ring structure having a coordinated carbon tom which is bonded to a platinum (Pt) atom, and a carbon atom which is bonded to the carbon atom and to a carbon atom in $Cy^1$. A ligand which is bonded to the Pt and contains a sulfur atom represents a dithiolate ligand selected from an aliphatic dithiolate ligand and heteroaromatic dithiolate ligand. In the dithiolate ligand, $R^3$ represents a bivalent aliphatic organic group or a divalent heteroaromatic organic group.

The heteroaromatic dithiolate ligand is preferably one represented by one of the following formulae (20) to (23).

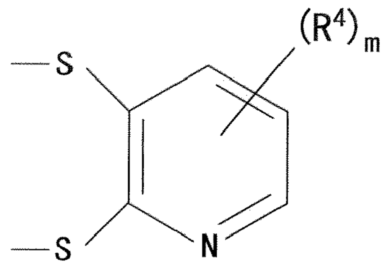

Formula (20)

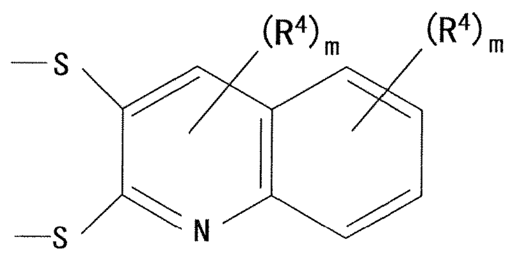

Formula (21)

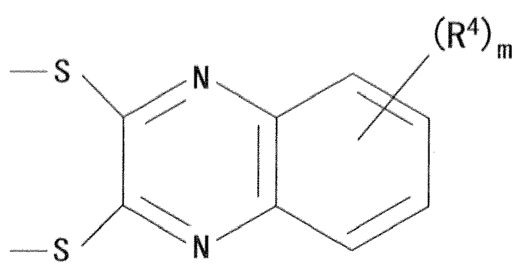

Formula (22)

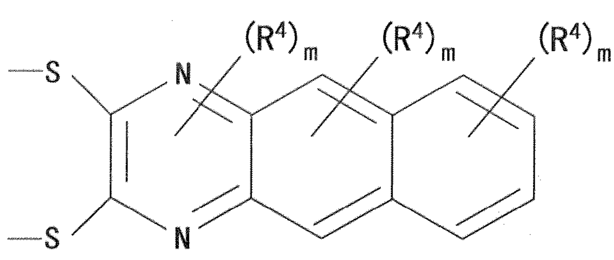

Formula (23)

In the following formulae (20) to (23), $R^4$ represents a halogen atom, a cyano group, an alkoxy group, an amino group, an alkyl group, an alkyl acetate group, a cycloalkyl group, a nitrogen atom, an aryl group, or an aryloxy group, and these themselves may be substituted with substituent groups. "m" represents an integer of 0 to 5.

The heteroaromatic dithiolate ligand is preferably one represented by one of the following formulae (24) and (25).

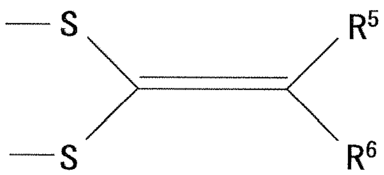

Formula (24)

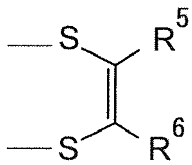

Formula (25)

In the formulae (24) and (25), $R^5$ and $R^6$ may be the same or different, a hydrogen atom, halogen atom, cyano group, alkoxy group, amino group, alkyl group, alkyl acetate group, cycloalkyl group, nitrogen atom, aryl group, or aryloxy group, and these themselves may be substituted with substituent groups.

There is no particular limitation on the third organometallic complex and may be suitably selected according to the purpose. For example, an organometallic complex represented by one of the following formulae (26) and (27).

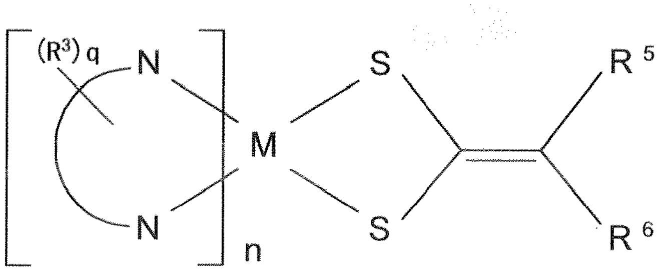

Formula (26)

In the formula (26), "M" represents a Group 8 metal atom. A ligand which is bonded to the M and contains a nitrogen atom, represents a ligand comprising at least one $\pi$ conjugation part and is bonded to the M one of unidentately and bidentately or more. In the ligand comprising at least one $\pi$ conjugation part, $R^3$ represents a hydrogen atom, halogen atom, cyano group, alkoxy group, amino group, alkyl group, alkyl acetate group, cycloalkyl group, nitrogen atom, aryl group, or aryloxy group, these themselves may be substituted with substituent groups, and "q" represents an integer of 0 to 5. A ligand which is bonded to the M and contains a sulfur atom represents an aliphatic dithiolate ligand. In the aliphatic dithiolate ligand, R5 and R6 may be the same or different, represent a hydrogen atom, halogen atom, cyano group, alkoxy group, amino group, alkyl group, alkyl acetate group, cycloalkyl group, nitrogen atom, aryl group, or aryloxy group, and these themselves may be substituted with substituent groups.

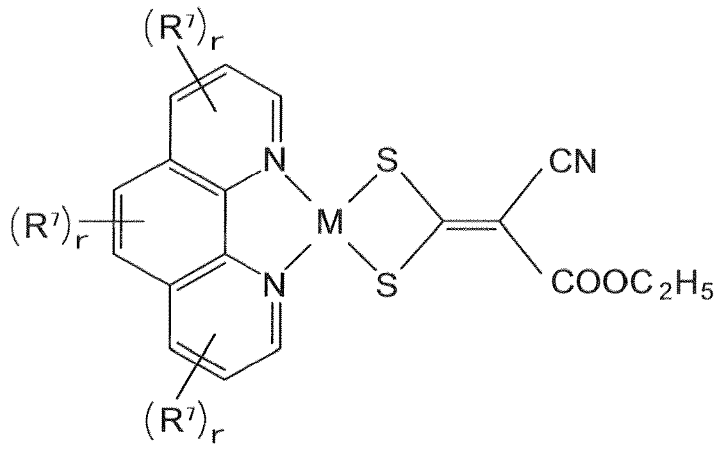

Formula (27)

In the formula (27), "M" represents a Group 8 metal atom. $R^7$ may be the same or different, represents a hydrogen atom, halogen atom, cyano group, alkoxy group, amino group, alkyl group, alkyl acetate group, cycloalkyl group, nitrogen atom, aryl group, or aryloxy group, and these themselves may be substituted with substituent groups. "r" represents an integer of 0 to 5.

Further, the organometallic complex is also preferably one represented by one of the following formulae (28) to (36):

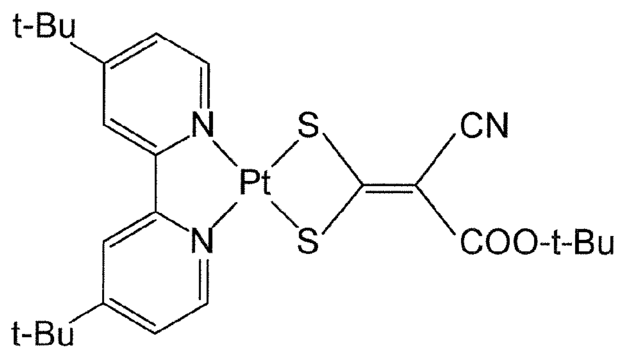

Formula (28)

where t-Bu represents a tert-butyl group.

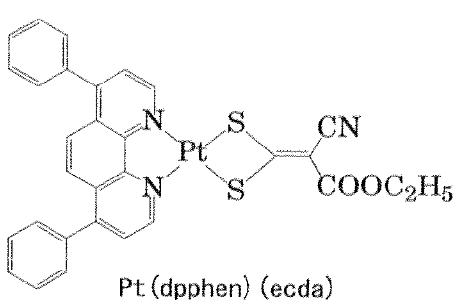

Pt(dpphen) (ecda)

Formula (29)

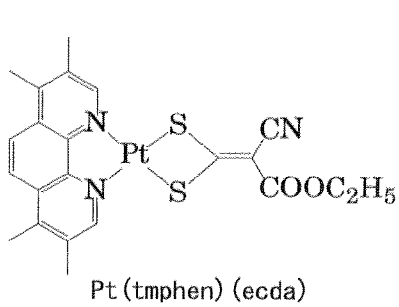

Pt(tmphen) (ecda)

Formula (30)

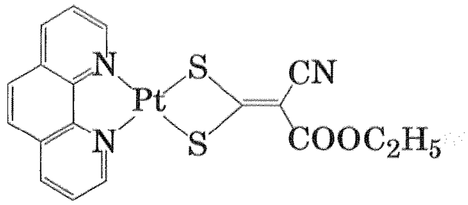

Pt (phen) (ecda)

Formula (31)

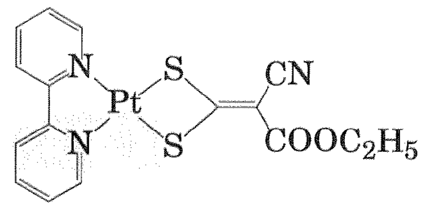

Pt (bpy) (ecda)

Formula (32)

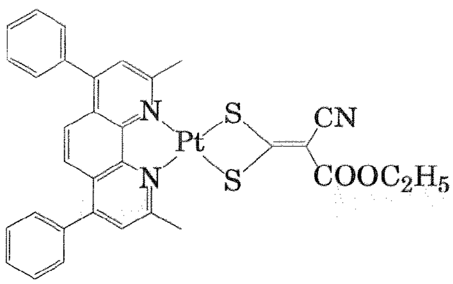

Pt (bcp) (ecda)

Formula(33)

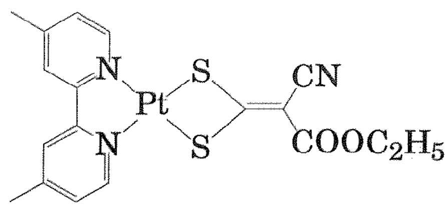

Pt (4dmbpy) (ecda)

Formula (34)

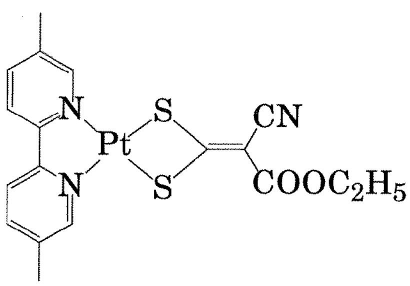

Pt (5dmbpy) (ecda)

Formula(35)

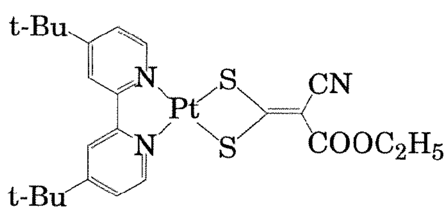

Pt (dbbpy) (ecda)

Formula(36)

Further, the organometallic complex is preferably one represented by one of the following formulae (37) to (45):

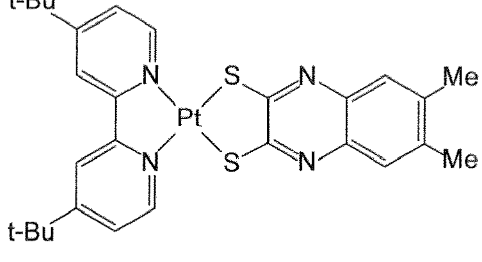

Formula (37)

where t-Bu represents a tert-butyl group.

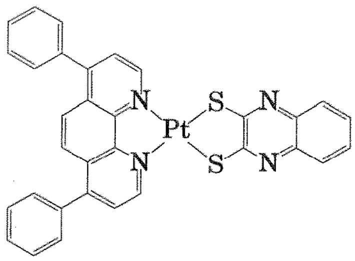

Pt(dpphen)(qdt)

Formula (38)

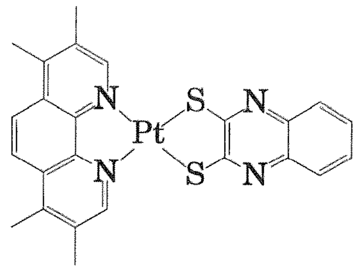

Pt(tmphen)(qdt)

Formula (39)

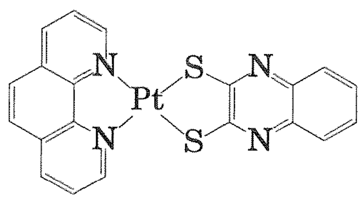

Pt(phen)(qdt)

Formula (40)

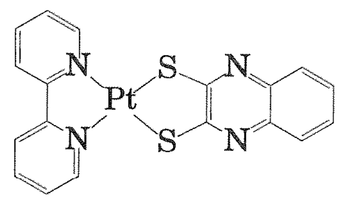

Pt(bpy)(qdt)

Formula (41)

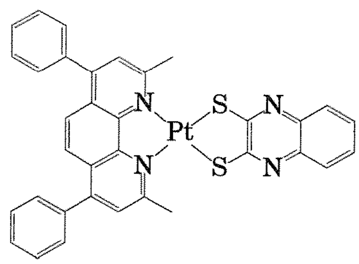

Pt(bcp)(qdt)

Formula (42)

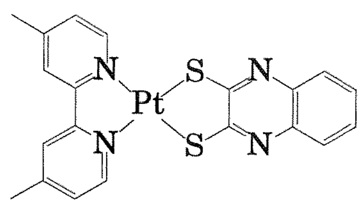

Pt(4dmbpy)(qdt)

Formula (43)

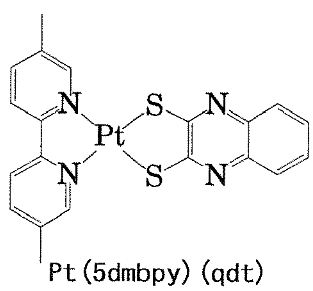

Pt(5dmbpy)(qdt)

Formula (44)

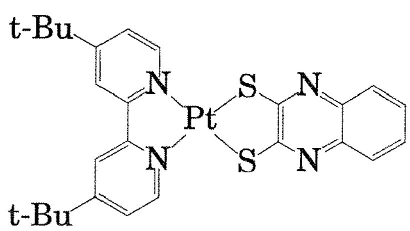

Pt(dbbpy)(qdt)

Formula (45)

Further, the organometallic complex is also preferably one represented by one of the following formulae (46) to (53).

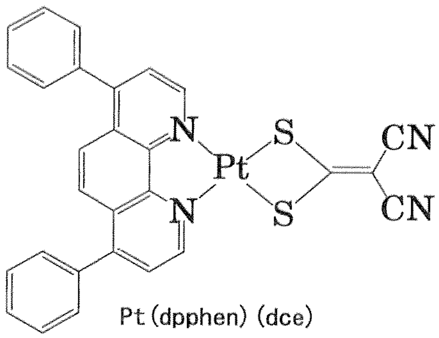

Pt (dpphen) (dce)

Formula (46)

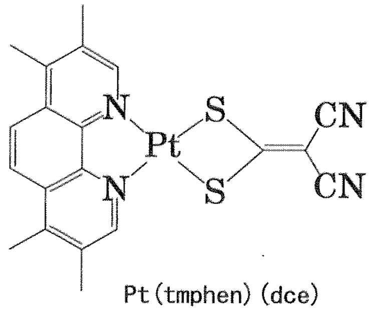

Pt (tmphen) (dce)

Formula (47)

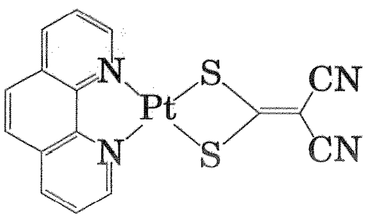

Pt (phen) (dce)

Formula (48)

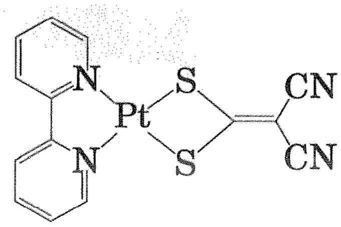

Pt (bpy) (dce)

Formula (49)

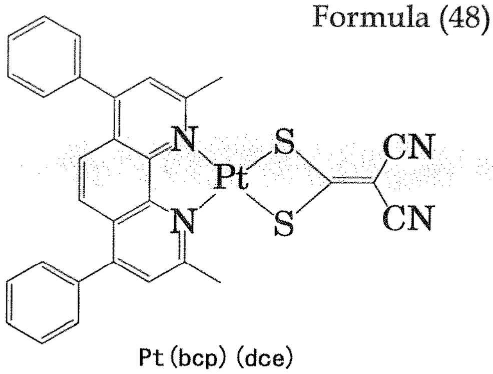

Pt (bcp) (dce)

Formula (50)

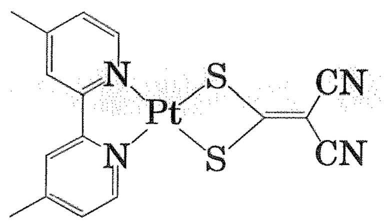

Pt (4dmbpy) (dce)

Formula (51)

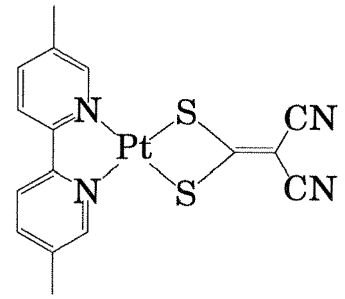

Pt(5dmbpy)(dce)

Formula (52)

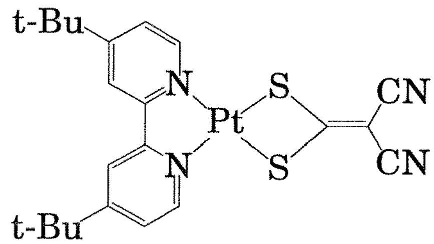

Pt(dbbpy)(dce)

Formula (53)

Further, the organometallic complex is preferably one represented by the following formula (54) or (55):

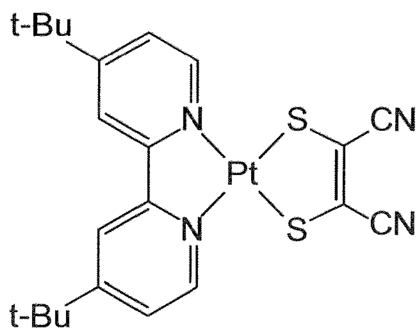

Formula (54)

where t-Bu represents a tert-butyl group,

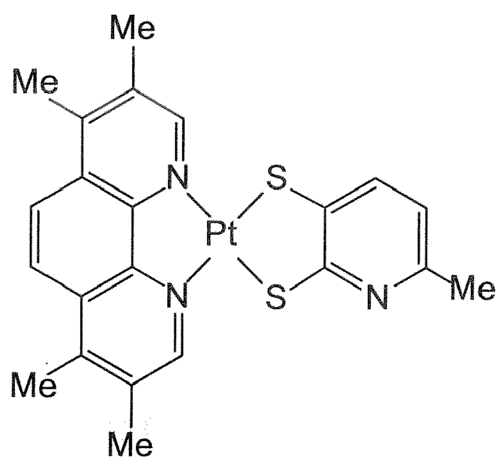

Formula (55)

where Me represents a methyl group.

There is no particular limitation on the method of manufacturing the third organometallic complex which may be suitably selected from the methods known in the art. For example, Pt(4,7-diphenyl-1,10-phenanthroline; dpphen)(1-(ethoxycarbonyl)-1-cyanoethylene-2,2-dithiolate; ecda) can be synthesized as follows.

(1) Synthesis of $K_2$(1-ethoxycarbonyl)-1-cyanoethylene-2,2-dithiolate; ecda)

According to the method described in the Acta Chem. Scand. 22, 1968, 1107-1128, crushed potassium hydroxide is added to dioxane and dissolved with stirring, keeping the temperature of 15-20°C as shown in the following reaction equation (reaction scheme). Ethyl cyanoacetate and carbon disulfide are gradually added to this solution. After addition, the solution is stirred for 20 minutes and diluted with ether to thereby produce a yellow precipitate. This precipitate is filtered, and obtained precipitate is washed with mixed solvent of dioxane : ether (1:1) (mass ratio) and vacuum dried to synthesize $K_2$ (1-ethoxycarbonyl)-1-cyanoethylene-2,2-dithiolate; ecda) (compound represented by I in the following reaction equation).

I

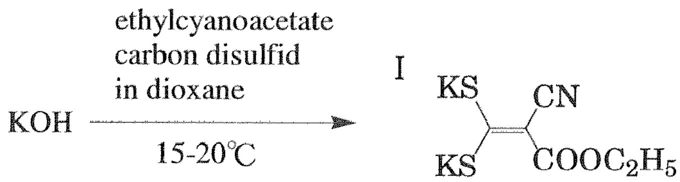


(2) Synthesis of Pt(4,7-diphenyl-1,10-phenanthroline; dpphen)$Cl_2$

According to the method described in the J. Am. Chem. Soc. 1990,112, 5625-5627 & J. Chem. Soc. Dalton Trans. 1978, 1127, $K_2PtCl_4$ is dissolved in pure water and heated as shown in the following reaction equation (reaction scheme). 4,7-diphenyl-1,10-phenanthroline (dpphen) is gradually added to this solution. After stirring for a while, precipitate is produced. This precipitate is collected by filtration, obtained precipitate is washed with acetone to synthesize Pt(4,7-diphenyl-1,10-phenanthroline; dpphen)$Cl_2$ (compound represented by II in the following reaction equation).

II

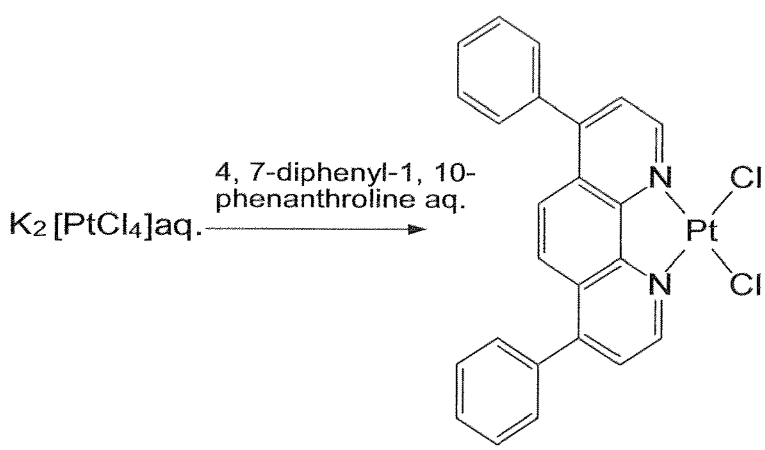


(3) Synthesis of Pt(dpphen)(ecda)

According to the method described in the Coord. Chem.Rev. 97, 1990, 47-64, a solution in which $K_2$(ecda) (compound represented by I in the above reaction equation) is dissolved in methanol, is dropped to a solution in which Pt(dpphen)$Cl_2$ (compound represented by II in the above reaction equation) is dissolved in acetone, to produce an orange precipitate as shown in the following reaction equation (reaction scheme). Centrifugation is performed to cause a precipitate (metal complex) and this precipitate is collected by filtration. Obtained organometallic complex is washed with acetone, ethanol and diethyl ether, and is vacuum dried to synthesize Pt(4,7-diphenyl-1,10-phenanthroline; dpphen) (1-(ethoxycarbonyl)-1-cyanoethylene-2,2-dithiolate; ecda) as an objective substance.

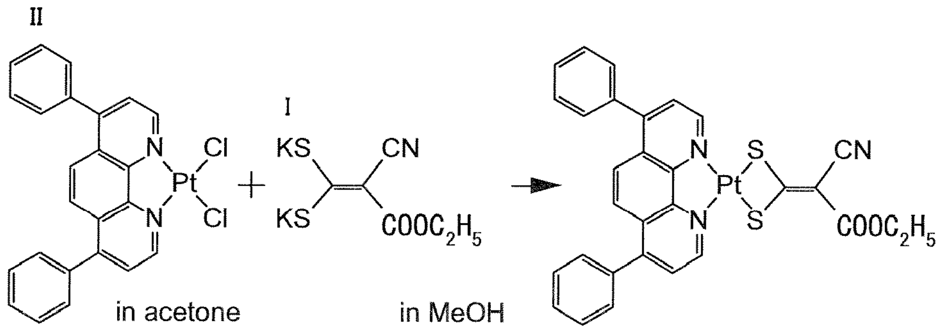


Moreover, Pt(diimine)(dithiolate) can be synthesized as follows.

(1) Synthesis of $K_2$(dithiolate)

According to the method described in the Acta Chem. Scand. 22, 1968, 1107-1128, crushed potassium hydroxide is added to dioxane and dissolved with stirring, keeping the temperature of 15 to 20°C. Dithol ligand and carbon disulfide are gradually added to this solution. After addition, the solution is stirred for 20 minutes and diluted with ether to thereby produce a yellow precipitate. This precipitate is filtered, and obtained precipitate is washed with mixed solvent of dioxane : ether (1:1) (mass ratio) and is vacuum dried to synthesize $K_2$(dithiolate).

(2) Synthesis of Pt(diimine)$Cl_2$

According to the method described in the J. Am. Chem. Soc. 1990,112, 5625-5627 & J. Chem. Soc. Dalton Trans. 1978, 1127, $K_2[PtCl_4]$ is dissolved in pure water and heated. Diimine compound solution or acetone solution is gradually added to this solution. After stirring for a while, precipitate is produced. This precipitate is collected by filtration, and obtained precipitate is washed with acetone and vacuum dried to synthesize Pt(diimine)$Cl_2$.

(3) Synthesis of Pt(diimine)(dithiolate)

According to the method described in the Coord. Chem.Rev. 97, 1990, 47-64, a solution in which $K_2$(dithiolate) is dissolved in methanol, is dropped to a solution in which Pt(diimlne)$Cl_2$ is dissolved in acetone, to thereby produce an orange precipitate. Centrifugation is performed to cause a precipitate (metal complex) and this precipitate is collected by filtration. Obtained organometallic complex is washed with acetone, ethanol and diethyl ether, and is vacuum dried to synthesize Pt(diimine)(dithiolate).

The first organometallic complex to the third organometallic complex can be suitably used in a variety of field, but can be particularly suitably used as a luminescent material, color conversion material, etc. in an organic EL element.

When any one of the organometallic complexes from the first organometallic complex to the third organometallic complex is used as a luminescent material of the light-emitting layer in the organic EL element, red light emission having high luminance and purity can be obtained. Further, when any one of the organometallic complexes from the first organometallic complex to the third organometallic complex is used as a color conversion material of the color conversion layer in the organic EL element, for example, blue light emission of the light-emitting layer can be efficiently converted into green light emission or red light emission, and a full color display having high performance and durability, etc. can be designed.

<Organic EL element>

The first organic EL element of the present invention comprises an organic thin film layer disposed between a positive electrode and a negative electrode. In the organic EL element, the organic thin film layer contains any one of the organometallic complexes from the first organometallic complex to the third organometallic complex at least as a luminescent material. The organic EL element further comprises other layers such as a color conversion layer.

The second organic EL element of the present invention comprises a color conversion layer. In the organic EL element, the color conversion layer contains any one of the organometallic complexes from the first organometallic complex to the third organometallic complex as a color conversion material. The organic EL element further comprises a positive electrode, an organic thin film layer such as a light-emitting layer, a negative electrode.

In the organic EL element of the present invention, when at least any one of the organometallic complexes from the first organometallic complex to the third organometallic complex of the present invention is used as a luminescent material, the organometallic complex is contained in the organic thin film layer where the organometallic complex may be contained in the light-emitting layer or may be contained in the light-emitting and electron transport layer, light-emitting and positive hole transport layer, etc. Further, when the organometallic complex is used in the light-emitting layer or color conversion layer, the light-emitting layer or color conversion layer may be formed of the organometallic complex alone as a film and may be formed using other materials such as a host material together in addition to the organometallic complex.

In the present invention, when the organometallic complex is used as a luminescent material, the light-emitting layer, light-emitting and electron transport layer, light-emitting and positive hole transport layer, or the like in the organic thin film layer may comprise the organometallic complex of the present invention as a guest material, and in addition to the guest material comprise a host material having an emission wavelength near an absorption wavelength of the guest material. The host material is preferably contained in the light-emitting layer, but may also be contained in a positive hole transport layer or an electron transport layer.

When the guest material and host material are used in conjunction, in a process of organic EL luminescence, the host material is excited first. Since the emission wavelength of the host material and the absorption wavelength of the guest material (the organometallic complex) overlap, excitation energy is efficiently transferred from the host material to the guest material, and since the host material returns to the ground state without emitting light and only the guest material which is in an excited state emits excitation energy as light, the light-emitting efficiency and color purity are excellent. In general, when one kind of luminescent molecule is present or the luminescent molecules are contained at high concentration in a thin film, the luminescent molecules are so close to each other that they interact, and a so-called "concentration quenching" effect occurs wherein the light-emitting efficiency declines. However, when the guest material and host material are used together, the organometallic complex which is the guest compound is dispersed at relatively low concentration in the host compound, so the "concentration quenching" effect is effectively suppressed and an excellent light-emitting efficiency is obtained. The use of the two materials in combination is therefore advantageous. Moreover, by using the guest material together with the host material in the light-emitting layer, as the host material generally has excellent film-forming properties, the combination has excellent film-forming properties while maintaining luminescent properties. There is no particular limitation on the host material, and may be suitably selected according to the purpose, but its emission wavelength is preferably near the optical absorption wavelength of the guest material. Suitable examples are the aromatic amine derivative represented by the following formula (56), the carbazole derivative represented by the following formula (57), the oxine complex represented by the following formula (58), 1,3,6,8-tetraphenylpyrene compound represented by the following formula (59), (4,4'-bis(2,2'-diphenylvinyl)-1,1'-biphenyl (DPVBi)) represented by the following formula (60) (main emission wavelength = 470nm), p-sexiphenyl represented by the following formula (61) (main emission wavelength = 400nm) and 9,9'-bianthryl represented by the following formula (62) (main emission wavelength = 460nm).

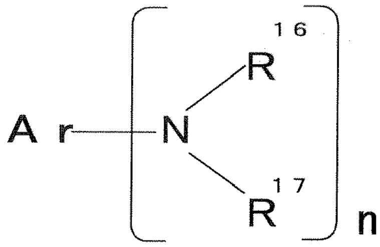

Formula (56)

In the formula (56), "n" represents an integer of 2 or 3. Ar represents a divalent or trivalent aromatic group, or heterocyclic aromatic group. $R^{16}$ and $R^{17}$ may be the same or different, and each represent a monovalent aromatic group or heterocyclic aromatic group. There is no particular limitation on the monovalent aromatic group or heterocyclic aromatic group, and can be selected according to the purpose. Of the aromatic amine derivatives represented by the formula (56), N,N'-dinaphthyl-N,N'-diphenyl-[1,1'-biphenyl]-4,4'-diamine (NPD), which is represented by the following formula (57) (main emission wavelength = 430nm), and its derivatives, are preferred.

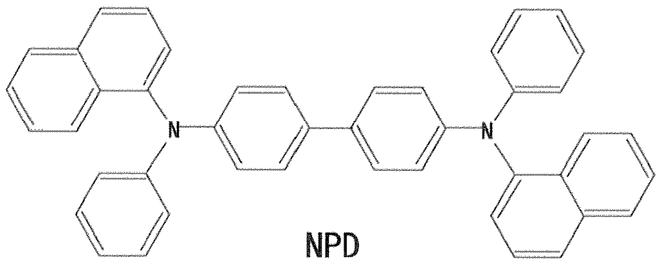

NPD

Formula (57)

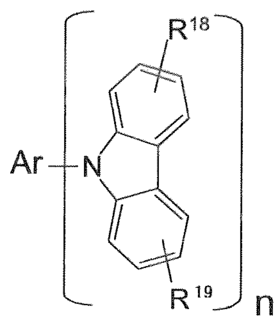

Formula (58)

In the formula (58), Ar is a divalent or trivalent group containing an aromatic ring as shown below, or a divalent or trivalent group containing a heterocyclic aromatic ring.

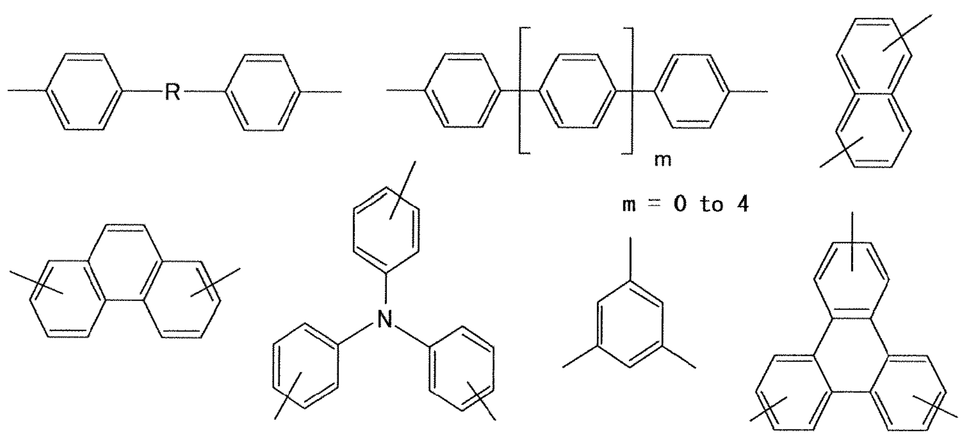

m = 0 to 4

These may be substituted by a non-conjugated group. "R" represents a linking group, the examples of which are shown below.

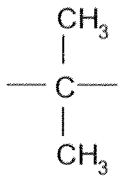 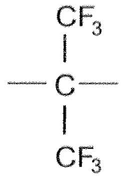 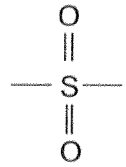

In the formula (58), $R^{18}$ and $R^{19}$ each independently represent a hydrogen atom, a halogen atom, an alkyl group, an aralkyl group, an alkenyl group, an aryl group, a cyano group, an amino group, an acyl group, an alkoxy carbonyl group, a carboxyl group, an alkoxy group, an alkyl sulfonyl group, a hydroxyl group, an amide group, an aryloxy group, an aromatic hydrocarbon ring or an aromatic heterocyclic group, and these may be further substituted by substituents.

In the formula (58), "n" represents an integer, and 2 and 3 are preferred.

Among the aromatic amine derivatives represented by the formula (58), a compound in which Ar is an aromatic group wherein two benzene rings are connected via a single bond, $R^{18}$ and $R^{19}$ are hydrogen atoms, and n=2, i.e., 4,4'-bis (9-carbazolyl)-biphenyl (CBP) represented by the following formula (59) (main emission wavelength = 380nm) and its derivatives are preferred in terms of particularly excellent light-emitting efficiency etc.

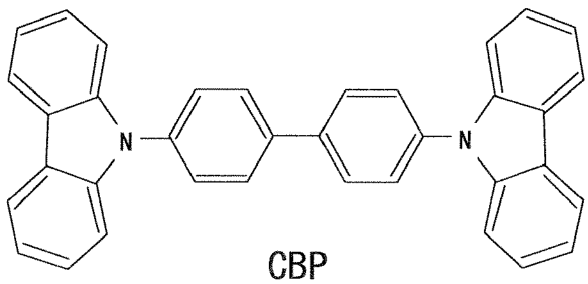

CBP

Formula (59)

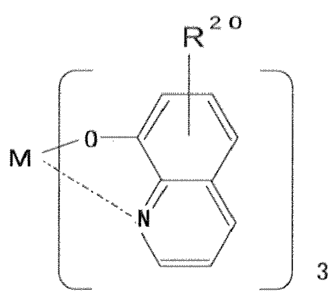

Formula (60)

Also, among oxine complexes represented by the formula (60), the aluminum quinoline complex (Alq) represented by the following formula (61) (main emission wavelength = 530nm) is preferred.

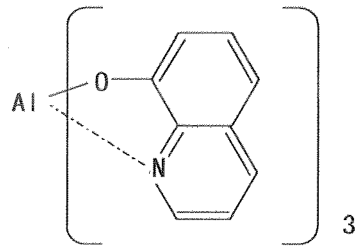

Alq

Formula (61)

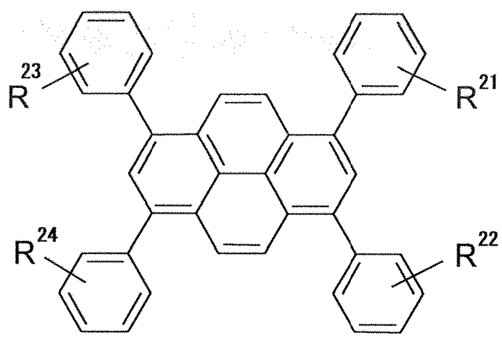

Formula (62)

In the formula (62), $R^{21}$ to $R^{24}$ may be the same or different, and represent a hydrogen atom or substituent group. The substituent may for example be an alkyl group, cycloalkyl group or aryl group, and these may be further substituted by a substituent.

Among the 1,3,6,8-tetraphenylpyrenes represented by the formula (62), the case where $R^{21}$ to $R^{24}$ are hydrogen atoms, i.e., the 1,3,6,8-tetraphenylpyrene represented by the following formula (63) (main emission wavelength = 440nm) is preferred from the viewpoint of excellent light-emitting efficiency, etc.

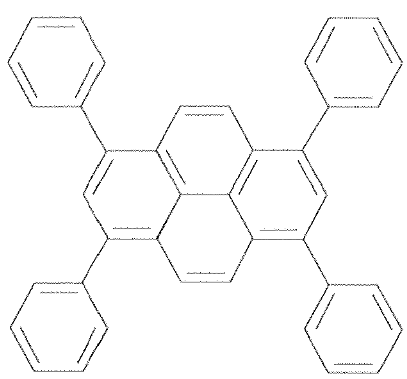

1, 3, 6, 8-tetraphenylpyrene

Formula (63)

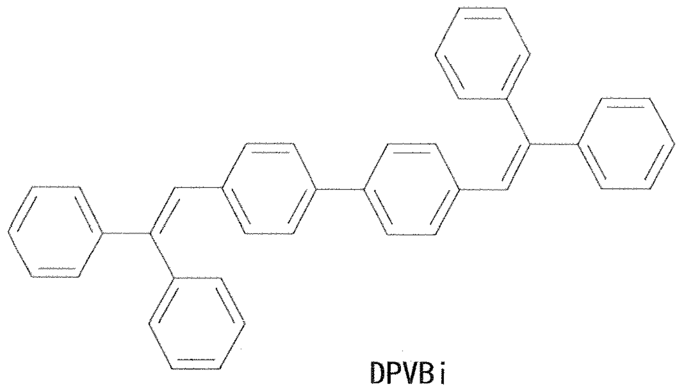

DPVBi

Formula (64)

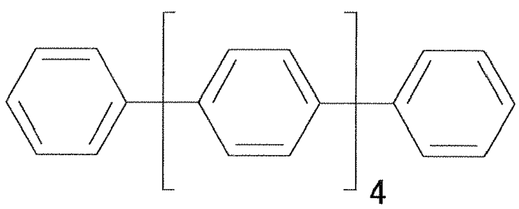

p-sexiphenyl

Formula (65)

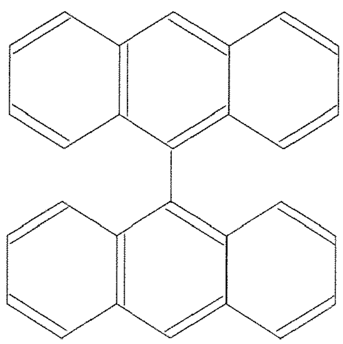

9,9'-bianthryl

Formula (66)

The amount of the organometallic complex in the layer containing the organometallic complex is preferably 0.1 to 50 % by mass, and more preferably 0.5 to 20 % by mass.

When the content is less than 0.1 % by mass, lifetime, light-emitting efficiency, and other properties may not be adequate, and when it exceeds 50 % by mass, color purity may decrease. On the other hand, when the amount is within the preferred range, lifetime, light-emitting efficiency, etc. are excellent.

Provided that the light-emitting layer in the organic EL element of the present invention may be injected with positive holes from the positive electrode, a positive hole injection layer, the positive hole transport layer or the like and with electrons from the negative electrode, an electron injection layer, the electron transport layer or the like when an electric field is applied; offers a site for recombination of positive holes and electrons; and has a function to allow the luminescent organometallic complex (luminous material, luminous molecule) to emit light using recombination energy generated by the recombination, the light-emitting layer may contain a luminescent material other than the organometallic complex so long as it does not adversely affect the light emission.

The light-emitting layer can be formed according to known methods, for example, vapor deposition method, wet film forming method, molecular beam epitaxy (MBE) method, cluster ion beam method, molecule laminating method, Langmuir-Brodgett (LB) method, printing method, transfer method, and the like.

Of these, vapor deposition is preferred from the viewpoint that no organic solvent is used so there is no problem

of waste fluid treatment, and that manufacture is low cost, simple and efficient. When designing the light-emitting layer as a single layer structure, for example, forming the light-emitting layer as a positive hole transport, light-emitting and electron transport layer, the wet film forming method is also preferred.

There is no particular limitation on the vapor deposition method, which can be conveniently chosen from known methods according to the purpose, for example vacuum vapor deposition, resistance heating vapor deposition, chemical vapor deposition and physical vapor deposition. Examples of chemical vapor deposition are plasma CVD, laser CVD, heat CVD and gas source CVD. Using the vapor deposition method, the light-emitting layer may for example be formed by vacuum vapor deposition of the organometallic complex, or when the light-emitting layer comprises the host material in addition to the organometallic complex, by simultaneous vacuum vapor deposition of the organometallic complex and host material. In the former case, manufacture is easier as co-deposition is not required.

There is no particular limitation on the wet film forming method which can be conveniently chosen from known methods according to the purpose, for example the ink-jet method, spin coating method, kneader coat method, bar coating method, blade coating method, casting method, dip coating method, curtain coating method and the like.

In the wet film forming method, a solution may be used (applied) wherein the material of the light-emitting layer is dissolved or dispersed together with a resin component. Examples of the resin component are polyvinyl carbazole, polycarbonate, polyvinyl chloride, polystyrene, polymethyl methacrylate, polyester, polysulfone, polyphenylene oxide, polybutadiene, a hydrocarbon resin, a ketone resin, a phenoxy resin, polyamide, ethyl cellulose, vinyl acetate, an acrylonitrile butadiene styrene (ABS) resin, polyurethane, a melamine resin, an unsaturated polyester resin, an alkyd resin, an epoxy resin and a silicone resin.

In the wet film forming method, the light-emitting layer may be preferably formed, for example, by using (applying and drying) a solution (coating solution) in which the organometallic complex and, if needed, the resin component are dissolved in a solvent, or when the light-emitting layer comprises the host material in addition to the organometallic complex, by using (applying and drying) a solution (coating solution) in which the organometallic complex, host material and, if needed, the resin component are dissolved in a solvent.

The thickness of the light-emitting layer is preferably 1 to 50nm, more preferably 3 to 20nm.

If the thickness of the light-emitting layer is within the above preferred numerical range, light-emitting efficiency, emission luminance and color purity of the light emitted by the organic EL element are sufficient, and if it is within the more preferred numerical range, these effects are more pronounced.

The organic EL element of the present invention comprises an organic thin film layer containing a light-emitting layer interposed between a positive electrode and a negative electrode, but it may have other layers such as a protective layer, according to the purpose.

The organic thin film layer comprises at least the light-emitting layer, and may also have a positive hole injection layer, positive hole transport layer, positive hole blocking layer, electron transport layer and the like as necessary.

- Positive electrode -

There is no particular limitation on the positive electrode, which can be conveniently chosen according to the purpose. It is preferred that the positive electrode supplies positive holes (carriers) to the organic thin film layer, specifically, to a light-emitting layer when the organic thin film layer comprises only the light-emitting layer; to a positive hole transport layer when the organic thin film layer further comprises the positive hole transport layer; or to a positive hole injection layer when the organic thin film layer further comprises the positive hole injection layer.

There is no particular limitation on the material of the positive electrode, and can be conveniently chosen according to the purpose, for example, a metal, an alloy, a metal oxide, an electrically conducting compound, mixtures thereof and the like, but among these, materials having a work function of 4eV or more are preferred.

Specific examples of the material of the positive electrode include electrically conducting metal oxides such as tin oxide, zinc oxide, indium oxide, indium tin oxide (ITO), metals such as gold, silver, chromium, and nickel, mixtures or laminates of these metals and electrically conducting metal oxides, inorganic electrically conducting substances such as copper iodide and copper sulfide, organic electrically conducting materials such as polyaniline, polythiophene and polypyrrole, and laminates of these with ITO. These may be used singly, or two or more may be used in combination. Of these, electrically conducting metal oxides are preferred, and ITO is particularly preferred from the viewpoints of productivity, high conductivity and transparency.

There is no particular limitation on the thickness of the positive electrode, and may be determined according to the material, but 1 to 5,000nm is preferred and 20 to 200nm is more preferred.

The positive electrode is typically formed on a substrate such as glass, e.g., soda lime glass or non-alkali glass, or a transparent resin.

When using the glass as the substrate, non-alkali glass or soda lime glass with a barrier layer of silica or the like, are preferred from the viewpoint that they lessen transport of ions from the glass.

There is no particular limitation on the thickness of the substrate provided that it is sufficient to maintain mechanical strength. When using glass as the substrate, it is typically 0.2mm or more, and 0.7mm or more is preferred.

The positive electrode can be conveniently formed by known methods such as vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method, transfer method and the method of applying a dispersion of ITO by a chemical reaction method (sol - gel process etc.).

By washing the positive electrode and performing other treatment, the driving voltage of the organic EL element can be reduced, and the light-emitting efficiency can also be increased. Examples of other treatment include, when the material of the positive electrode is ITO, UV ozonization, plasma processing, and the like.

- Negative electrode -

There is no particular limitation on the negative electrode, which can be conveniently chosen according to the purpose. It is preferred that the negative electrode supplies electrons to the organic thin film layer, specifically, to a light-emittina layer when the organic thin film layer comprises only the light-emitting layer or to an electron transport layer when the organic thin film layer further comprises the electron transport layer, or to an electron injection layer when the electron injection layer is present between the organic thin film layer and the negative electrode.

There is no particular limitation on the material of the negative electrode, and can be conveniently chosen according to adhesion properties with the layers or molecules adjoining the negative electrode, such as the electron transport layer and light-emitting layer, and according to ionization potential, stability and the like. Examples include a metal, an alloy, a metal oxide, an electrically conducting compound and a mixture thereof.

Examples of the material of the negative electrode include alkali metals (e.g., Li, Na, K, Cs), alkaline earth metals (e.g., Mg, Ca), gold, silver, lead, aluminum, sodium-potassium alloys or mixtures thereof, lithium-aluminum alloys or mixtures thereof, magnesium-silver alloys or mixtures thereof, rare earth metals such as indium and ytterbium, and alloys thereof.

These ay be used singly, or two or more may be used in combination. Of these, materials having a work function of 4eV or less are preferred. Aluminum, lithium-aluminum alloys or mixtures thereof, or magnesium-silver alloys or mixtures thereof, are more preferred.

There is no particular limitation on the thickness of the negative electrode, and may be determined according to the material of the negative electrode and the like, but 1 to 10,000nm is preferred and 20 to 200nm is more preferred.

The negative electrode can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method and transfer method.

When two or more materials are used together as the material of the negative electrode, the materials may be vapor-deposited simultaneously to form an alloy electrode or the like, or a pre-prepared alloy may be made to vapor-deposit so as to form an alloy electrode or the like.

The resistances of the positive electrode and negative electrode are preferably low, and it is preferred that they are not more than several hundred ohms per square.

- Positive hole injection layer -

There is no particular restriction on the positive hole injection layer, and can be chosen according to the purpose, but it is preferred that it has the function of, for example, injecting positive holes from the positive electrode when an electric field is applied.

There is no particular limitation on the material of the positive hole injection layer, which can be conveniently chosen according to the purpose. Suitable examples include starburst amine (4,4', 4"-tris[3-methylphenyl(phenyl) amino] triphenylamine: m-MTDATA) represented by the following formula, copper phthalocyanine and polyaniline.

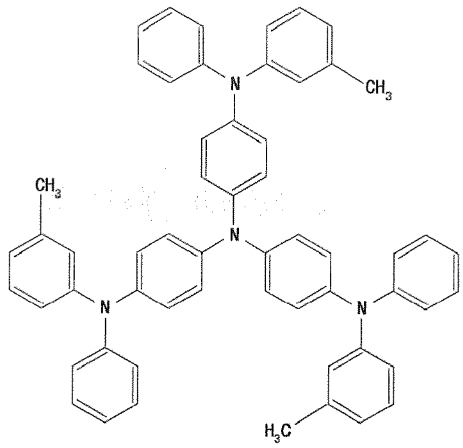

There is no particular limitation on the thickness of the positive hole injection layer, which can be chosen according to the purpose, e.g., about 1 to 100nm is preferred, and 5 to 50nm is more preferred.

The positive hole injection layer can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method and transfer method.

- Positive hole transport layer -

There is no particular limitation on the positive hole transport layer, and can be chosen according to the purpose, but for example, a layer having the function to convey positive holes from the positive electrode when an electric field is applied, is preferred.

There is no particular limitation on the material of the positive hole transport layer, and can conveniently be chosen according to the purpose. Examples include aromatic amine compounds, carbazole, imidazole, triazole, oxazole, oxadiazole, polyarylalkane, pyrazoline, pyrazolone, phenylene diamine, arylamine, amino-substituted chalcone, styryl anthracene, fluorenone, hydrazone, stilbene, silazane, styryl amine, aromatic dimethylidene compounds, porphyrin compounds, electrically conducting oligomers and polymers such as polysilane compounds, poly(N-vinyl carbazole), aniline copolymers, thiophene oligomers and polymers and polythiophene, and carbon films. If the material of the positive hole transport layer is mixed with the material of the light-emitting layer to form a film, a positive hole transport and light-emitting layer can be formed.

These may be used singly, or two or more may be used in combination. Of these, aromatic amine compounds are preferred. Specifically, TPD (N, N'-diphenyl-N, N'-bis (3-methylphenyl)-[1, 1'-biphenyl]-4, 4'-diamine) expressed by the following formula, and NPD(N,N'-dinaphthyl-N, N'-diphenyl-[1,1'-biphenyl]-4,4'-diamine) expressed by the following formula, and the like are more preferred.

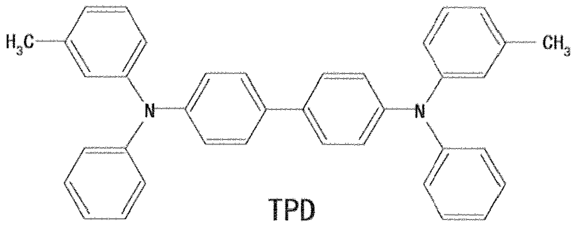

TPD

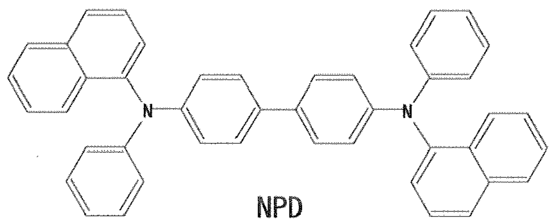

NPD

Formula (67)

There is no particular limitation on the thickness of the positive hole transport layer, and may be chosen according to the purpose, but is typically in the range of 1 to 500nm, and preferably 10 to 100nm.

The positive hole transport layer can be conveniently formed known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method and transfer method.

- Positive hole blocking layer -

There is no particular limitation on the positive hole blocking layer, and may be chosen according to the purpose, but a layer having for example the function of a barrier to positive holes injected from the positive electrode, is preferred.

There is no particular limitation on the material of the positive hole blocking layer, and can be conveniently chosen according to the purpose.

If the organic EL element comprises a positive hole blocking layer, positive holes conveyed from the positive electrode side are blocked by the positive hole blocking layer, and electrons conveyed from the negative electrode are transmitted through this positive hole blocking layer to reach the light-emitting layer. Hence, recombination of electrons and positive holes occurs efficiently in the light-emitting layer, and recombination of positive holes and electrons in the organic thin film layer other than the light-emitting layer can be prevented. Thus, the luminescence from the organic rhenium complex, which is the target luminescent material, is obtained efficiently, and this is advantageous in respect of color purity.

The positive hole blocking layer is preferably disposed between the light-emitting layer and the electron transport layer.

There is no particular limitation on the thickness of the positive hole blocking layer which can be conveniently determined according to the purpose, for example it is typically about 1 to 500nm, and preferably 10 to 50nm.

The positive hole blocking layer may be a single layer structure, or may be a laminated structure.

The positive hole blocking layer can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method or transfer method.

- Electron transport layer -

There is no particular limitation on the electron transport layer, and may conveniently be chosen according to the purpose, but for example a layer having the function to convey electrons from the negative electrode, or the function to act as a barrier to positive holes injected from the positive electrode, is preferred.

There is no particular limitation on the electron transport layer, and can be selected according to the purpose. Examples include a quinoline derivative such as the aluminum quinoline complex (Alq), an oxadiazole derivative, a triazole derivative, a phenanthroline derivative, a perylene derivative, a pyridine derivative, a pyrimidine derivative, a quinoxaline derivative, a diphenylquinone derivative and a nitro-substituted fluorene derivative. If one of these materials for electron transport layer is mixed with a material for the light-emitting layer to form a film, an electron transport and light-emitting layer can be formed, and if a material for the positive hole transport layer is also mixed to form a film, an electron transport, positive hole transport and light-emitting layer can be formed. In this case, a polymer such as polyvinyl carbazole or polycarbonate can be used.

There is no particular limitation on the thickness of the electron transport layer, and can be conveniently chosen according to the purpose, for example it is typically about 1 to 500nm, and preferable 10 to 50nm.

The electron transport layer may be a single layer structure, or may be a laminated structure. In this case, it is preferred that an electron transport material used for the electron transport layer adjacent to the light-emitting layer has an optical absorption edge at a shorter wavelength than that of the organic rhenium complex so that it limits the luminescence region in the organic EL element to the light-emitting layer and prevents unwanted luminescence from the electron transport layer. Examples of the electron transport material having an optical absorption edge at a shorter wavelength than the organic rhenium complex include a phenanthroline derivative, an oxadiazole derivative and a triazole derivative. Preferable examples include 2,9-dimethyl-4,7-diphenyl-1,10-phenanthroline (BCP) represented by the following formula (68) and the compounds shown below.

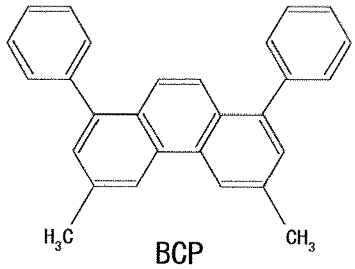

BCP

Formula (68)

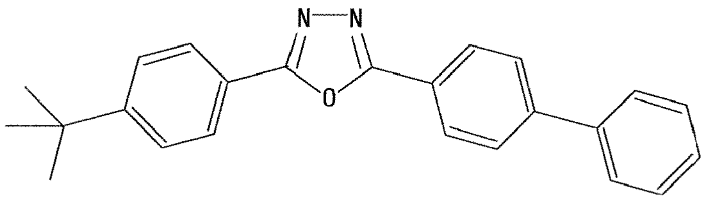

2-(4-tert-butylphenyl)-5-(4-biphenylyl)-1,3,4-oxadiazole

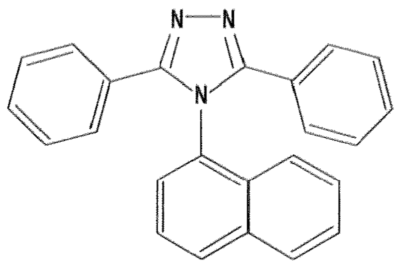

3-phenyl-4-(1-naphthyl)-5-phenyl-1,2,4-triazole

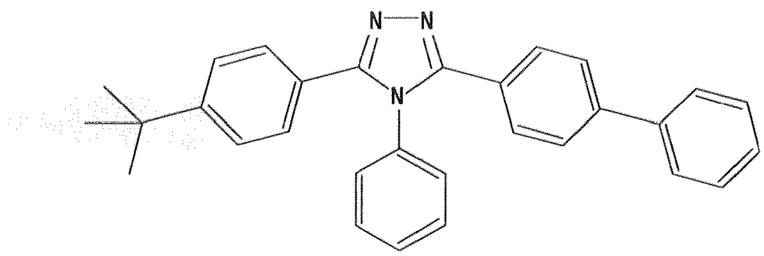

3-(4-tert-butylphenyl)-4-phenyl-5-(4'-biphenylyl)-1,2,4-triazole

The electron transport layer can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method or transfer method.

- Other layers -

The organic EL element of the present invention may comprise other layers suitably selected according to the purpose. Suitable examples of such other layers are a color conversion layer, or a protective layer.

In the case of the second organic EL element, the color conversion layer is essential layer and preferably comprises a phosphorescent material, more preferably at least one of the organometallic complexes from the first organometallic complex to the third organometallic complex of the present invention. Of these, the color conversion layer particularly preferably comprises at least one of an organic rhenium complex and organic platinum complex. The color conversion layer may be formed of the organometallic complex alone and may further comprise other materials.

In the color conversion layer, at least any one of the organometallic complexes from the first organometallic complex to the third organometallic complex may be used alone, or two or more may be used in combination.

By the way, it is generally known that the organic molecule excited by light having a certain wavelength loses a part of the excitation energy in the form of thermal energy non-radiatively due to interaction within the molecule or with other molecule before the organic molecule makes transition from excited state to ground state, so the wavelength of the excitation light does not correspond to that of emission light. The energy difference between the excitation light and emission light is called Stokes shift. Until now, as a color conversion material of the color conversion layer, a fluorescent material where only emitting-light from singlet is seen, has been used from the wide range of material selection. Since the fluorescent material has a small stokes shift (<100nm) and emission is seen in the longer wavelength region adjacent to the strongest absorption band, for example, blue-line emission cannot be efficiently absorbed to be converted into red-line color. On the contrary, since at least one of the organometallic complexes from the first organometallic complex to the third organometallic complex is a phosphorescent material, when singlet excitation is generated due to excitation by certain wavelength light, phosphorescent luminescence can be yielded by transiting to a triplet excitation state which is lower energy state. Thus, the phosphorescent material has larger stokes shift than a fluorescent material (in a case of normal organic material, it is known that a triplet state has lower energy by about 0.1 to 2 eV than singlet excitation

state). For example, in the application of converting blue-line emission serving as excitation source into red color, the color conversion layer where a phosphorescent material is used has higher absorption rate of blue light than the layer where a fluorescent material is used, thus led to higher rate of color conversion per molecule. In other words, since the color conversion layer where the fluorescent material is used absorbs less blue light, more blue light transmit the color conversion layer. In order to cover this defect, a color conversion layer may be thickened without changing dispersion concentration, which enables the increase of absorption of blue light and strength of red light. However, in the manufactured organic EL element, exudates from a color conversion layer, such as moisture and residue of organic solvent, causes serious problem that materials constituting the organic EL element deteriorate and non-light-emission region is generated. Therefore, it is desirable that the color conversion layer is as thin as possible. In the color conversion layer where a luminescent material is used, low absorption rate of a guest is covered by using host which absorbs blue light together. However, in case of the color conversion layer where a luminescent material is used, materials serving as a host are not necessarily required to be used together, even in the case where a luminescent material is used alone, high color conversion efficiency can be achieved. Thus, many problems which are concerned in the color conversion layer manufactured using host together, such as emission from host molecule, deterioration of properties of manufactured color conversion layer and increase of manufacturing cost of the substrate, can be advantageously solved at the same time. In addition, in the case where host is used, as mentioned above, too high concentration of fluorescent material often causes concentration quenching, thus weakening emission remarkably. However, it is known that the phosphorescent material doesn't tend to cause concentration quenching compared with the fluorescent material and the dispersion concentration is not limited. For example, more phosphorescent material emits light even in a powder state compared with a fluorescent material and, on the contrary, too low dispersion concentration weakens emission due to quenching effect by oxygen molecule. When the phosphorescent material is used in a powder state, it is effective from the viewpoint that inhibition of deterioration of the color conversion layer can be achieved. In the color conversion layer, since it is constantly light-exposed in the lithography step at the time of manufacturing a substrate, ITO patterning step and process of color conversion as an element, there is a problem that color conversion efficiency is reduced due to deterioration by light. When luminescent material dispersed in the color conversion layer is used, the material deteriorates extremely rapidly because the luminescent material itself alone is exposed to light and it is extremely difficult to prevent the deterioration. On the contrary, since the color conversion layer in which a phosphorescent material in a power state is used, is exposed to light as a bulk, color conversion layer in which deterioration is reduced, a long lifetime is achieved and conversion efficiency does not change.

There is no particular limitation on the position where the color conversion layer is provided, and can be conveniently chosen according to the purpose, for example, it is preferably provided on the pixels when full color display is conducted.

In the second organic EL element of the present invention, it is required that the color conversion layer is capable of converting incident light into light having a wavelength longer than the wavelength thereof by 100nm or more and is preferably capable of converting incident light into light having a wavelength longer than the wavelength thereof by 150nm or more. In the first organic EL element of the present invention, the color conversion layer is preferably capable of converting incident light into light having a wavelength longer than the wavelength thereof by 100nm or more and is more preferably capable of converting incident light into light having a wavelength longer than the wavelength thereof by 150nm or more.

The color conversion layer is preferably capable of converting light in the wavelength of ultraviolet light to blue light into red light.

There is no particular limitation on the method of forming the color conversion layer, and may be conveniently chosen according to the purpose, but for example, vapor deposition and coating method are preferred.

In the case of the first organic EL element of the present, the color conversion layer is not necessarily essential and may be provided if required. There is no particular limitation on the color conversion layer and may be conveniently chosen according to the purpose. It is preferable that the color conversion layer is formed using at least one of the organometallic complexes from the first organometallic complex to the third organometallic complex of the present invention but color filter, etc. known in the art may be used.

There is no particular limitation on the protective layer, and may be conveniently chosen according to the purpose, but for example a layer which can prevent molecules or substances which promote deterioration of the organic EL element, such as moisture and oxygen, from penetrating the organic EL element, is preferred.

Examples of the material of the protective layer are metals such as In, Sn, Pb, Au, Cu, Ag, Al, Ti and Ni, metal oxides such as MgO, SiO, $SiO_2$, $Al_2O_3$, GeO, NiO, CaO, BaO, $Fe_2O_3$, $Y_2O_3$ and $TiO_2$, nitrides such as SiN and $SiN_xO_y$, metal fluorides such as $MgF_2$, LiF, $AlF_3$, $CaF_2$, polyethylene, polypropylene, polymethyl methacrylate, polyimide, polyurea, polytetrafluoroethylene, polychlorotrifluoroethylene, polydichlorodifluoroethylene, a copolymer of chlorotrifluoroethylene and dichlorodifluoroethylene, a copolymer obtained by copolymerizing a monomer mixture comprising tetrafluoroethylene and at least one comonomer, a fluorine-containing copolymer having a ring structure in a main chain of the copolymer, a water-absorbing substance having a water absorption rate of 1% or more, and a dampproof substance

having a water absorption rate of 0.1% or less.

The protection layer can be conveniently formed by known methods such as the vapor deposition method, wet film forming method, sputtering method, reactive sputtering method, molecular beam epitaxy (MBE) method, cluster ion beam method, ion plating method, plasma polymerization method (high frequency excitation ion plating method), printing method and transfer method.

There is no particular limitation on the structure of the organic EL element of the present invention, and may be chosen according to the purpose. Suitable examples include the following layer compositions (1) to (13):

(1) Positive electrode/positive hole injection layer/positive hole transport layer/light-emitting layer/electron transport layer/electron injection layer/negative electrode,
(2) Positive electrode/positive hole injection layer/positive hole transport layer/light-emitting layer/electron transport layer/negative electrode,
(3) Positive electrode/positive hole transport layer/light-emitting layer/electron transport layer/electron injection layer/negative electrode,
(4) Positive electrode/positive hole transport layer/light-emitting layer/ electron transport layer/negative electrode,
(5) Positive electrode/positive hole injection layer/positive hole transport layer/light-emitting and electron transport layer/electron injection layer/negative electrode,
(6) Positive electrode/positive hole injection layer/positive hole transport layer/light-emitting and electron transport layer/negative electrode,
(7) Positive electrode/positive hole transport layer/light-emitting and electron transport layer/electron injection layer/negative electrode,
(8) Positive electrode/positive hole transport layer/light-emitting and electron transport layer/negative electrode,
(9) Positive electrode/positive hole injection layer/positive hole transport and light-emitting layer/electron transport layer/electron injection layer/negative electrode,
(10) Positive electrode/positive hole injection layer/positive hole transport and light-emitting layer/electron transport layer/negative electrode,
(11) Positive electrode/positive hole transport and light-emitting layer/electron transport layer/electron injection layer/negative electrode,
(12) Positive electrode/positive hole transport and light-emitting layer/electron transport layer/negative electrode,
(13) Positive electrode/positive hole transport, light-emitting and electron transport layer/negative electrode.

When the organic EL element has a positive hole blocking layer, in the (1) to (13), layer compositions wherein the positive hole blocking layer is disposed between the light-emitting layer and electron transport layer are also suitable.

Of these layer compositions, the aspect (4), positive electrode/positive hole transport layer/ light-emitting layer/ electron transport layer/negative electrode, is shown in FIG. 1. An organic EL element 10 has a layer composition comprising an positive electrode 14 (for example, an ITO electrode) formed on a glass substrate 12, a positive hole transport layer 16, a light-emitting layer 18, an electron transport layer 20, and a negative electrode 22 (for example, an Al-Li electrode) laminated in this order. The positive electrode 14 (for example, an ITO electrode) and the negative electrode 22 (for example, an Al-Li electrode) are interconnected through a power supply. An organic thin film layer 24 which emits red light is formed by the positive hole transport layer 16, light-emitting layer 18 and electron transport layer 20.

The luminescence peak wavelength of the organic EL element of the present invention is preferably 600 to 650nm.

From the viewpoint of light-emitting efficiency of the organic EL element of the present invention, it is desired that it emits red light at a voltage of 10V or less, preferably at a voltage of 7V or less, and more preferably at a voltage of 5V or less.

It is preferred that, at an applied voltage of 10V, the emission luminance of the organic EL element of the present invention is 100 cd/$m^2$ or more, more preferably 500 cd/$m^2$ or more, and particularly preferably 1,000 cd/$m^2$ or more.

The organic EL element of the present invention is especially useful in various fields such as lighting units, computers, vehicle-mounted display devices, field-ready display devices, home apparatuses, industrial apparatuses, household electric appliances, traffic display devices, clock display devices, calendar display units, luminescent screens and audio equipment, and is particularly suitable for lighting units and the organic EL display of the present invention, described below.

<Organic EL display>

There is no particular limitation on the organic EL display of the present invention, and can be chosen from known compositions, except that it uses the organic EL element of the present invention.

The organic EL display may be a monochrome, a multicolor, or a full color type.

The organic EL display may be made a full color type using several methods including those disclosed in "Monthly Display (published by Techno Times Co., Ltd. of Japan)", September 2000, pages 33-37, i.e., (a) the three color light emitting method wherein three types of organic EL elements which, respectively, emit light corresponding to the three primary colors (blue (B), green (G), red (R)) are disposed on a substrate; (b) the white light method wherein white light from an organic EL element for white light emission is divided into the three primary colors via color filters; (c) and the color conversion method wherein blue light emitted by an organic EL element which emits blue light is converted into red (R) and green (G) via a fluorescent pigment layer. In the present invention, as the organic EL element of the invention emits red light, the three color light emitting method and color conversion method can be used, the three color light emitting method being particularly suitable.

When at least any one of the first organometallic complex to the third organometallic complex of the present invention is used as a color conversion material, the color conversion method can particularly preferably be used.

Specific example of the organic EL display of the present invention using the color conversion method includes the organic EL display as shown in FIG. 8. This organic EL display comprises electrodes 25 arranged so as to correspond to pixels and an organic thin film layer 30 for blue light provided over the electrodes, further comprises a transparent electrode 20 thereon. Over the transparent electrode 20, a laminate of color conversion layer for red color 60 and red color filter 65, and a laminate of color conversion layer for green color 80 and green color filter 70 are arranged via a protective layer (planarizing layer) 15, and a glass substrate 10 is provided thereon.

When a voltage is applied between the electrodes 25 and transparent electrode 20 in this organic EL display, the organic thin film layer 30 for blue light emission emits blue light. A part of this blue light-emitting light transmits the transparent electrode 20, further transmits the protective layer 15 and glass substrate 10 without conversion, and radiated outside. On the contrary, in the part of the color conversion layer for red color 60 and the part of the color conversion layer for green color 70, the blue light-emitting light is converted into red or green in these color conversion layers and further transmits the red color filter 65 or green color filter 70, thus transmitting the glass substrate 10 as red light-emitting light or green light-emitting light. As a result, a full display can be achieved in the organic EL display.

When the color conversion layers 60 and 80 are formed of the organometallic complex (phosphorescent material) of the present invention, a color conversion layer can be formed of a single film composed of the organometallic complex without using host material etc., particularly even in the case of the color conversion layer for red color, and the organic EL display can be easily manufactured and, in addition, and has extraordinary excellent color conversion efficiency. FIG. 6 is a view describing an example of the structure of an organic EL display according to the three color light emitting method. FIG. 7 is a view describing an example of the structure of an organic EL display according to the white light method. The reference character in FIGS. 6 and 7 refers to the same reference number in FIG. 8.

Moreover, in manufacturing a full color organic EL display by the three color light emitting method, the organic EL element of the present invention is used for red light emission, and besides, an organic EL element for green light emission and organic EL element for blue light emission are required.

There is no particular limitation on the organic EL element used for blue light emission which may be selected from among those known in the art, but suitable laminar constructions include ITO (positive electrode)/NPD/Al-Li (negative electrode).

There is no particular limitation on the organic EL element used for green light emission which may selected from among those known in the art, but suitable laminar constructions include ITO (positive electrode)/NPD/Alq/Al-Li (negative electrode).

There is no particular limitation on the aspects of the organic EL display, and may be chosen according to the purpose. Examples include a passive matrix panel and active matrix panel disclosed in Nikkei Electronics (published by Nikkei Business Publications Inc. of Japan), No. 765, March 13, 2000, pages 55-62.

The passive matrix panel for example has belt-like positive electrodes 14 (for example, ITO electrodes) arranged parallel to each other on a glass substrate 12 as shown in FIG. 2. On the positive electrodes 14, belt-like organic thin film layers 24 for red light emission, organic thin film layers 26 for blue light emission and organic thin film layer 28 for green light emission are arranged sequentially in parallel and substantially perpendicular to the positive electrodes 14. Each of the organic thin film layers has negative electrodes 22 of identical shape thereon.

In the passive matrix panel, positive electrode lines 30 comprising a plurality of positive electrodes 14, and negative electrode lines 32 comprising a plurality of negative electrodes 22, for example intersect substantially at right angles to form a circuit, as shown in FIG. 3. Each of the organic thin film layers 24, 26, and 28 for red light emission, blue light emission and green light emission situated at each intersection point functions as a pixel, there being a plurality of organic EL elements 34 corresponding to each pixel. In this passive matrix panel, when a current is applied by a constant-current supply 36 to one of the positive electrodes 14 in the positive electrode lines 30, and one of the negative electrodes 22 in the negative electrode lines 32, a current will be applied to an organic EL thin film layer situated at the intersection, and the organic EL thin film layer at this position will emit light. By controlling the light emission of each pixel unit, a full color picture can easily be formed.

In the active matrix panel, for example, scanning lines, data lines and current supply lines are arranged in a grid pattern on a glass substrate 12, as shown in FIG. 4. A TFT circuit 40 connected to the scanning lines and the like forming the grid pattern is disposed in each grid, and an positive electrode 14 (for example, an ITO electrode) disposed in each grid can be driven by the TFT circuit 40. On the positive electrodes 14, a belt-like organic thin film layer 24 for red light emission, organic thin film layer 26 for blue light emission and organic thin film layer 28 for green light emission, are arranged sequentially and in parallel to each other. A negative electrode 22 is further arranged so as to cover each of the organic thin film layer 24 for red light emission, organic thin film layer 26 for blue light emission and organic thin film layer 28 for green light emission. The organic thin film layer 24 for red light emission, organic thin film layer 26 for blue light emission and organic thin film layer 28 for green light emission, respectively, comprise a positive hole transport layer 16, light-emitting layer 18 and electron transport layer 20.

In the active matrix panel, as shown in FIG. 5, a plurality of scanning lines 46 are arranged in parallel to each other intersecting in substantially right angles with a plurality of data lines 42 and current supply lines 44, which are parallel to each other, to form grids, and a switching TFT 48 and driver TFT 50 are connected to each grid to form a circuit. If a current is applied from a driver circuit 38, the switching TFT 48 and driver TFT 50 can be driven for each grid. In each grid, the organic thin film elements 24, 26, and 28 for blue light emission, green light emission and red light emission function as a pixel. In this active matrix panel, if a current is applied from the driver circuit 38 to one of the scanning lines 46 arranged in the horizontal direction, and the current supply lines 44 arranged in the vertical direction, the switching TFT 48 situated at the intersection is driven, the driver TFT 50 is driven as a result, and an organic EL element 52 at this position emits light. By controlling the light emission of each pixel unit, a full color picture can easily be formed.

The organic EL display of the present invention may be conveniently used in fields of various kinds such as computers, vehicle-mounted display devices, field-ready display devices, home apparatuses, industrial apparatuses, household electric appliances, traffic display devices, clock display devices, calendar display units, luminescent screens and audio equipment.

The present invention will be illustrated in further detail with reference to several examples below, which are not intended to limit the scope of the present invention.

(Example1)

- Synthesis of $Re(CO)_4$(8-quinolinate) -

$Re(CO)_4$ (8-quinolinate) was synthesized using $Re(CO)_5Cl$ and 8-quinolinate as raw materials according to the method described in Inorg. Chem. 1993, 1, 32, 398-401. Specifically, as shown in the following reaction equation, $Re(CO)_5Cl$ and 8-quinoline had been reacted in toluene with stirring under reflux until generation of the HCl gas stopped. The toluene was evaporated and diethyl ether was added to let the solution cool. A yellow precipitate was filtrated and obtained precipitate was washed with diethyl ether. Then, recrystallization was performed twice using mixed solvent of acetone and diethyl ether to thereby synthesize $Re(CO)_4$(8-quinolinate) as an objective substance.

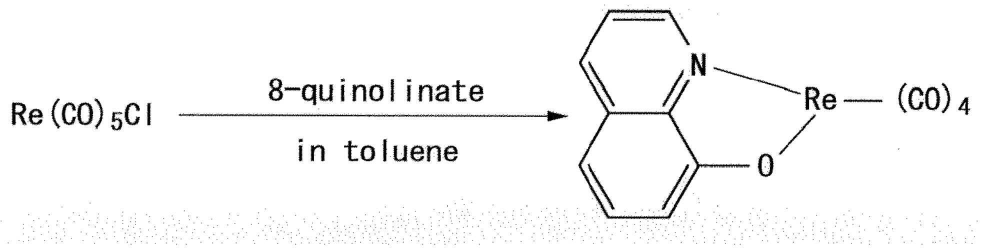


(Example 2)

- Synthesis of $Re(CO)_4$ (2-(2'-pyridyl)phenol) -

$Re(CO)_4$(2-(2'-pyridyl)phenol) was synthesized as in Example 1, except that 8-quinoline was replaced by 2-(2'-pyridyl)phenol.

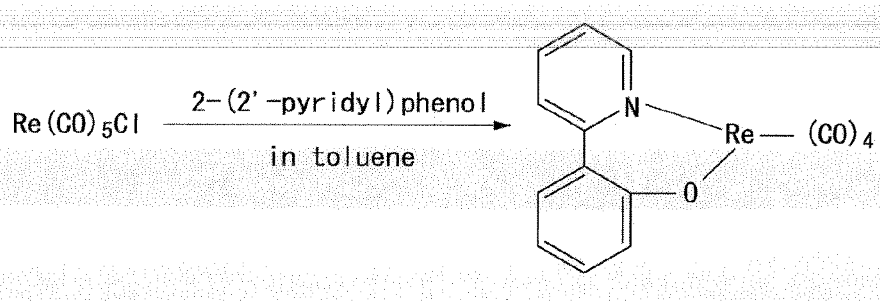


(Example 3)

- Synthesis of $Re(CO)_2$(8-quinoline)(2-(2'-pyridyl)phenol)-

$Re(CO)_2$(8-quinolinate)(2-(2'-pyridyl)phenol) was synthesized as in Example 1, except that $Re(CO)_5Cl$ was replaced by $Re(CO)_4Cl_2$ and 8-quinolinate serving as was replaced by 8-quinolinate and 2-(2'-pyridyl)phenol (1:1). Obtained crude product was separated by column. The yield was 10 %.

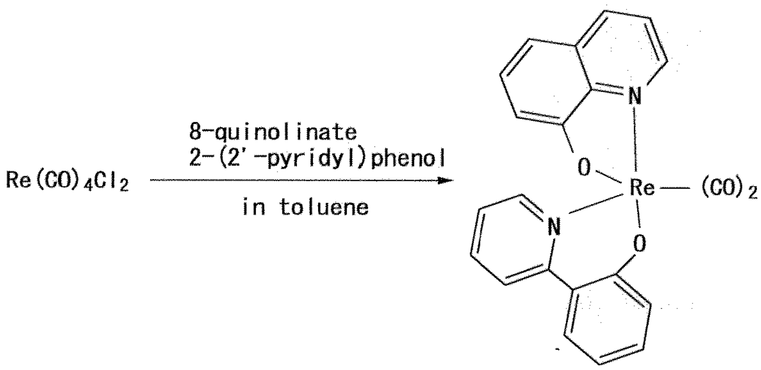


(Example 4)

- Synthesis of Re(8-quinolinate)(2-(2'-pyridyl)phenol)(7,8-benzoquinoline) -

Re(8-quinolinate)(2-(2'-pyridyl)phenol)(7,8-benzoquinoline) was synthesized as in Example 1, except that Re $(CO)_5Cl$ was replaced by $ReCl_3$, 8-quinolinate serving as ligand was replaced by 8-quinolinate, 2-(2'-pyridyl)phenol and 7,8-benzoquinoline and these were subsequently coordinated with Re. Product was separated by column with respect to coordination of each ligand. The total yield was about 2%.

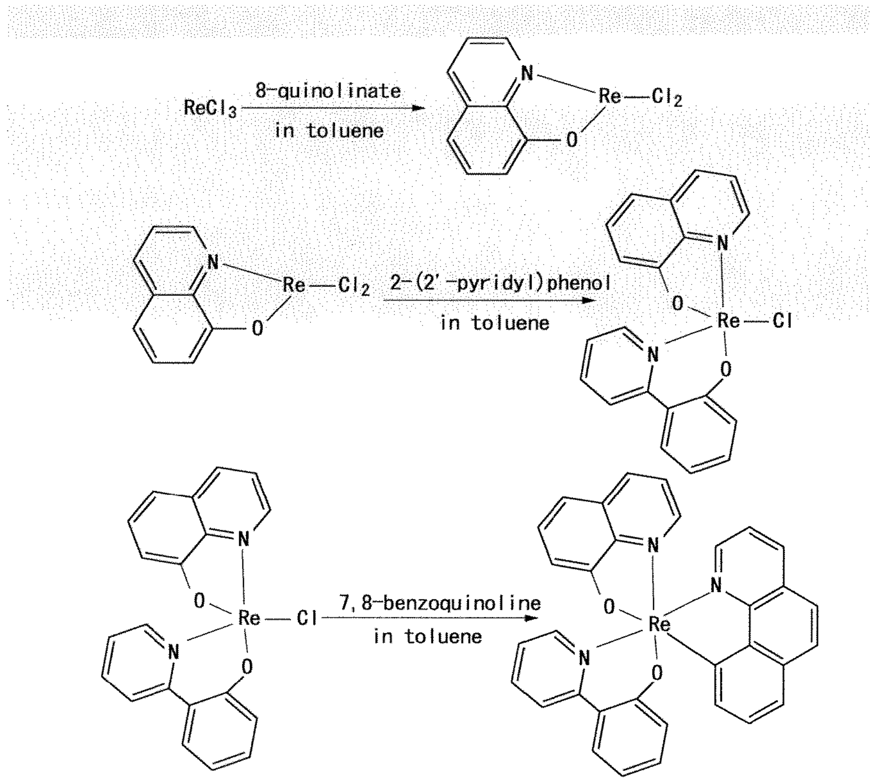


(Example 5)

- Manufacture of organic EL element -

Using the organic rhenium complexes respectively synthesized in Examples 1 to 4, laminated organic EL elements comprising a light-emitting layer which comprises one of the organic rhenium complexes as a luminescent material, were produced as follows. A glass substrate wherein an ITO electrode was formed as a positive electrode was subjected to ultrasonic cleaning in water, acetone and isopropyl alcohol and after performing UV ozonization, it was coated with (N,N'-diphenyl-N,N'-bis(3-methylphenyl)-[1,1'-biphenyl]-4,4'-diamine) (TPD) to a thickness of 50nm as a positive hole transport layer on this ITO electrode using a vacuum vapor deposition system (degree of vacuum = $1x10^{-6}$Torr ($1.3x10^{-4}$Pa), substrate temperature = room temperature). Next, the organic rhenium complexes respectively synthesized in Examples 1 to 7, were vapor deposited to a thickness of 20nm to form a light-emitting layer on this TPD positive hole transport layer. A vapor deposit of 2,9-dimethyl-4,7-diphenyl-1,10-phenanthroline (BCP) was then formed to a thickness of 10nm as a first electron transport layer on the light-emitting layer. Further, a vapor deposit of aluminum quinoline complex (Alq) was formed to a thickness of 20nm as a second electron transport layer on the first electron transport layer, and an Al-Li alloy (Li content = 0.5 % by mass) layer was formed as a negative electrode by vapor deposition to a thickness of 50nm on the aluminum quinoline complex (Alq) second electron transport layer. In this way, four organic EL elements were manufactured.

When a voltage was applied to the ITO electrode (positive electrode) and Al-Li alloy (negative electrode) of the manufactured organic EL elements, a high color purity red light emission was observed for each element at a voltage of 5V or higher. Also, for each organic EL element, emission luminance (cd/$m^2$) at an applied voltage of 10V and an effective half-life with an initial luminance of 100 cd/$m^2$ (by constant current measurement) was measured. The results are shown in Table 1. The numbers 1 to 4 in Table 1 refer to Examples 1 to 4, and to the organic rhenium complexes obtained in each example.

Table 1

| | Organic rhenium complex | Luminance ($cd/m^2$) | Lifetime (hours) |
|---|---|---|---|
| 1 | $Re(CO)_4$(quin) | 1200 | 2000 |
| 2 | $Re(CO)_4$(pyph) | 1500 | 2000 |
| 3 | $Re(CO)_2$(quin)(pyph) | 3500 | 2000 |
| 4 | Re(quin)(pyph)(bzq) | 6000 | 1500 |

(Example 6)

- Manufacture of organic EL element -

Seven kinds of organic EL elements were manufactured as in Example 5, except that whereas in Example 5 the light-emitting layer was formed of only the organic rhenium complex, in this example the organic rhenium complex and 4,4'-bis(9-carbazolyl)-biphenyl (CBP) represented by the formula (13) were simultaneously deposited in such a way that there were 99 molecules (99 moles) of CBP for one molecule (1 mole) of organic rhenium complex to form the light-emitting layer.

When a voltage was applied to the ITO electrode (positive electrode) and Al-Li alloy (negative electrode) of the manufactured organic EL elements, a high color purity red light emission was observed for each element at a voltage of 5V or higher. Also, for each organic EL element, emission luminance ($cd/m^2$) at an applied voltage of 10V and an effective half-life with an initial luminance of 100 $cd/m^2$ (by constant current measurement) was measured. The results are shown in Table 2. The numbers 1 to 4 in Table 2 refer to Example 1 to 4, and to the organic rhenium complexes obtained in each example.

Table 2

| | Organic rhenium complex | Luminance ($cd/m^2$) | Lifetime (hours) |
|---|---|---|---|
| 1 | $Re(CO)_4$(quin) | 2000 | 2000 |
| 2 | $Re(CO)_4$(pyph) | 2000 | 3000 |
| 3 | $Re(CO)_2$(quin)(pyph) | 4500 | 3000 |
| 4 | Re(quin)(pyph)(bzq) | 8000 | 2000 |

(Example 7)

- Synthesis of $Re(CO)_4$ (7,8-benzoquinoline) -

$Re(CO)_4$(7,8-benzoquinoline) was synthesized using $Re(CO)_5Cl$ and 7,8-benzoquinoline as raw materials according to the method described in Inorg. Chem. 1993, 32, 5633-5636. $Re(CO)_5Cl$ and 7,8-benzoquinoline were reacted in toluene deaerated with nitrogen gas with stirring under reflux for several hours according to the following reaction equation, hot hexane was added to the reaction product remaining after evaporation of the toluene, and the reaction product was extracted. Next, the obtained yellow crude product was recrystallized several times with hexane, and unreacted 7,8-benzoquinoline was removed. In this way, $Re(CO)_4$(7,8-benzoquinoline) was synthesized as an organic rhenium complex of the present invention.

Synthesis of $Re(CO)_4$(7,8-benzoquinoline)

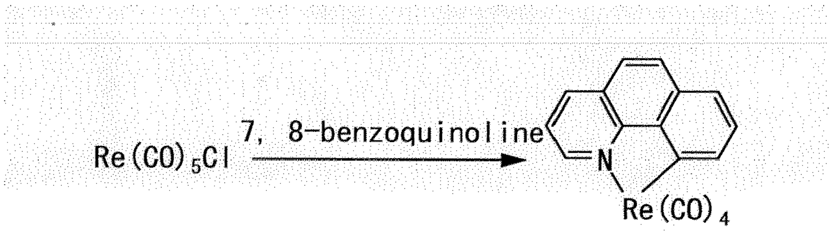


(Example 8)

- Synthesis of $Re(CO)_4$(2-phenylpyridine) -

$Re(CO)_4$(2-phenylpyridine) was synthesized as in Example 7, except that in Example 1, 7,8-benzoquinoline was replaced by 2-phenylpyridine.

(Example 9)

- Synthesis of $Re(CO)_4$(2-phenyloxazoline) -

$Re(CO)_4$(2-phenyloxazoline) was synthesized as in Example 7, except that in Example 1, 7,8-benzoquinoline was replaced by 2-phenyloxazoline.

(Example 10)

- Synthesis of $Re(CO)_4$(2-phenylthiazoline) -

$Re(CO)_4$(2-phenylthiazoline) was synthesized as in Example 7, except that in Example 1, 7,8-benzoquinoline was replaced by 2-phenylthiazoline.

(Example 11)

- Synthesis of $Re(CO)_4$(2-(2'-thienyl)pyridine)-

Re $(CO)_4$(2-(2'-thienyl) pyridine) was synthesized as in Example 1, except that in Example 7, 7,8-benzoquinoline was replaced by 2-(2'-thienyl)pyridine.

(Example 12)

- Synthesis of $Re(CO)_4$(2-(2'-thienyl)thiazoline) -

$Re(CO)_4$(2-(2'-thienyl) thiazoline was as in Example 7, except that in Example 1, 7,8-benzoquinoline was replaced by 2-(2'-thienyl)thiazoline.

(Example 13)

- Synthesis of $Re(CO)_4$(3-(2'-thiazolyl)-2H-pyran-2-one)-

$Re(CO)_4$(3-(2'-thiazolyl)-2H-pyran-2-one) was synthesized as in Example 1, except that in Example 7, 7,8-benzoquinoline was replaced by 3-(2'-thiazolyl)-2H-pyran-2-one.

(Example 14)

- Manufacture of organic EL element -

Using the organic rhenium complexes respectively synthesized in Examples 7 to 13, laminated organic EL elements comprising a light-emitting layer which comprises one of the organic rhenium complexes as a luminescent

material, were produced as follows. A glass substrate wherein an ITO electrode was formed as a positive electrode was subjected to ultrasonic cleaning in water, acetone and isopropyl alcohol, and after performing UV ozonization, it was coated with (N,N'-diphenyl-N,N'-bis(3-methylphenyl)-[1,1'-biphenyl]-4,4'-diamine) (TPD) to a thickness of 50nm as a positive hole transport layer on this ITO electrode using a vacuum vapor deposition system (degree of vacuum = $1x10^{-6}$Torr ($1.3x10^{-4}$Pa), substrate temperature = room temperature). Next, the organic rhenium complexes respectively synthesized in Examples 1 to 7, were vapor deposited to a thickness of 20nm to form a light-emitting layer on this TPD positive hole transport layer. A vapor deposit of 2,9-dimethyl-4,7-diphenyl-1,10-phenanthroline (BCP) was then formed to a thickness of 10nm as a first electron transport layer on the light-emitting layer. Further, a vapor deposit of aluminum quinoline complex (Alq) was formed to a thickness of 20nm as a second electron transport layer on the first electron transport layer, and an Al-Li alloy (Li content = 0.5 % by mass) layer was formed as a negative electrode by vapor deposition to a thickness of 50nm on the aluminum quinoline complex (Alq) second electron transport layer. In this way, seven organic EL elements were manufactured.

When a voltage was applied to the ITO electrode (positive electrode) and Al-Li alloy (negative electrode) of the manufactured organic EL elements, a high color purity red light emission was observed for each element at a voltage of 5V or higher. Also, for each organic EL element, emission luminance (cd/$m^2$) at an applied voltage of 10V and an effective half-life with an initial luminance of 100 cd/$m^2$ (by constant current measurement) was measured. The results are shown in Table 3. The numbers 7 to 13 in Table 3 refer to Examples 7 to 13, and refer to the organic rhenium complexes obtained in each example.

Table 3

| | Organic rhenium complex | Luminance (cd/$m^2$) | Lifetime (hours) |
|---|---|---|---|
| 7 | $Re(CO)_4$(7,8-benzoquinoline) | 1820 | 1000 |
| 8 | $Re(CO)_4$(2-phenylpyridine) | 1620 | 3000 |
| 9 | $Re(CO)_4$(2-phenyloxazoline) | 1630 | 3000 |
| 10 | $Re(CO)_4$(2-phenylthiozoline) | 1500 | 2000 |
| 11 | $Re(CO)_4$(2-(2'-thienyl)pyridine) | 1500 | 2000 |
| 12 | $Re(CO)_4$(2-(2'-thienyl)thiozoline) | 1640 | 2400 |
| 13 | $Re(CO)_4$(3-(2'-thiozolyl)-2H-pyrane-2-one) | 1000 | 3000 |

(Example 15)

- Manufacture of organic EL element -

Seven kinds of organic EL elements were manufactured as in Example 14, except that whereas in Example 8 the light-emitting layer was formed of only the organic rhenium complex, in this example the organic rhenium complex and 4,4'-bis(9-carbazolyl)-biphenyl (CBP) represented by the formula (59) were simultaneously deposited in such a way that there were 99 molecules (99 moles) of CBP for one molecule (1 mole) of organic rhenium complex to form the light-emitting layer.

When a voltage was applied to the ITO electrode (positive electrode) and Al-Li alloy (negative electrode) of the manufactured organic EL elements, a high color purity red light emission was observed for each element at a voltage of 5V or higher. Also, for each organic EL element emission luminance (cd/$m^2$) at an applied voltage of 10V and an effective half-life with an initial luminance of 100 cd/$m^2$ (by constant current measurement) was measured. The results are shown in Table 4. The numbers 7 to 13 in Table 4 refer to Examples 7 to 13, and refer to the organic rhenium complexes obtained in each example.

Table 4

| | Organic rhenium complex | Luminance (cd/$m^2$) | Lifetime (hours) |
|---|---|---|---|
| 7 | $Re(CO)_4$(7,8-benzoquinoline) | 3600 | 1500 |
| 8 | $Re(CO)_4$(2-phenylpyridine) | 3000 | 3500 |

(continued)

| | Organic rhenium complex | Luminance ($cd/m^2$) | Lifetime (hours) |
|---|---|---|---|
| 9 | $Re(CO)_4$(2-phenyloxazoline) | 2800 | 3500 |
| 10 | $Re(CO)_4$(2-phenylthiozoline) | 2860 | 2500 |
| 11 | $Re(CO)_4$(2-(2'-thienyl)pyridine) | 2200 | 1500 |
| 12 | $Re(CO)_4$(2-(2'-thienyl)thiozoline) | 2020 | 2500 |
| 13 | $Re(CO)_4$(3-(2'-thiozolyl)-2H-pyrane-2-one) | 1520 | 2000 |

(Example 16)

-Synthesis of Pt(dpphen)(ecda)-

In Example 16, "dpphen" is an abbreviation of 4,7-diphenyl-1,10-phenanthroline and "ecda" is an abbreviation of 1-(ethoxycarbonyl)-1-cyanoethylene-2,2-dithiolate.

(1) Synthesis of $K_2$(ecda)

$K_2$(ecda) was synthesized using potassium hydroxide (KOH), ethylcyanoacetat and carbon disulfide as raw materials according to the method described in Acta Chem. Scand. 22, 1968, 1107-1128. Specifically, as shown in the following reaction equation, 11.2g of crushed potassium hydroxide was added to dioxane and was dissolved with stirring under 15-20. 11.3 g of ethyl cyanoacetate and 7.6 g of carbon disulfide are gradually added to this solution. After addition, the solution was stirred for 20 minutes and diluted with ether to produce a yellow precipitate. This precipitate was filtered, obtained precipitate was washed with mixed solvent of dioxane : ether (1:1) (mass ratio) and was vacuum dried to synthesize $K_2$(ecda) (compound represented by I in the following reaction equation).

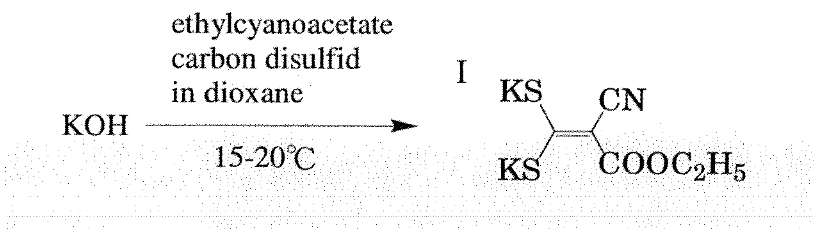

I

(2) Synthesis of $Pt(dpphen)Cl_2$

According to the method described in the J. Am. Chem. Soc. 1990, 112, 5625-5627 & J. Chem. Soc. Dalton Trans. 1978, 1127, $Pt(dpphen)Cl_2$ was synthesized using $K_2[PtCl_4]$ and 4,7-diphenyl-1,10-phenanthroline (dpphen) as raw materials. Specifically, as shown in the following reaction equation, 1 g of $K_2[PtCl_4]$ was dissolved in pure water and heated. An aqueous solution, in which 0.8 g of 4,7-diphenyl-1,10-phenanthroline (dpphen) was dissolved in pure water, was gradually added to this solution. After stirring for a while, precipitate was produced. This precipitate was collected by filtration, and obtained precipitate was washed with acetone to synthesize $Pt(dpphen)Cl_2$ (compound represented by II in the following reaction equation).

II

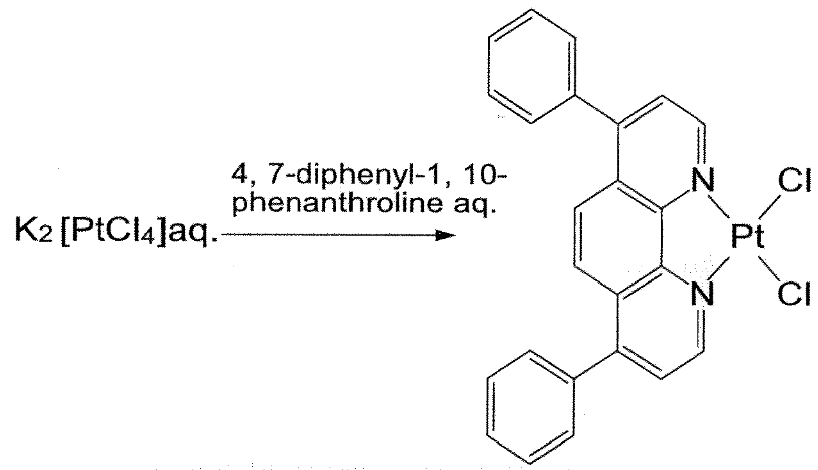


(3) Synthesis of Pt(dpphen)(ecda)

Pt(dpphen)(ecda) was synthesized according to the method described in Cooed. Chem. Rev. 97, 1990, 47-64. Specifically, as shown in the following reaction equation, when a solution in which 0.3 g of $K_2$(ecda) (compound represented by I in the above reaction equation) was dissolved in methanol, was dropped to a solution in which 0.6 g of Pt (dpphen)$Cl_2$ (compound represented by I in the above reaction equation) was dissolved in acetone, an orange precipitate was produced. Centrifugation was performed to cause a precipitate (metal complex) and this precipitate was collected by filtration. Obtained organometallic complex was washed with acetone, ethanol and diethyl ether, and was vacuum dried to synthesize Pt(dpphen)(ecda).

II

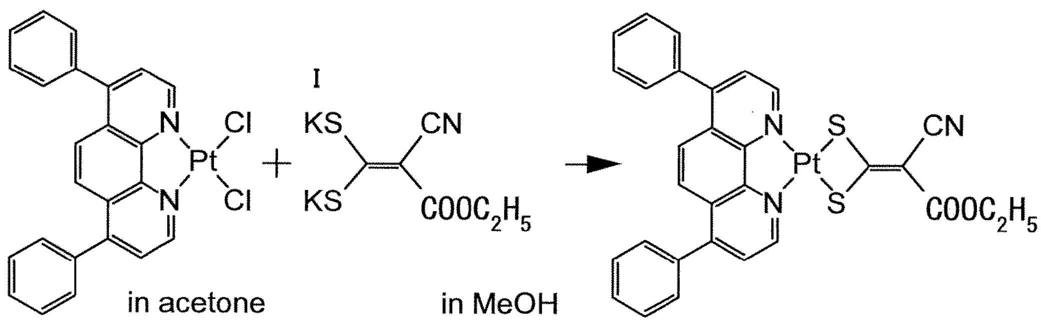
I


(Example 17)

- Manufacture of organic EL element -

Using the organometallic complex (Pt(dpphen)(ecda)) synthesized in Example 16 as a luminescent material, a polymer dispersion type organic EL element was produced as follows. A glass substrate wherein an ITO electrode was formed as a positive electrode was subjected to ultrasonic cleaning in water, acetone and isopropyl alcohol, and after performing UV ozonization, this ITO electrode was coated with a solution in which polyvinyl carbazole was doped with 0.5 % by mass organometallic complex (Pt(dpphen)(ecda)) synthesized in Example 16 to form a positive hole transport layer and light-emitting layer thereon to a thickness of 50nm by spin-coating. Next, A vapor deposit of aluminum quinoline complex (Alq) was formed to a thickness of 20nm as an electron transport layer on this positive hole transport layer and light-emitting layer, using a vacuum vapor deposition system (degree of vacuum = $1x10^{-6}$Torr ($1.3x10^{-4}$Pa),

substrate temperature = room temperature). An Al-Li alloy (Li content = 11.5 % by mass) layer was formed as a negative electrode by vapor deposition to a thickness of 50nm on the electron transport layer. In this way, the organic EL element was manufactured.

When a voltage was applied to the ITO electrode (positive electrode) and Al-Li alloy (negative electrode) of the manufactured organic EL elements, a red light emission was observed at a voltage of 6V or higher.

Also, for the organic EL element, emission luminance (cd/$m^2$) at an applied voltage of 10V and an effective half-life with an initial luminance of 100 cd/$m^2$ (by constant current measurement) was measured. The emission luminance was 3300 (cd/$m^2$) and effective half-life was 500 hours.

(Example 18)

-Synthesis of Pt(diimine)(dithiolate) complex-

(1) Synthesis of $K_2$(ecda)

As in Example 16, $K_2$(ecda) was synthesized using potassium hydroxide (KOH), ethyl cyanoacetate and carbon disulfide as raw materials according to the method described in Acta Chem. Scand. 22, 1968, 1107-1128. Specifically, as shown in the following reaction equation, 11.2g of crushed potassium hydroxide was added to dioxane and was dissolved with stirring, keeping the temperature of 15-20˚C. 11.3 g of ethyl cyanoacetate and 7.6 g of carbon disulfide are gradually added to this solution. After addition, the solution was stirred for 20 minutes and diluted with ether to produce a yellow precipitate. This precipitate was filtered, obtained precipitate was washed with mixed solvent of dioxane : ether (1:1) (mass ratio) and was vacuum dried to synthesize $K_2$ ecda) (compound represented by I in the above reaction equation in Example 16) (yield: about 83%).

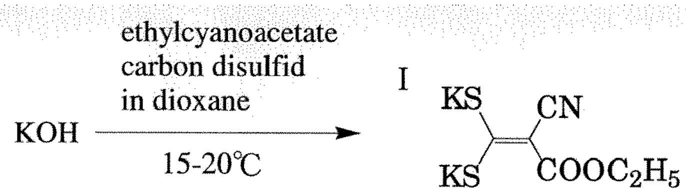


(2) Synthesis of $K_2$(qdt)

100ml of acetone and 2 g of 2,3-quinoxalinedithiol (qdt) were placed in a 200ml of conical flask according to the method described in Acta Chem. Scand. 22, 1968, 1107-1128. 5 g of granular potassium hydrate was put into the flask and was stirred for 30 minutes. A few drops of pure water were put in the flask and stirred for 10 hours under normal temperature. Precipitated yellow object was filtrated and vacuum dried to thereby obtain $K_2$(qdt) (yield: about 80%).

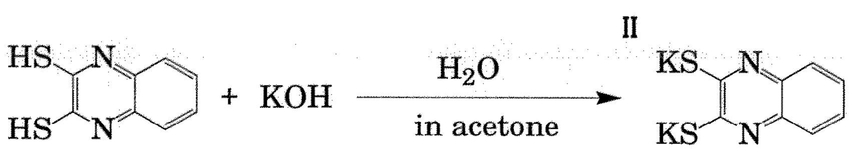


(3) Synthesis of $K_2$(dce)

11.22 g of crushed KOH was added to 100 ml of dioxane according to the method described in Acta Chem. Scand. 22, 1968, 1107-1128. To this solution, a solution in which 6.6 g of Malononitrile was dissolved in 50 ml of dioxane and 7.6 g of carbon disulfide were gradually added with stirring, keeping the temperature of 15-20˚C. After addition, the solution was stirred for 20 minutes and diluted with 250 ml of ether. Yellow precipitate was produced. This precipitate was filtrated, washed with solvent dioxane and ether (1:1) and vacuum dried. The dried product was dissolved in a small amount of water, allowed to precipitate with 1-propanol and purified to thereby obtain $K_2$(dce) (yield: about 80%).

III

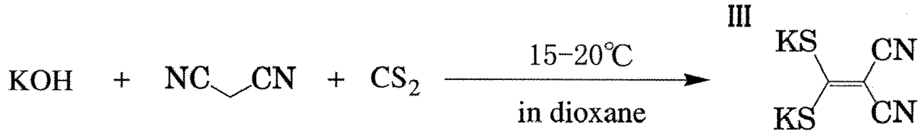


(4) Synthesis of Pt(dpphen)$Cl_2$

As in Example 16, according to the method described in the J. Am. Chem. Soc. 1990, 112, 5625-5627 & J. Chem. Soc. Dalton Trans. 1978, 1127, Pt(dpphen)$Cl_2$ was synthesized using $K_2[PtCl_4]$ and 4,7-diphenyl-1,10-phenanthroline (dpphen) as raw materials. Specifically, as shown in the following reaction equation, 1 g of $K_2[PtCl_4]$ (2.4 mmol) was dissolved in pure water and heated. An aqueous solution, in which 0.8 g of 4, 7-diphenyl-1,10 phenanthroline (dpphen) (2.4 mmol) was dissolved in pure water, was gradually added to this solution. After stirring for a while, precipitate was produced. This precipitate was collected by filtration, and obtained precipitate was with acetone to synthesize Pt (dpphen)$Cl_2$ (compound represented by II in the above reaction equation in Example 16).

IV

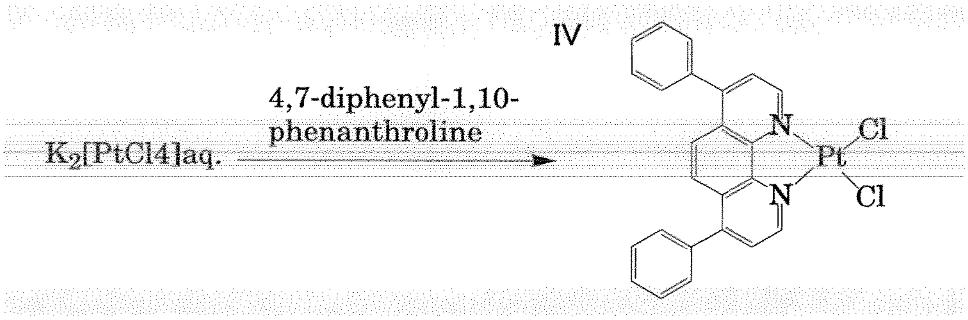


(5) Synthesis of Pt(tmphen)$Cl_2$

Pt(tmphen)$Cl_2$ (V) was synthesized as in the (4) Synthesis of Pt(dpphen)$Cl_2$, except that 3,4,7,8-tetramethyl-1,10-phenanthroline (tmphen) as raw materials (yield: about 90%).

(6) Synthesis of Pt(phen)$Cl_2$ (VI)

Pt(phen)$Cl_2$ (VI) was synthesized as in the (4) Synthesis of Pt(dpphen)$Cl_2$, except that 1,10-phenanthroline (phen) was used as raw materials (yield: about 90%).

(7) Synthesis of Pt(bpy)$Cl_2$ (VII)

Pt (bpy)$Cl_2$(VII) was synthesized as in the (4) Synthesis of Pt(dpphen)$Cl_2$, except that 2,2-dipyridyl(bpy) was used as raw materials (yield: about 79%).

(8) Synthesis of Pt(bcp)$Cl_2$ (VIII)

Pt(bcp)$Cl_2$ (VIII) was synthesized as in the (4) Synthesis of Pt(dpphen)$Cl_2$, except that bathocuproine (bcp) was used as raw materials (yield: about 65%).

(9) Synthesis of Pt(4dmbpy)$Cl_2$ (X)

Pt(4dmbpy)$Cl_2$ (IX) was synthesized as in the (4) Synthesis of Pt(dpphen)$Cl_2$. except that 4,4-dimethyl-2,2'-dipyridyl (4dmbpy) was used as raw materials (yield: about 79%).

(10) Synthesis of Pt(5dmbpy)$Cl_2$ (X)

Pt(5dmbpy)$Cl_2$ (X) was synthesized as in the (4) Synthesis of Pt(dpphen)$Cl_2$, except that 5,5'-dimethyl-2,2'-dipyridyl (5dmbpy) was used as raw materials (yield: about 79%).

(11) Synthesis of Pt(4dpbpy)$Cl_2$ (X)

Pt(4dpbpy)$Cl_2$ (XI) was synthesized as in the (4) Synthesis of Pt(dpphen)$Cl_2$. except that 4,4'-di-tert-butyl-2,2'-dipyridyl (4dpbpy) was used as raw materials (yield: about 79%).

(12) Synthesis of Pt(dbbpy)(qdt)

0.6 g of compound represented by the XI was dissolved in acetone. To this solution, a solution in which 1.0 g of compound represented by the II was dissolved in methanol was dropped. An orange precipitate was produced. Precipitated solid was filtrated, washed with water, ethanol and diethyl ether, and vacuum dried (yield: about 90%). The reaction was carried out according to the method described in the Coord. Chem. Rev. 97, 1990, 47-64.

XI

II

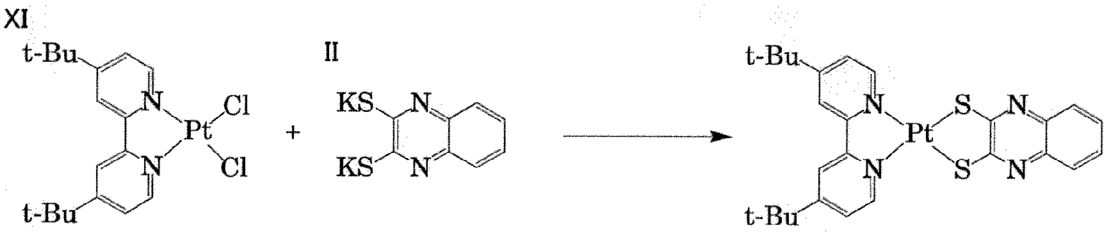

In the same way, 24 kinds of organic, platinum complexes were synthesized from combination of the dithiolate ligands I to III and Pt(diimine)$Cl_2$ IV to XI. FIGS. 9 to 32 are graphs showing emission spectrum data as results from measurement of emission spectrum of the 24 kinds of organic platinum complexes.

Emission spectrum was measured as follows. Specifically, 24 kinds of organic platinum complexes were each dispersed in a polyester resin (optically inactive) so as to form a 2 % by mass solution the solution was coated on a glass substrate by spin-coating. The substrate was heated for 5 hours under normal pressure at 130°C and the solvent was evaporated to thereby obtain a uniform thin film. Emission spectrum was measured by irradiating ultraviolet rays having a wavelength of 365nm to this sample. Spectroradiometer CS-1000 manufactured by MINOLTA co., Ltd was used as a detector.

As comparative experiments, Pt(diimine)(aromatic dithiolate) was synthesized and spectrum, other physical properties and characteristics were compared.

(1) Synthesis of Pt(4dmbpy)(tdt)

According to the method described in the J. Am. Chem. Soc. 1996, 118, 1949-1960, 72 ml of DMSO was placed in a round flask and subjected to $N_2$ gas substitution. 0.5 g of the IX Pt(4dmbpy)$Cl_2$ was placed therein and dissolved by heating. 2ml of methanol was placed in a test reagent bottle, 0.2 g of KOH and 0.3 g of XII 3,4-toluene dithol were placed thereto and the resulting solution was stirred. This solution was dropped to the round flask. As a result, the solution changed into red, and immediately precipitate was produced. After stirring for about 20 minutes, the solution was left standing to cool. An excess of pure water was added to the cooled reaction system. A dark red precipitate was taken out by filtration, washed with pure water and diethyl ether repeatedly and vacuum dried (yield: about 32%).

IX

XII

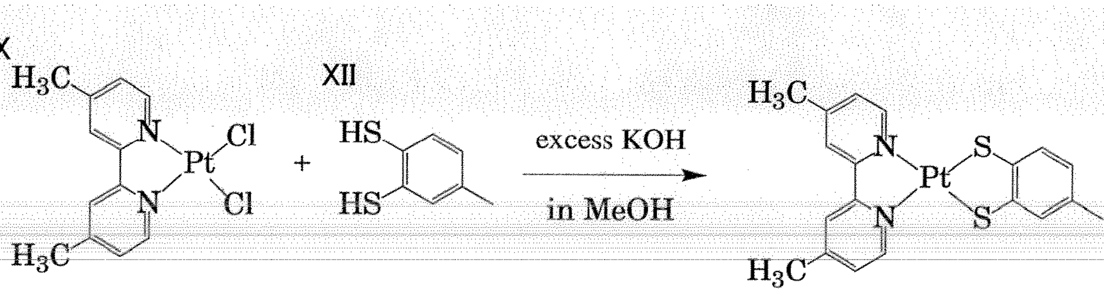

Obtained Pt(4dmbpy)(tdt) had a strong photosensitivity in a solution state and was completely degraded when it was left under outside light.

(2) Synthesis of Pt(dpbpy)(tdt)

According to the method described in the J. Am. Chem. Soc. 1996, 118, 1949-1960, 72 ml of DMSO was placed in a round flask and subjected to $N_2$ gas substitution. 0.6 g of the XI Pt(dpbpy)$Cl_2$ was placed therein and dissolved by heating. 2ml of methanol was placed in a test reagent bottle, 0.3 g of KOH and 0.4 g of XII 3,4-toluene dithol were placed thereto and the resulting solution was stirred. This solution was dropped to the round flask. As a result, the solution changed into red, and immediately precipitate was produced. After stirring for about 20 minutes, the solution was left standing to cool. An excess of pure water was added to the cooled reaction system. A dark red precipitate was taken out by filtration, washed with pure water and diethyl ether repeatedly and vacuum dried (yield: about 45%).

XI

XII

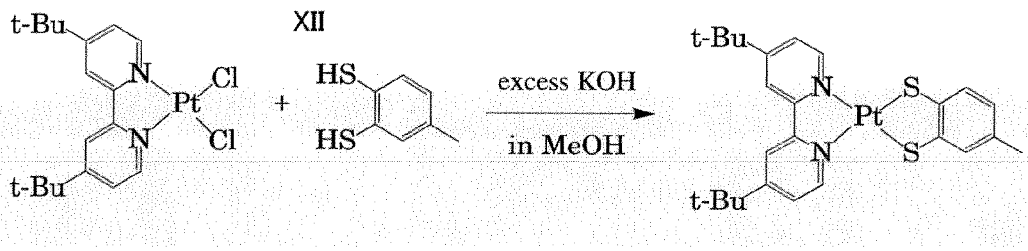


Obtained Pt(dpbpy)(tdt) had a strong photosensitivity in a solution state and was completely degraded when it was left under outside light.

In the same way as mentioned above, emission spectrum of these two kinds of organic platinum complexes as comparative experiments were measured and FIGS. 33 and 34 are graphs showing emission spectrum data as results of measurement.

Using 4 kinds out of thus-obtained 24 kinds of organic platinum complexes of the present invention, in addition, using 2 kinds of organic platinum complexes as comparative experiments, luminescence lifetime was measured. Specifically, these organic platinum complexes were each dispersed in polyvinyl carbazole so as to form a 4 % by mass solution and the solution was coated on a glass substrate by spin-coating. The substrate was subjected to a pre-baking treatment for 5 hours under normal pressure at 130˚C and the solvent was evaporated to thereby obtain a uniform thin film. Measurement was carried out using Streak Camera C5094 manufactured by Hamamatsu Photonics K.K. under nitrogen laser excitation (wavelength of 337nm). During measurement the influence of the air was removed by evacuating the sample room. Luminescence lifetime of the complex was calculated from the measured time-resolved spectrum according to the following equation (1).

$$\text{Log } I(t) = -t/\tau + \log I_0 \qquad (1)$$

(I(t): light-emitting intensity at the time of t, $I_0$: light-emitting intensity at the of t=0, $\tau$: luminescence lifetime)

Also, in order to estimate the degree of thermal deactivation, light-emitting intensity at normal temperature was compared with that of at low temperature. Samples were used as those used in the measurement of the luminescence lifetime without any treatment. The results are shown in Tables 5 and 6.

Table 5

| Complex | Pt(4dmbpy)(ecda) | Pt(dbbpy)(ecda) | Pt(4dmbpy)(qdt) | Pt(dbbpy)(qdt) |
|---|---|---|---|---|
| Molecular Formula | $C_{18}N_2S_2O_2H_{17}Pt$ | $C_{24}N_2S_2O_2H_{29}Pt$ | $C_{20}N_4S_2H_{16}Pt$ | $C_{26}N_4S_2H_{28}Pt$ |
| Molecular Weight | 566.26 | 650.36 | 571.27 | 655.37 |

(continued)

| Complex | Pt(4dmbpy)(ecda) | Pt(dbbpy)(ecda) | Pt(4dmbpy)(qdt) | Pt(dbbpy)(qdt) |
|---|---|---|---|---|
| Structure | 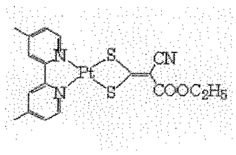 | 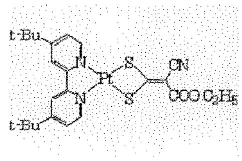 | 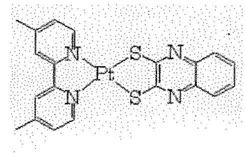 | 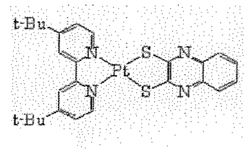 |
| r.t. Life Time | 0.13μs, 1.55μs | 0.27μs, 1.29μs | 0.10μs, 3.74μs | 0.49μs, 3.57μs |
| $I_{300K}/I_{6K}$ | 0.92 | 0.84 | 0.84 | 0.94 |
| PL Wave Length | 609nm | 576nm | 574nm | 579nm |

Table 6

| Complex | Pt(4dmbpy)(tdt) | Pt(dbbpy)(tdt) |
|---|---|---|
| Molecular Formula | $C_{19}N_2S_2H_{18}Pt$ | $C_{25}N_2S_2H_{30}Pt$ |
| Molecular Weight | 533.27 | 617.37 |
| Structure | 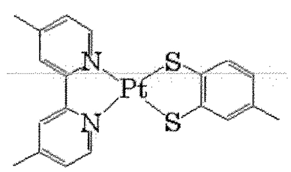 | 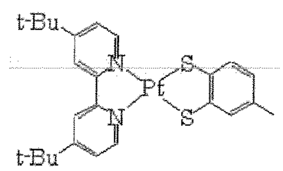 |
| r.t. Life Time | 0.13μs, 2.44μs | 0.16μs, 1.87μs |
| $I_{300K}/I_{6K}$ | 0.52 | 0.31 |
| PL Wave Length | 683nm | 700nm |

In the Tables 5 and 6, beginning at the top, each represents complex name, molecular formula, molecular weight, molecular structure, photoexcited luminescence decay time at room temperature (two components), ratio of luminescence intensity at room temperature and luminescence intensity at 6K, and peak wavelength of the PL spectrum measured by photoexcitation. Two values are described because the luminescence decay curve of this platinum complex was two-component system. The former value represents the decay time of the first component and the latter represents the decay time of the second component.

As is obvious from the result of Table 5, it is found that the luminescence lifetime dose not differs greatly depending on the complex ligand and the value is 5 μs or less which is extremely short decay time for phosphorescence luminescence. This shows that these complexes are suitable as a luminescent material of the organic EL element. Further, the ratio of luminescence intensity at room temperature and luminescence intensity at 6K indicate the relative value of luminescence intensity at room temperature when the intensity at 6K is set to "1" (It is considered that the closer to 1 the value is, the smaller the thermal deactivation is). All values indicated 0.8 or more and it is found that the thermal inactivation is extremely small.

On the contrary, in the case of the complexes for comparison, it is found that the luminescence lifetime dose not differ greatly depending on the complex ligand and the value is 5 μs or less which is extremely short for phosphorescence luminescence, however, the values of the ratio of luminescence intensity at room temperature and luminescence intensity at 6K were 0.5 and 0.3, respectively, which are small and thermal inactivation is large.

(Example 19)

A glass substrate with ITO (sheet resistance 10 ohms per square) film was used as an element substrate. The substrate was subjected to ultrasonic cleaning sequentially with pure water, acetone and IPA each for 15 minutes and to an UV ozone treatment. A positive hole transport layer and light-emitting layer was formed as a film using SPINCOATER 1H-d3 manufactured by MIKASA Co. by spin-coating. Deposition was carried out, in both cases of a positive hole

transport layer (PEDOT) and light-emitting layer (PVK + PBD + Pt complex), under the condition of 1st: 1000rpm, 10s, 2nd: 2500rpm, 60s, and baking was performed for 10 hours at 150˚C and for 2 hours at 120˚C, respectively, to remove an organic solvent. At the time of coating light-emitting layer, the solution is passed through 0.2 μm of filter to thereby remove undissolved organic material and solid impurities. Baking was performed using TYO-300 manufactured by Pasolina under normal pressure and in the atmosphere. A positive hole blocking layer and negative electrode were formed as a film using vacuum evaporator which is heat resistance type. At the time of forming the positive hole blocking layer, deposition was performed under the condition of: degree of vacuum: $10^{-4}$ Pa and depositing speed: 0.1 to 0.2 nm/s, and at the time of forming the negative electrode, under the condition of: degree of vacuum: $10^{-4}$ Pa and depositing speed: 1 to 2 nm/s. After vapor-deposition of a negative electrode, element was exposed to the atmosphere carried in a glove box under nitrogen and a glass plate was bonded with the substrate with two component epoxy adhesives (araldite) to be sealed. Light-emitting part area of the manufactured element was 2 times 2 $mm^2$ and the layer composition of the organic element was as follows:

glass/ITO/PEDOT (100nm)/ light-emitting layer (PVK + PBD +Pt complex) (50m)/BCP (20nm) / AlLi (100nm)

Properties of manufactured organic EL element are shown in the tables 7 and 8. In these tables, luminance shows the values when 12V was applied and element lifetime shows half-brightness time when element was driven at constant current from an initial luminance of 100 $cd/m^2$.

Table 7

| Complex | Luminance ($cd/m^2$) | Life (hour) |
|---|---|---|
| Pt(4dmbpy)(ecda) | 2168 | 330 |
| Pt(dbbpy)(ecda) | 2615 | 300 |
| Pt(4dmbpy)(qdt) | 5295 | 500 |
| Pt(dbbpy)(qdt) | 6365 | 510 |

Table 8

| Complex | Luminance ($cd/m^2$) | Life (hour) |
|---|---|---|
| Pt(4dmbpy)(tdt) | 394 | 50 |
| Pt(dbbpy)(tdt) | 104 | 20 |

(Example 20)

Pt(2,2'-bipyridine)(1,1-dicyano-2,2-dithio-ethylene) complex (PT-001) was synthesized as follows. Specifically, to 15ml of acetone, 0.422 g of compound I synthesized according to the method described in the J. Am. Chem. Soc. 1990, 112, 5625-5627 & J. Chem. Soy. Dalton Trans. 1978, 11227 was dissolved. To 10 ml of methanol, 0.218 g of compound II synthesized according to the method described in the Acta. Chem. Scand. 22, 1968, 1107-1123-1128 was dissolved and was dropped. As a result, an orange precipitate was produced. Centrifugation was performed and organometallic complex was allowed to precipitate and filtrated. This was washed with acetone, ethanol and diethyl ether, and is vacuum dried (refer to Coord. Chem. Rev. 97, 1990, 47-64).

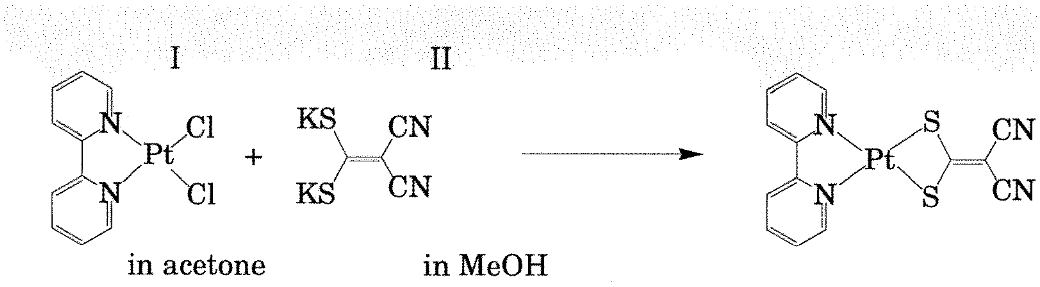


Moreover, in the same way as mentioned above, organometallic (organic platinum) complexes (phosphorescent material) was synthesized (PT-002 to PT-007).

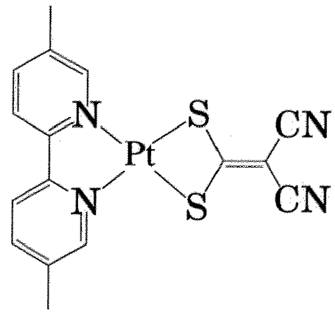

PT-002

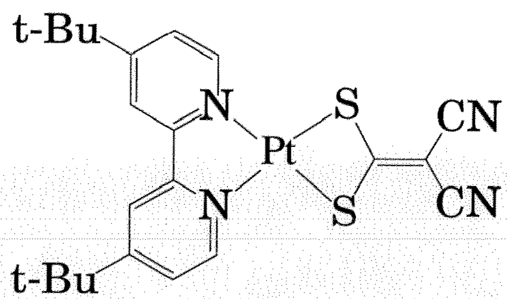

PT-003

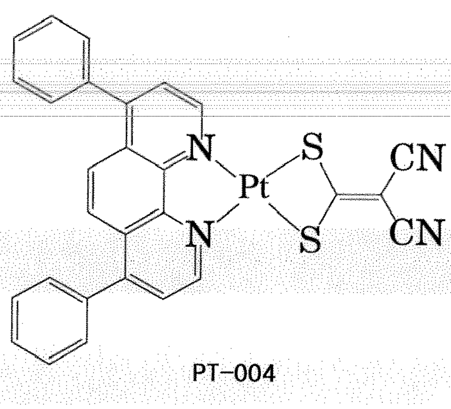

PT-004

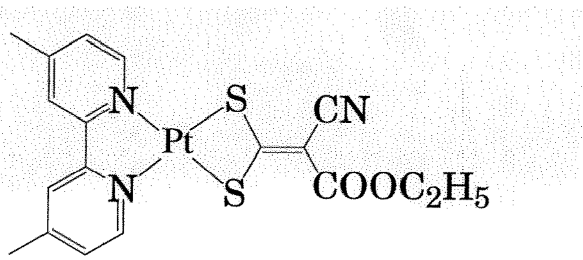

PT-005

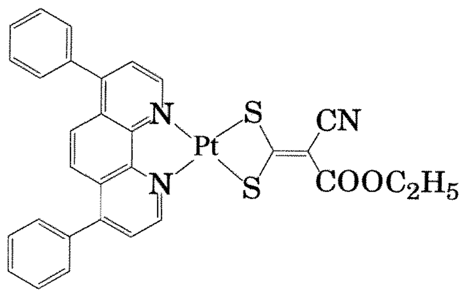

PT-006

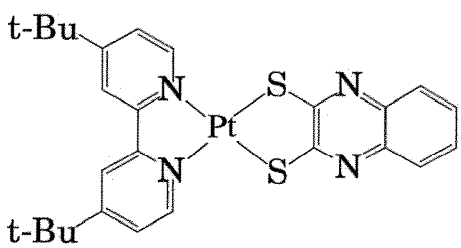

PT-007

In the following, emission wavelength of the synthesized organic platinum complexes (PT-001 to PT-007) in powder form is shown in Table 9. The wavelength shows peak wavelength of emission spectrum observed after irradiating 365nm of excitation light.

Table 9

| Complex name | Emission wavelength (nm) |
|---|---|
| PT-001 | 647nm |
| PT-002 | 599nm |
| PT-003 | 682nm |
| PT-004 | 630mn |
| PT-005 | 665nm |
| PT-006 | 600nm |
| PT-007 | 650nm |

Next, color conversion layers were manufactured in which synthesized organic platinum complexes were used and when 400nm, 450nm and 500sm of light was color-converted, emission corresponding to the value of Table 9 was observed from each color conversion layer with high conversion efficiency. Also, resistance to light when exposed to

the light for 1000 hours was deterioration by 1% or less based on the conversion efficiency before exposure. Thus, the results were extremely satisfactory. Further, since the thickness of the color conversion layer became half or less than that of the color conversion layer in which a fluorescent dye is used, an organic EL element using this was manufactured. In this organic EL element exudates decreased from the color conversion layer and non-luminescence of the element was reduced as a result, the lifetime of the element improved.

(Example 21)

12.5 g of $Re(CO)_5Cl$ and 1.5 g of benzo[h]quinoline were added to toluene deaerated with argon, stirred and refluxed. Toluene was evaporated and to the remaining mixture, heated hexane was added to thereby extract objective substance. The obtained yellow crude product was recrystallized several times with hexane, and thus unreacted benzoquinoline was removed. An organic rhenium complex as an objective substance was obtained by mass spectroscopy (refer to Peter Spellane, and Richard J. Watts, Inorg. Chem.32 (1993) 5633).

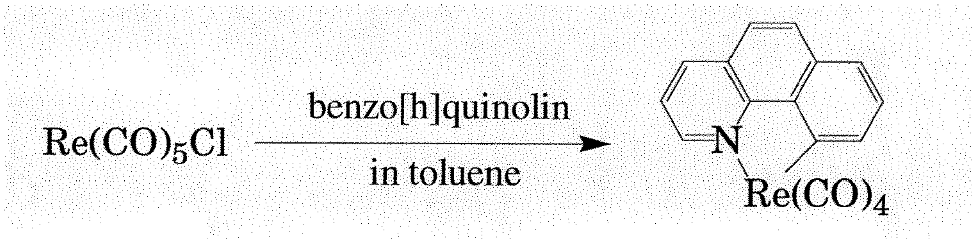


Moreover, in the same way as mentioned above, organic rhenium complexes (phosphorescent material) was synthesized (RE-002 to 004).

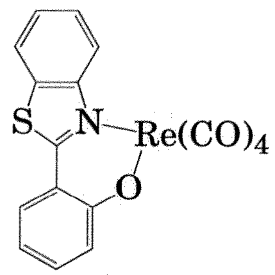

RE−002

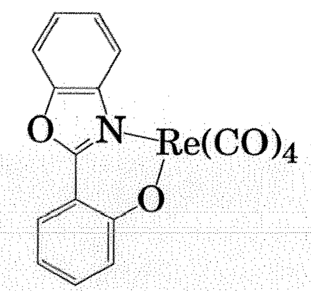

RE−003

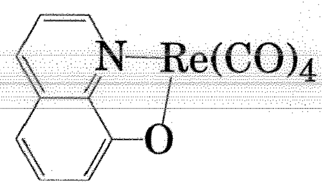

RE-004

In the following, the emission wavelength of the synthesized organic rhenium complexes (RE-001 to 004) in powder form is shown in Table 10. The wavelength shows the peak wavelength of the emission spectrum observed after irradiating 365nm of excitation light.

Table 10

| Complex name | Emission wavelength (nm) |
|---|---|
| RE-001 | 615 nm |
| RE-002 | 532 nm |
| RE-003 | 530 nm |
| RE-004 | 653 nm |

Next, color conversion layers were manufactured in which synthesized organic platinum complexes were used, in the same way as in Example 20, and when 400nm, 450nm and 500nm of light was color-converted, emission corresponding to the value of Table 10 was observed from each color conversion layer with high conversion efficiency. Also, resistance to light when exposed to the light for 1000 hours was deterioration by 1% or less based on the conversion efficiency before exposure. Thus, the results were extremely satisfactory. Further, since the thickness of the color conversion layer became half or less than that of the color conversion layer in which a fluorescent dye is used, an organic EL element using this was manufactured. In this organic EL element, exudates decreased from the color conversion layer and non-luminescence of the element was reduced, as a result, the lifetime of the element improved.

Herein, the preferred aspects of the present invention will be appended as follows.

(Aspect 1)

An organometallic complex comprising a rhenium (are) atom; one ligand which has a coordinated nitrogen atom and a coordinated oxygen atom, each coordinated with the rhenium (Re) atom, and has at least one $\pi$ conjugation part; and the other ligand coordinated with the rhenium (Re) atom in such a way that the ligand saturates the coordination number of the rhenium (Re) atom and the charge of the whole organometallic complex is neutral.

(Aspect 2)

An organometallic complex according to Aspect 1, wherein the nitrogen atom coordinated with the rhenium (Re) atom in the one ligand is a part of one ring structure, and the oxygen atom coordinated with the rhenium (Re) atom in the one ligand is bonded to a carbon atom which is a part of the other ring structure.

(Aspect 3)

An organometallic complex according to Aspect 2, wherein the one ring structure and the other ring structure are selected from 5-membered ring or 6-membered ring, and two of at least one carbon atom, each a member of either of the two ring structures, are bonded, one another or at least one carbon atom in either of two ring structures is shared one another.

(Aspect 4)

An organometallic complex according to once of Aspects 1 to 3, wherein there is an overlap between an electron

orbit of the one ligand and an electron orbit of the rhenium (Re) atom and electrons are capable of being transferred between them.

(Aspect 5)

An organometallic complex according to any one of Aspects 1 to 4, wherein the organometallic complex is represented by the following formula (1):

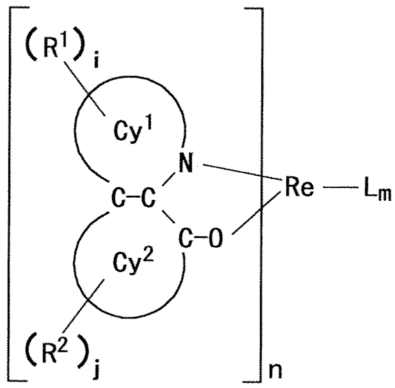

Formula (1)

In the formula (1), $R^1$ and $R^2$ may be the same or different, and each represent a hydrogen atom or a substituent group. "i" and "j" are integers. $Cy^1$ represents one ring structure containing a coordinated nitrogen atom which is coordinated with a rhenium (Re) atom, and two carbon atoms which are bonded to the nitrogen atom and are shared with $Cy^2$. $Cy^2$ represents the other ring structure which is bonded to the oxygen atom bonded to a rhenium (Re) atom and contains the two carbon atoms shared with $Cy^1$. "n" is 1, 2, or 3, representing a coordination number of the ligand coordinated with the rhenium (Re) atom bidentately, the one ligand comprising $Cy^1$ and $Cy^2$. The letter "L" represents the other ligands which saturates the coordination number of the rhenium (Re) atom, and neutralizes the charge of the whole complex. "m" represents an integer of 0 to 4.

(Aspect 6)

An organometallic complex according to any one of Aspects 1 to 4, wherein the organometallic complex is represented by the following formula (2):

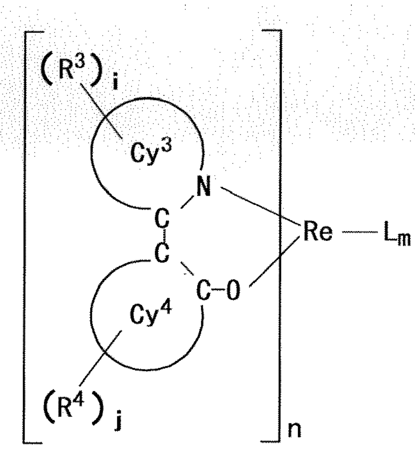

Formula (2)

In the formula (2), $R^3$ and $R^4$ may be the same or different, and each represent a hydrogen atom or a substituent group. "i" and "j" are integers. $Cy^3$ represents one ring structure containing a coordinated nitrogen atom which is coordinated with a rhenium (Re) atom, and a carbon atom which is bonded to the nitrogen atom and to a carbon atom in

$Cy^4$. $Cy^4$ represents the other ring structure containing a carbon atom which is bonded to the oxygen atom bonded to a rhenium (Re) atom and a carbon atom which is bonded to a carbon atom in $Cy^3$. "n" is 1, 2, or 3, representing a coordination number of the one ligand coordinated with the rhenium (Re) atom bidentately, the one ligand comprising $Cy^1$ and $Cy^2$. The letter "L" represents the other ligand which saturates the coordination number of the rhenium (Re) atom, and neutralizes the charge of the whole complex, "m" represents an integer of 0 to 4.

(Aspect 7)

An organometallic complex according to any one of Aspects 1 to 4, wherein the organometallic complex is represented by the following formula (3):

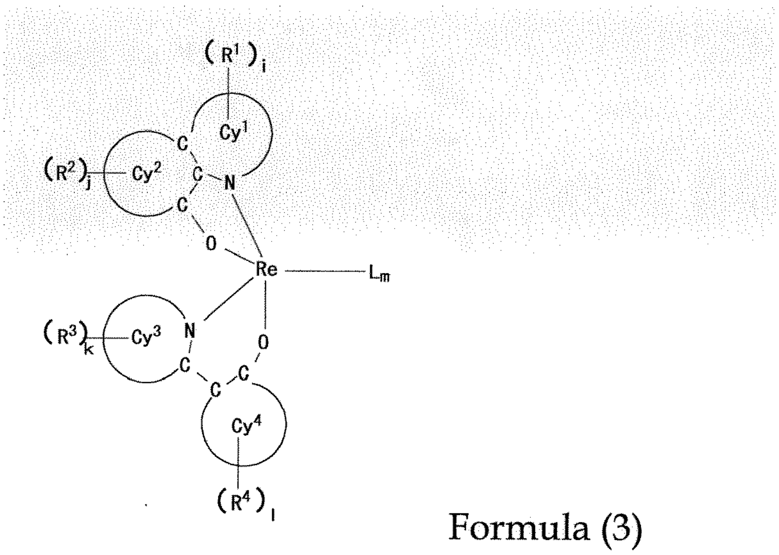

Formula (3)

In the formula (3), $R^1$ to $R^4$ may be the same or different, and each represent a hydrogen atom or a substituent group. "i", "j", "k" and "1" are integers. $Cy^1$ represents one ring structure containing a coordinated nitrogen atom which is coordinated with a rhenium (Re) atom, and two carbon atoms which are bonded to the nitrogen atom and are shared with $Cy^2$. $Cy^2$ represents the other ring structure which is bonded to the oxygen atom bonded to a rhenium (Re) atom and contains the two carbon atoms shared with $Cy^1$. $Cy^3$ represents one ring structure containing a coordinated nitrogen atom which is coordinated with a rhenium (Re) atom, and a carbon atom which is bonded to the nitrogen atom and to a carbon atom in $Cy^4$. $Cy^4$ represents the other ring structure containing a carbon atom which is bonded to the oxygen atom bonded to a rhenium (Re) atom and a carbon atom which is bonded to a carbon atom in $Cy^3$. The letter "L" represents the other ligand which satu-rates the coordination number of the rhenium (Re) atom, and neutralizes the charge of the whole complex, "m" represent 1 or 2.

(Aspect 8)

An organometallic complex according to any one of Aspects 1 to 5, wherein the organic rhenium complex is represented by the following formula (4):

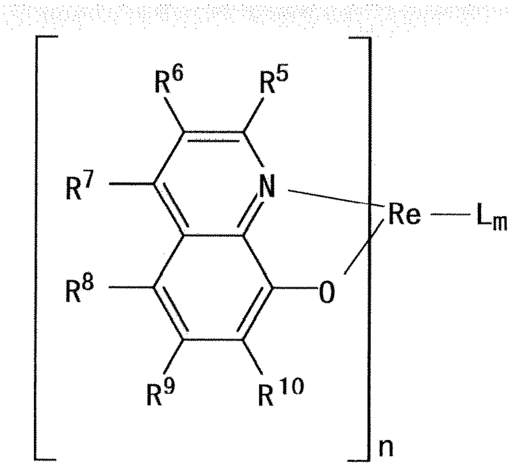

Formula (4)

In the formula (4), $R^5$ to $R^{10}$ may be the same or different, and represent a hydrogen atom or substituent group. "n" represents a coordination number. The letter "L" represents the other ligand which saturates the coordination number of the rhenium (Re) atom, and neutralizes the charge of the whole complex. "m" represents an integer of 0 to 4.

(Aspect 9)

An organometallic complex according to any one of Aspects 1 to 8, wherein the other ligand is selected from a halogen atom, a carbonyl group, a cyano group, a hydroxyalkyl group, a phenylisocyanide group, a pyridine group, an acetylacetonato group, a 2, 2'-bipyridyl group, 1, 10-phenanthroline group, a cyclometalate and ligand group and a triphenylphosphine group.

(Aspect 10)

An organometallic complex comprising a rhenium (Re) atom; one ligand which has a coordinated nitrogen atom and a coordinated carbon atom, each coordinated with the rhenium (Re) atom, and has at least once π conjugation part; and the other ligand coordinated with the rhenium (Re) atom in such a way that the ligand saturates the coordination number of the rhenium (Re) atom and the charge of the whole organometallic complex is neutral.

(Aspect 11)

An organometallic complex according to Aspect 10, wherein the nitrogen atom coordinated with the rhenium (Re) atom in the one ligand is a part of one ring structure, and the carbon atom coordinated with the rhenium (Re) atom in the one ligand is a part of the other ring structure.

(Aspect 12)

An organometallic complex according to Aspect 11, wherein the one ring structure and the other ring structure are selected from 5-membered ring or 6-membered ring, and two of at least one carbon atom, each a member of either of the two ring structures, are bonded one another or at least one carbon atom in either of two ring structures is shared one another.

(Aspect 13)

An organometallic complex according to any one of Aspects 10 to 12, wherein there is an overlap between an electron orbit of the one ligand and an electron orbit of the rhenium (Re) atom and electrons are capable of being transferred between them.

(Aspect 14)

An organometallic complex according to any one of Aspects 10 to 13, wherein the organometallic complex is represented by the following formula (8):

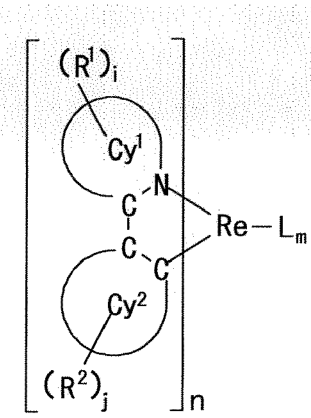

Formula (8)

In the formula (8), $R^1$ and $R^2$ may be the same or different, and each represent a hydrogen atom or a substituent group. "i" and "j" are integers. $Cy^1$ represents one ring structure having a coordinated nitrogen atom which is coordinated with a rhenium (Re) atom, and a carbon atom which is bonded to a carbon atom in $Cy^2$. $Cy^2$ represents the other ring structure having a coordinated carbon atom which is bonded to a rhenium (Re) atom, and a carbon atom which is bonded to is bonded to the carbon atom a carbon atom in $Cy^1$. "n" is 1, 2, or 3, representing a coordination number of the one ligand coordinated with the rhenium (Re) atom bidentately, the one ligand comprising $Cy^1$ and $Cy^2$. The "L" represents the other ligand which saturates the coordination number of the rhenium (Re) atom, and neutralizes the charge of the whole complex. "m" represents an integer of 0 to 4.

(Aspect 15)

An organometallic complex according to any one of Aspects 10 to 13, wherein the organometallic complex is represented by the following formula (9) and the one ligand contains 7,8-benzoquinoline skeleton:

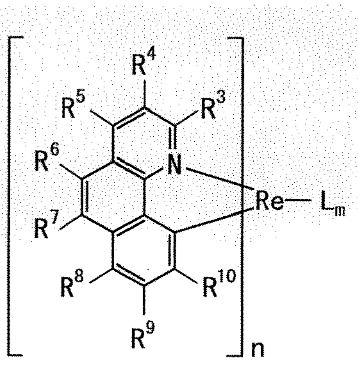

Formula (9)

In the formula (9), $R^3$ to $R^{10}$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom. "n" represents an integer of 1 to 3. The letter 'L" represents the other ligand which saturates the coordination number of the rhenium (Re) atom, and neutralizes the charge of the whole complex. "m" represents an integer of 0 to 4.

(Aspect 16)

An organometallic complex according to any one of Aspects 10 to 13, wherein the organometallic complex is represented by the following formula (10) and the one ligand contains 2-phenylpyridine skeleton:

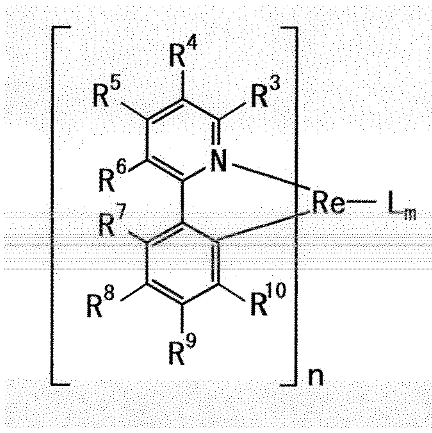

Formula (10)

In the formula (10), $R^3$ to $R^{10}$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom. "'n" represents an integer of 1 to 3. The letter "L" represents the other ligand which saturates the coordination number of the rhenium (Re) atom, and neutralizes the charge of the whole complex. "m" represents an integer of 0 to 4.

(Aspect 17)

An organometallic complex according to any one of Aspects 10 to 13, wherein the organometallic complex is represented by the following formula (11) and the one ligand contains 2-phenyloxazoline skeleton:

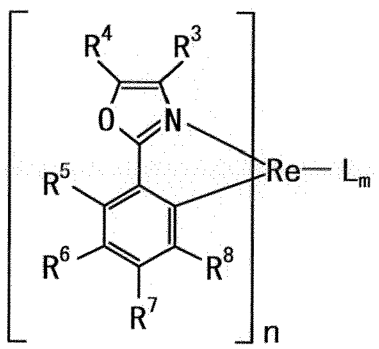

Formula (11)

In the formula (11), $R^3$ to $R^8$ may be the same or different, each representing a hydrogen atom or a substituent group which may optionally be substituted, wherein an adjacent pair thereof may join together to form an aromatic ring which contains one of a nitrogen atom sulphur atom and an oxygen atom. "'n" represents an integer of 1 to 3. The letter "L" represents the other ligand which saturates the coordination number of the rhenium (Re) atom, and neutralizes the charge of the whole complex, "m" represents an integer of 0 to 4.

(Aspect 18)

An organometallic complex according to any one of Aspects 10 to 13, wherein the organometallic complex is represented by the following formula (12) and the one ligand contains 2-phenylthiozoline skeleton:

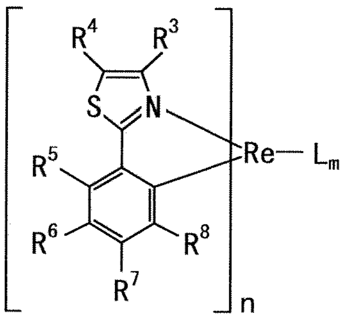

Formula (12)

In the formula (12), $R^3$ to $R^8$ may be the same or different each representing a hydrogen atom or a substituent group which may optionally be substituted, wherein an adjacent pair thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole complex. "m" represents an integer of 0 to 4.

(Aspect 19)

An organometallic complex according to any one of Aspects 10 to 13, wherein the organometallic complex is represented by the following formula (13) and the one ligand contains 2-(2'-thienyl)pyridine skeleton:

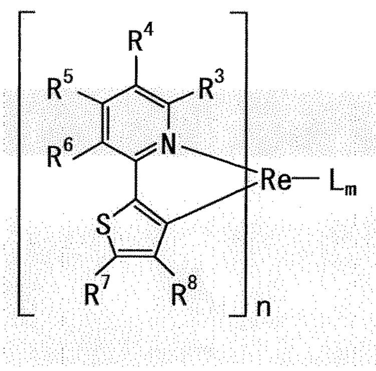

Formula (13)

In the formula (13), $R^3$ to $R^8$ may be the same or different, each representing a hydrogen atom or a substituent group which may optionnally be substituted, wherein an adjacent pair thereof may join together to form an aromatic ring which contains one of a nitrogen atom, a sulphur atom and a oxygen atom. "n" represents an integer of 1 to 3. The lettre "L" represents the other ligand which saturates the coordination number of the rhenium (Re) atom, and neutralizes the charge of the whole complex. "m" represents an integer of 0 to 4.

(Aspect 20)

An organometallic complex according to any one of Aspects 10 to 13, wherein the organometallic complex is represented by the following formula (14) and the one ligand contains 2-(2'-thienyl)thiozoline skeleton:

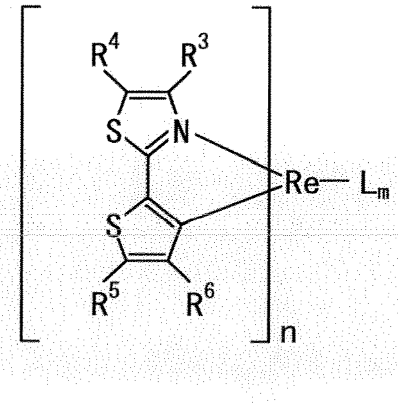

Formula (14)

In the formula (14), $R^3$ to $R^8$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom. "n" represents an integer of 1 to 3. The letter "L" represents the other ligand which saturates the coordination number of the rhenium (Re) atom, and neutralizes the charge of the whole complex. "m" represents an integer of 0 to 4.

(Aspect 21)

An organometallic complex according to any one of Aspects 10 to 13, wherein the organometallic complex is represented by the following formula (15) and the one ligand contains 3-(2'-thiozolyl)-2H-pyran-2-one skeleton:

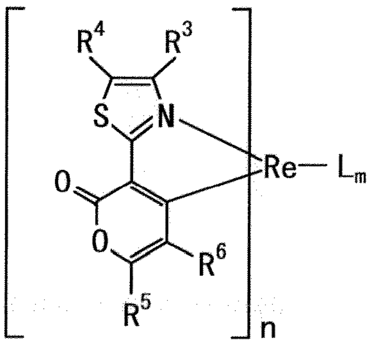

Formula (15)

In the formula (15), $R^3$ to $R^6$ may be the same or different, each representing a hydrogen atom or a substituent group which may optionally be substituted, wherein an adjacent pair thereof may join together to form an aromatic ring which contains one of a nitrogen atoms, a sulphur atom and an oxygen atom. "n" represents an integer of 1 to 3. The letter "L" represents the other ligand which saturates the coordination number of the rhenium (Re) atom, and neutralizes the charge of the whole complex. "m" represents an integer of 0 to 4.

(Aspect 22)

An organometallic complex according to any one of Aspects 10 to 13, wherein the organometallic complex is a Re(CO)4(7,8-benzoquinoline) complex represented by the formula (16):

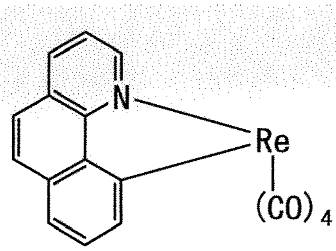

Formula (16)

(Aspect 23)

An organometallic complex according to any one of Aspects 10 to 22, wherein the other ligand is selected from a halogen atom, a carbonyl group, a cyano group, a hydroxyalkyl group, a phenylisocyanide group, a pyridine group, an acetylacetonato group, a 2,2'-bipyridyl group, a 1,10-phenanthroline group, a cyclometalate and ligand group and a triphenylphosphine group.

(Aspect 24)

An organometallic complex comprising at least one of Group 8 metal atoms selected from Group 8 metal element; one ligand which contains at least one π conjugation part and is coordinated with the Group 8 metal atom; and a dithiolate ligand which is selected from an aliphatic dithiolate ligand and a heteroaromatic dithiolate ligand, and is coordinated with the Group 8 metal atom.

(Aspect 25)

An organometallic complex according to Aspect 24, wherein the other ligand is coordinated with the Group 8 metal atom in such as way that the ligand saturates the coordination number of the Group 8 metal atom and the charge of the whole organometallic complex is neutral.

(Aspect 26)

An organometallic complex according to one of Aspects 24 and 25, wherein the dithiolate ligand is represented by the following formula:

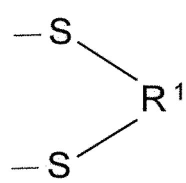

dithiolate ligand

In the formula, $R^1$ represents a divalent aliphatic organic group or a divalent heteroaromatic organic group.

(Aspect 27)

An organometallic complex according to any one of Aspects 24 to 26, wherein the organometallic complex is represented by the following formula (17):

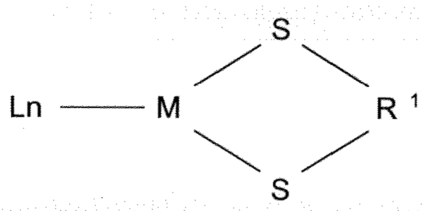

Formula (17)

In the formula (17), "M" reresents a Group 8 metal atom. The letter "L" represents a ligand which is coordinated with the Group 8 metal atom one of unidentately and bidentately or more and comprises at least one $\pi$ conjugation part. "n" represents an integer of 1 to 6. $R^1$ represents a divalent aliphatic organic group or a divalent heteroaromatic organic group.

(Aspect 28)

An organometallic complex according to any one of Aspects 24 to 27, wherein the one ligand comprises an aromatic ring and an atom capable of being coordinated with the Group 8 metal atom one of unidentately and bidentately or more, the atom being in a portion of the aromatic ring, and wherein the atom is one selected from a nitrogen atom, oxygen atom, sulfur atom, selenium atom, tellurium atom and polonium atom and phosphorus atom.

(Aspect 29)

An organic EL element according to one Aspects 24 and 28, wherein the one ligand is represented by any one of the following formulae:

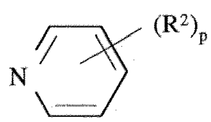

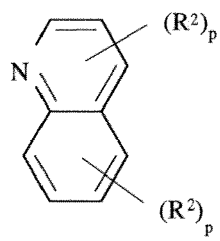

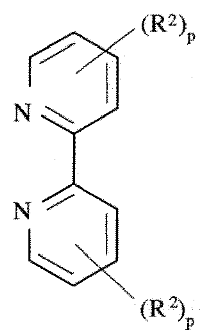

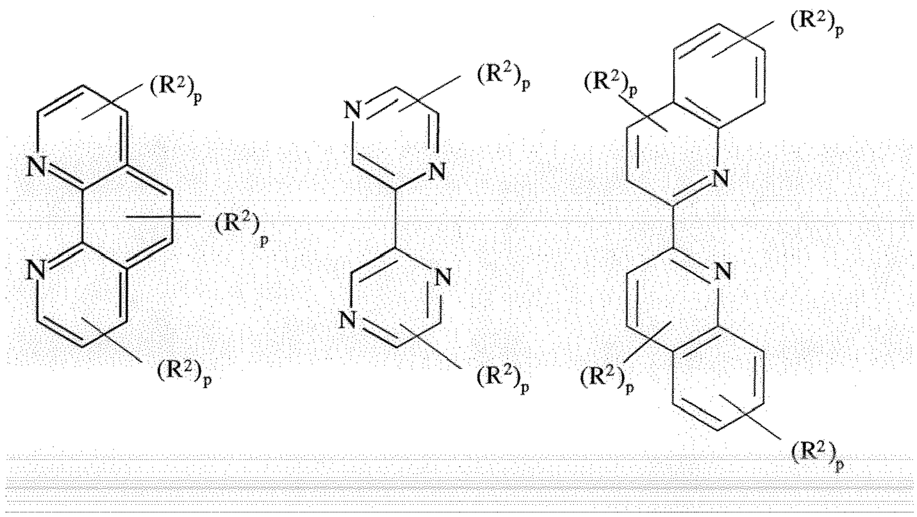

In the formula (18), "M" represents a Group 8 metal atom. A ligand which is bonded to the M and contains a nitrogen atom, represents a ligand comprising at least one π conjugation part and is coordinated with the M one of unidentately and bidentately or more. In the ligand comprising at least one π conjugation part, $R^3$ represents a hydrogen atom, a halogen atom, a cyano group, an alkoxy group, an amino group, an alkyl group, an alkyl acetate group, a cycloalkyl group, a nitrogen atom, an aryl group, or an aryloxy group, these themselves may be substituted with substituent groups, and "q" represents an integer of 0 to 8. "n" represents an integer of 1 to 4. A ligand which is bonded to the M and contains a sulfur atom represents a dithiolate ligand selected from an aliphatic dithiolate ligand and heteroaromatic dithiolate ligand. In the dithiolate ligand, $R^1$ represents a divalent aliphatic organic group or divalent heteroaromatic organic group.

(Aspect 31)

An organometallic complex according to any one of Aspects 24 to 29, wherein the organometallic complex is represented by the following formula (19):

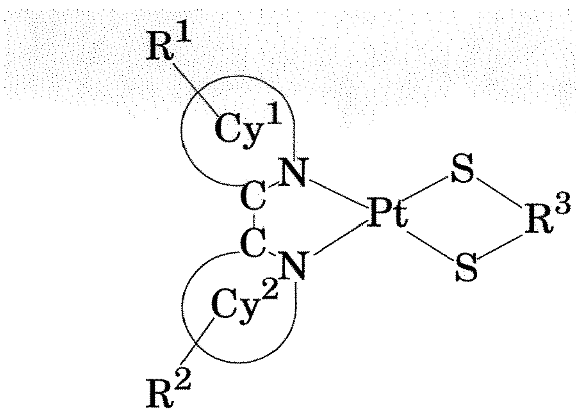

Formula (19)

In the formula (19), $R^1$ and $R^2$ may be the same or different, and each represent a hydrogen atom or a substituent group. $Cy^1$ represents one ring structure having a coordinated nitrogen atom which is coordinated with a platinum (Pt) atom, and a carbon atom which is bonded to a carbon atom in $Cy^2$. $Cy^2$ represents the other ring structure having a coordinated carbon atom which is bonded to a platinum (Pt) atom, and a carbon atom which is bonded to is bonded to the carbon atom a carbon atom in $Cy^1$. A ligand which is bonded to the Pt and contains a sulfur atom represents a dithiolate ligand selected from an aliphatic dithiolate ligand and heteroaromatic dithiolate ligand. In the dithiolate ligand, $R^3$ represents a divalent aliphatic organic group or a divalent heteroaromatic organic group.

(Aspect 32)

An organometallic complex according to any one of Aspects 24 to 31, wherein the heteroaromatic dithiolate ligand is an aromatic dithiolate ligand represented by any one of the following formulae (20) to (23):

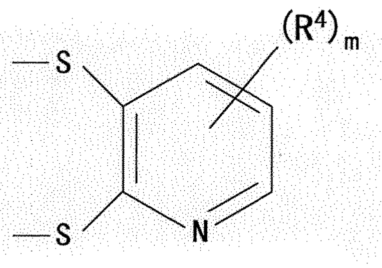

Formula (20)

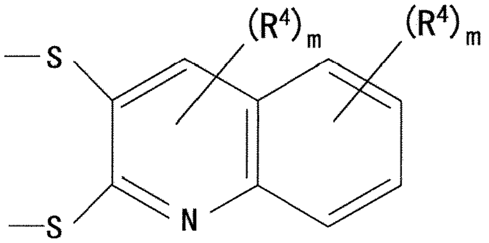

Formula (21)

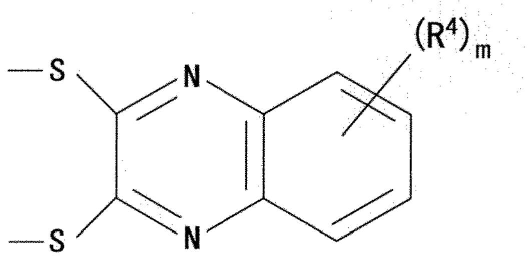

Formula (22)

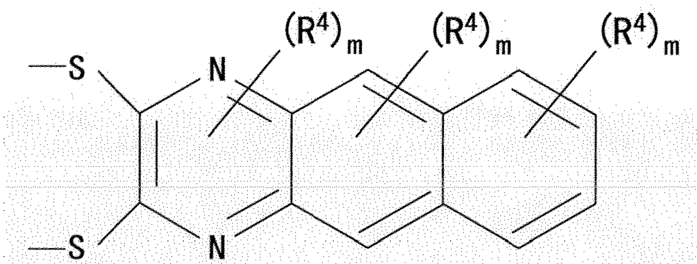

Formula (23)

In the formulae (3) to (6), $R^4$ represents a halogen atom, a cyano group, an alkoxy group, an amino group, an alkyl group, an alkyl acetate group, a cycloalkyl group, a nitrogen atom, an aryl group, or an aryloxy group, and these themselves may be substituted with substituent groups. "m" represents an integer of 0 to 5.

(Aspect 33)

An organometallic complex according to any one of Aspects 24 to 31, wherein the aliphatic dithiolate ligand is an aliphatic dithiolate ligand represented by any one of the following formulae (24) and (25):

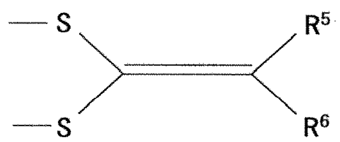

Formula (24)

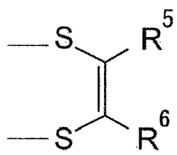

Formula (25)

In the formulae (24) and (25), $R^5$ and $R^6$ may be the same or different, represents a hydrogen atom, a halogen atom, a cyano group, an alkoxy group, an amino group, an alkyl group, an alkyl acetate group, a cycloalkyl group, a nitrogen atom, an aryl group, or an aryloxy group, and these themselves may be substituted with substituent groups.

(Aspect 34)

An organometallic complex according to any one of Aspects 24 to 30, wherein the organometallic complex is represented by the following formula (26):

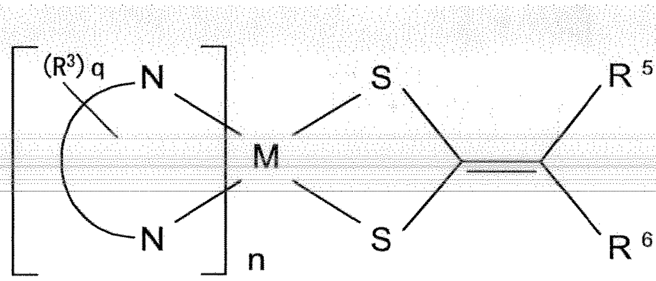

Formula (26)

In the formula (26), "M" represents a Group 8 metal atom. A ligand which is bonded to the M and contains a nitrogen atom, represents a ligand comprising at least one $\pi$ conjugation part and is coordinated with the M one of unidentately and bidentately or more. In the ligand comprising at least one $\pi$ conjugation part, $R^3$ represents a hydrogen atom, a halogen atom, a cyano group, an alkoxy group, an amino group, an alkyl group, an alkyl acetate group, a cycloalkyl group, a nitrogen atom, an aryl group, or an aryloxy group, these themselves may be substituted with substituent groups, and "q" represents an integer of 0 to 8. "n" represents an integer of 1 to 4. A ligand which is bonded to the M and contains a sulfur atom represents an aliphatic dithiolate ligand. In the aliphatic dithiolate ligand, $R^5$ and $R^6$ may be the same or different, represent a hydrogen atom, a halogen atom, a cyano group, an alkoxy group, an amino group,

an alkyl group, an alkyl acetate group, a cycloalkyl group, a nitrogen atom, an aryl group, or an aryloxy group, and these themselves may be substituted with substituent groups.

(Aspect 35)

An organometallic complex according to any one of Aspects 24 to 30, wherein the organometallic complex is represented by the following formula (27):

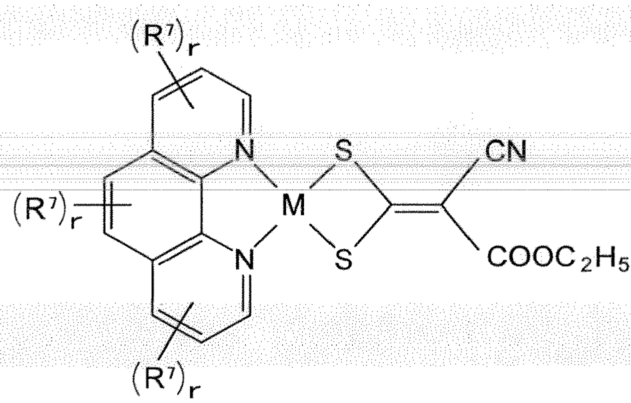

Formula (27)

In the formula (27), "M" represents a Group 8 metal atom. $R^7$ may be the same or different, represents a hydrogen atom, a halogen atom, a cyano group, an alkoxy group, an amino group, an alkyl group, an alkyl acetate group, a cycloalkyl group, a nitrogen atom, an aryl group, or an aryloxy group, and these themselves may be substituted with substituent groups. "r" represents an integer of 0 to 5.

(Aspect 36)

An organometallic complex according to one of Aspects 24 and 35, wherein the Group 8 metal atom is selected from Fe, Co, Ni, Ru, Rh, Pd, Os, Ir, and Pt.

(Aspect 37)

An organometallic complex according to any one of Aspects 8 to 36, wherein the Group 8 metal atom is Pt.

(Aspect 38)

An organometallic complex according to any one of Aspects 24 to 30, wherein the organometallic complex is represented by any one of the following formulae (28), (37) and (54):

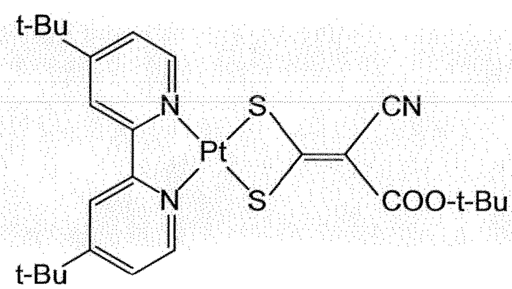

Formula (28)

In the formula (28), t-Bu represents a tert-butyl group.

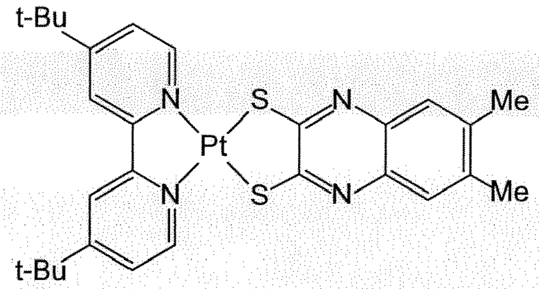

Formula (37)

In the formula (37), t-Bu represents a tert-butyl group. Me represents a methyl group.

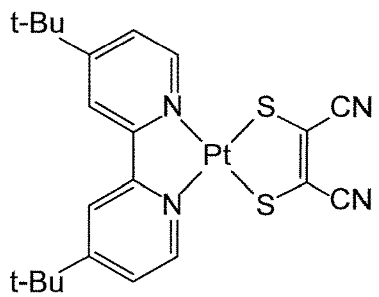

Formula (54)

In the formula (37), t-Bu represents a tert-butyl group.

(Aspect 39)

An organometallic complex according to any one of Aspects 1 to 38, which is used as at least one of luminescent material and color conversion material in an organic EL element.

(Aspect 40)

An organometallic complex according to any one of Aspects 1 to 39, which is used for lighting units.

(Aspect 41)

An organic EL element comprising: a positive electrode; a negative electrode; and an organic thin film layer disposed between the positive electrode and the negative electrode, wherein the organic thin film layer comprises the organometallic complex according to any one of Aspects 1 to 38.

(Aspect 42)

An organic EL element according to Aspect 41, wherein the organic thin film layer comprises a light-emitting layer disposed between a positive hole transport layer and an electron transport layer, wherein the light-emitting layer comprises the organometallic complex as a luminescent material.

(Aspect 44)

An organic EL element according to one of Aspects 42 and 43, wherein the light-emitting layer contains an aromatic amine derivative represented by the following formula (56):

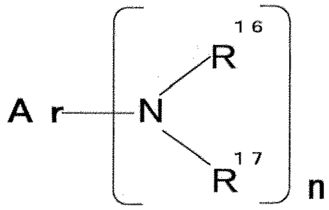

Formula (56)

In the formula (56), "n" represents an integer of 2 or 3. Ar represents a divalent or trivalent aromatic group, or heterocyclic aromatic group. $R^{16}$ and $R^{17}$ may be the or different and each represent a monovalent group or heterocyclic aromatic group.

(Aspect 45)

An organic EL element according to one of Aspects 42 and 44, wherein the light-emitting layer contains a carbazole derivative represented by the following formula (58):

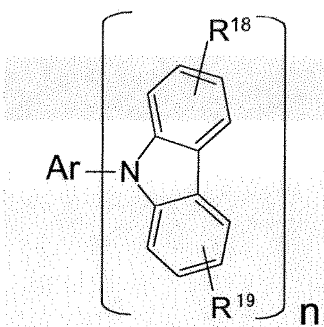

Formula (58)

In the formula (58), Ar is a divalent or trivalent group containing an aromatic ring or a divalent or trivalent group containing a heterocyclic aromatic ring. $R^{18}$ and $R^{19}$ each independently represent a hydrogen atom, a halogen atom, an alkyl group, an aralkyl group, an alkenyl group, an aryl group, a cyano group, an amino group, an acyl group, an alkoxy carbonyl group, a carboxyl group, an alkoxy group, an alkyl sulfonyl group, a hydroxyl group, an amide group, an aryloxy group, an aromatic hydrocarbon ring or an aromatic heterocyclic group, and these may be further substituted by substituents. "n" represents an integer of 2 or 3.

(Aspect 46)

An organic EL element according to one of Aspects 42 and 45, wherein the light-emitting layer contains an oxine complexe derivative represented by the following formula (60):

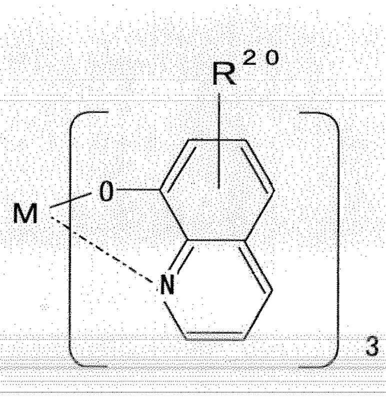

Formula (60)

M represents a metal atom. $R^{20}$ represents a hydrogen atom, a halogen atom, an alkyl group, an aralkyl group, an alkenyl group, an aryl group, a cyano group, an amino group, an acyl group, an alkoxy carbonyl group, a carboxyl group, an alkoxy group, an alkyl sulfonyl group, a hydroxyl group, an amide group, an aryloxy group, an aromatic hydrocarbon ring or an aromatic heterocyclic group, and these may be further substituted by substituents.

(Aspect 47)

An organic EL element according to one of Aspects 42 and 46, wherein the an electron transport material contained in an electron transport layer is 2,9-dimethyl-4,7-diphenyl-1,10-phenanthroline (BCP) represented by the following formula (68):

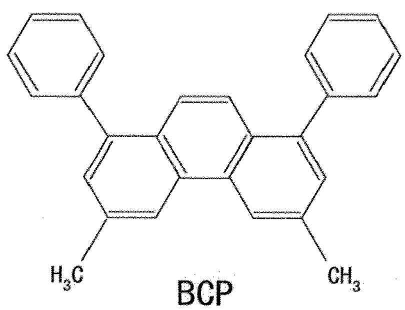

BCP

Formula (68)

(Aspect 48)

An organometallic complex according to any one of Aspects 41 to 47, which is for red light emission.

(Aspect 49)

An organic EL element according to any one of Aspects 41 to 48, further comprising a color conversion layer, wherein the color conversion layer is of converting incident light into light having a wavelength longer than the wavelength thereof by 100 nm or more.

(Aspect 50)

An organic EL element according to Aspect 49, wherein the color conversion layer is capable of converting incident light into light having a wavelength longer than the wavelength thereof by 150 nm or more.

(Aspect 51)

An organic EL element according to any one of Aspects 49 and 50, wherein the color conversion layer is capable of converting light in the wavelength range of ultraviolet light to blue light into red light.

(Aspect 52)

An organic EL element according to any one of Aspects 49 and 50, wherein the color conversion layer is capable of emitting phosphorescence.

(Aspect 53)

An organic EL element according to any one of Aspects 49 to 51, wherein the color conversion layer contains a phosphorescent material as a color conversion material.

(Aspect 54)

An organic EL element according to Aspect 53, wherein the phosphorescent material is at least one selected from an organic rhenium complex and an organic platinum complex.

(Aspect 55)

An organic EL element according to any one of Aspects 49 to 54, the color conversion layer contains at least one selected from the organometallic complex according to any one of Aspects 1 to 38.

(Aspect 56)

An organic EL element, comprising at least a color conversion layer, wherein the color conversion layer is capable of converting incident light into light having a wavelength longer than the wavelength thereof by 100 nm or more.

(Aspect 57)

An organic EL element according to Aspect 56, wherein the color conversion layer is capable of converting incident light into light having a wavelength longer than the wavelength thereof by 150 nm or more.

(Aspect 58)

An organic EL element according to any one of Aspects 56 and 57, wherein the color conversion layer is capable of converting light in the wavelength range of ultraviolet light to blue light into red light.

(Aspect 59)

An organic EL element according to any one of Aspects 56 and 58, wherein the color conversion layer is capable of emitting phosphorescence.

(Aspect 60)

An organic EL element according to one of Aspects 56 and 59, wherein the color conversion layer contains a phosphorescent material, as a color conversion material.

(Aspect 61)

An organic EL element according to Aspect 60, wherein the phosphorescent material is at least one selected from an organic rhenium complex and an organic platinum complex.

(Aspect 62)

An organic EL element according to any one of Aspects 56 to 61, wherein the color conversion layer contains

at least one selected from the organometallic complex according to any one of Aspects 1 to 38.

(Aspect 63)

An organic EL display, which uses the organic EL element according to any one of Aspects 41 to 62.

(Aspect 64)

An organic EL display according to Aspect 63, which is one of a passive matrix panel and an active matrix panel.

(Aspect 65)

An organic EL display according to according to any one of

Aspects 63 and 64, comprising:

a pair of electrodes;
an organic thin film layer disposed between the pair of electrodes which is capable of emitting EL light; and
a color conversion layer,

wherein at least one of the pair of electrodes is transparent and at least one of the pair of electrodes corresponds to pixels, wherein the color conversion layer is arranged on at least a green pixel and a red pixel in the pixels.

(Aspect 66)

An organic EL display according to any one of Aspects 63 to 66, comprising:

a of electrodes;
an organic thin film layer disposed between the pair of electrodes which is capable of emitting EL light; and
a color conversion layer,

wherein at least one of the pair of electrodes is transparent and at least one of the pair of electrodes corresponds to pixels, wherein the color conversion layer is arranged on at least a green pixel and a red pixel in the pixels.

(Aspect 67)

An organic EL display according to Aspects 63 to 66, comprising:

a color conversion layer arranged on a blue pixel; and
a color conversion layer arranged on a red pixel,

wherein light-emitting light due to EL luminescence is white light,
wherein the color conversion layer arranged on a red pixel comprises at least one selected from the organometallic complexes according to any one of Aspects 1 to 38.

(Aspect 68)

An organic EL display according to Aspects 63 to 66, comprising:

a color conversion layer arranged on a red pixel; and

wherein light-emitting light due to EL luminescence is white light,
wherein the color conversion layer arranged on a red pixel comprises at least one selected from the organometallic complexes according to any one of Aspects 1 to 38.

(Aspect 69)

An organic EL display, comprising:

a pair of electrodes;
an organic thin film layer disposed between the pair of electrodes which is capable of emitting EL light; and
a color conversion layer,

wherein at least one of the pair of electrodes is transparent and at least one of the pair of electrodes corresponds to pixels,
wherein the color conversion layer is arranged on at least a green pixel and a red pixel in the pixels.

(Aspect 70)

An organic EL display according to Aspect 69, further comprising:

a color conversion layer arranged on a blue pixel; and

wherein light-emitting light due to EL luminescence is white light,
wherein the color conversion layer arranged on a red pixel comprises at least one selected from the organometallic complexes according to any one of Aspects 1 to 38.

(Aspect 71)

An organic EL display according to any one of Aspects 69 and 70, comprising:

a color conversion layer arranged on a red pixel; and

wherein light-emitting light due to EL luminescence is white light,
wherein the color conversion layer arranged on a red pixel comprises at least one selected from the organometallic complexes represented by any of aspects 1 to 38.

Industrial Applicability

The present invention, which can solve the conventional problems, provides an organometallic complex exhibiting phosphorescent luminescence suitable for use as a luminescent material, color conversion material, etc. in an organic EL element, an organic EL element having excellent lifetime, light-emitting efficiency, thermal and electrical stability, color conversion efficiency, etc., and a high performance, long lifetime organic EL display using the organometallic complex or the organic EL element, which organic EL display is suitable for a color display in which a constant average driving current can be achieved regardless of light-emitting pixels and color balance is satisfactory without changing light emitting area, etc.

The organometallic complex of the present invention exhibits phosphorescent luminescence and can be suitably used as a luminescent material, color conversion material, etc. in an organic EL element. Since the organic EL element of the present invention uses the organometallic complex, the organic EL element is excellent in lifetime, light emission efficiency, thermal and electrical stability, color conversion efficiency, etc., and can be suitably used for an organic EL display. Since the organic EL display of the present invention uses the organic EL element, the organic EL display has high performance and a long lifetime, and can be suitably used for display screens of televisions, mobile-phones, computers, etc.

## Claims

**1.** An organic EL element comprising:

a positive electrode;
a negative electrode; and
an organic thin film layer disposed between the positive electrode and the negative electrode,

wherein the organic thin film layer comprises an organometallic complex,
wherein the organometallic complex comprises a rhenium (Re) atom; one ligand which comprises a coordinated nitrogen atom and a coordinated carbon atom, each coordinated with the rhenium (Re) atom, and comprises at least one π conjugation part; and the other ligand coordinated with the rhenium (Re) atom in such a way that the ligand saturates the coordination number of the rhenium (Re) atom and the charge of the whole organometallic

complex is neutral.

2. An organic EL element according to claim 1, wherein the organometallic complex is represented by the following formula (8):

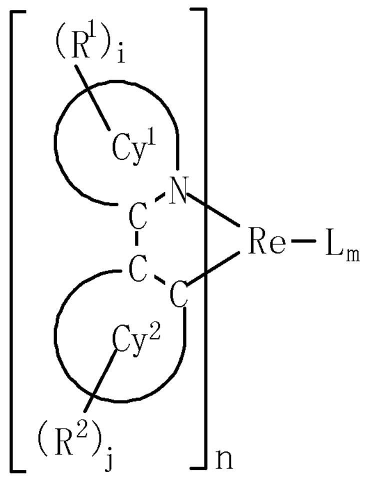

Formula (8)

wherein, in the formula (8), $R^1$ and $R^2$ may be the same or different, and each represent a hydrogen atom or a substituent group; "i" and "j" are integers; $Cy^1$ represents one ring structure having a coordinated nitrogen atom which is coordinated with a rhenium (Re) atom, and a carbon atom which is bonded to a carbon atom in $Cy^2$; $Cy^2$ represents the other ring structure having a coordinated carbon atom which is bonded to a rhenium (Re) atom, and a carbon atom which is bonded to is bonded to the carbon atom a carbon atom in $Cy^1$; "n" is 1, 2, or 3, representing a coordination number of the one ligand coordinated with the rhenium (Re) atom bidentately, the one ligand comprising $Cy^1$ and $Cy^2$; the letter "L" represents the other ligand which saturates the coordination number of the rhenium (Re) atom, and neutralizes the charge of the whole complex; and "m" represents an integer of 0 to 4.

3. An organic EL element according to claim 1, wherein the organometallic complex is represented by the following formula (9) and the one ligand comprises 7,8-benzoquinoline skeleton:

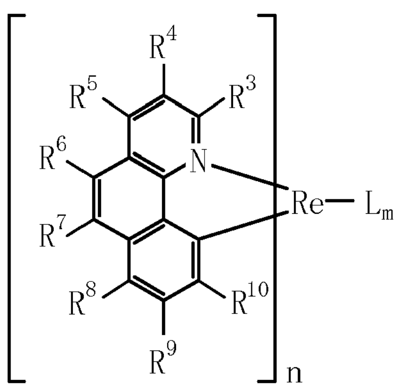

Formula (9)

wherein, in the formula (9), $R^3$ to $R^{10}$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom; "n" represents an integer of 1 to 3; the letter "L" represents the other ligand which saturates the coordination number of the rhenium (Re) atom, and neutralizes the charge of the whole complex; and "m" represents an integer of 0 to 4.

**4.** An organic EL element according to claim 1, wherein the organometallic complex is represented by the following formula (10) and the one ligand comprises 2-phenylpyridine skeleton:

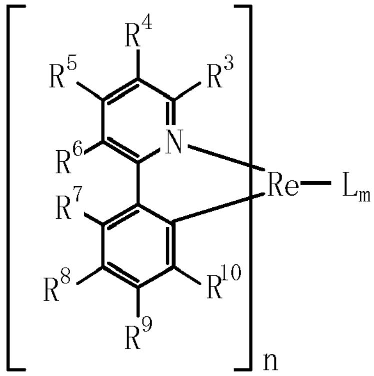

Formula (10)

wherein, in the formula (10), $R^3$ to $R^{10}$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom; "n" represents an integer of 1 to 3; the letter "L" represents the other ligand which saturates the coordination number of the rhenium (Re) atom, and neutralizes the charge of the whole complex; and "m" represents an integer of 0 to 4.

**5.** An organic EL element according to claim 1, wherein the organometallic complex is represented by the following formula (11) and the one ligand comprises 2-phenyloxazoline skeleton:

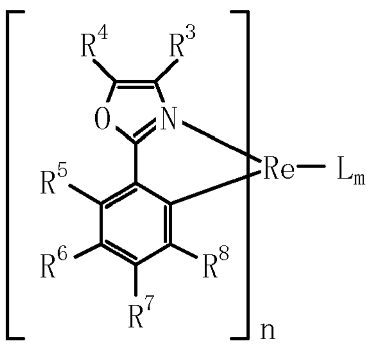

Formula (11)

wherein, in the formula (11), $R^3$ to $R^8$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom; "n" represents an integer of 1 to 3; the letter "L" represents the other ligand which saturates the coordination number of the rhenium (Re) atom, and neutralizes the charge of the whole complex; and "m" represents an integer of 0 to 4.

**6.** An organic EL element according to claim 1, wherein the organometallic complex is represented by the following formula (12) and the one ligand comprises 2-phenylthiozoline skeleton:

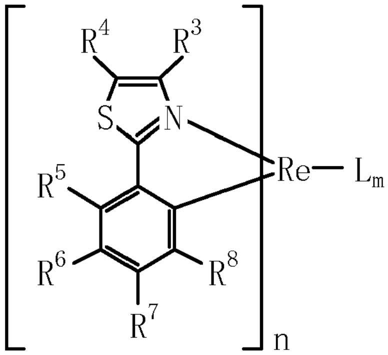

Formula (12)

wherein, in the formula (12), $R^3$ to $R^8$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom; "n" represents an integer of 1 to 3; the letter "L" represents the other ligand which saturates the coordination number of the rhenium (Re) atom, and neutralizes the charge of the whole complex; and "m" represents an integer of 0 to 4.

**7.** An organic EL element according to claim 1, wherein the organometallic complex is represented by the following formula (13) and the one ligand comprises 2-(2'-thienyl)pyridine skeleton:

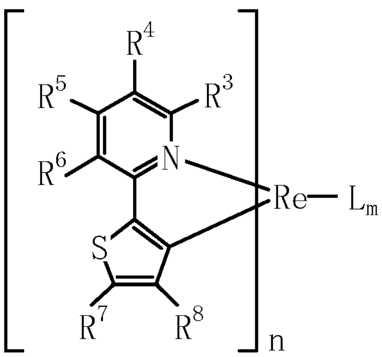

Formula (13)

wherein, in the formula (13), $R^3$ to $R^8$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom; "n" represents an integer of 1 to 3; the letter "L" represents the other ligand which saturates the coordination number of the rhenium (Re) atom, and neutralizes the charge of the whole complex; and "m" represents an integer of 0 to 4.

**8.** An organic EL element according to claim 1, wherein the organometallic complex is represented by the following formula (14) and the one ligand comprises 2-(2'-thienyl)thiozoline skeleton:

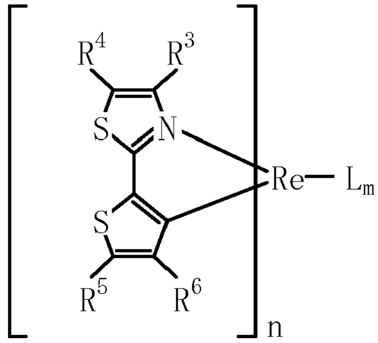

Formula (14)

wherein, in the formula (14), $R^3$ to $R^8$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom; "n" represents an integer of 1 to 3; the letter "L" represents the other ligand which saturates the coordination number of the rhenium (Re) atom, and neutralizes the charge of the whole complex; and "m" represents an integer of 0 to 4.

**9.** An organic EL element according to claim 1, wherein the organometallic complex is represented by the following formula (15) and the one ligand comprises 3-(2'-thiozolyl)-2H-pyran-2-one skeleton:

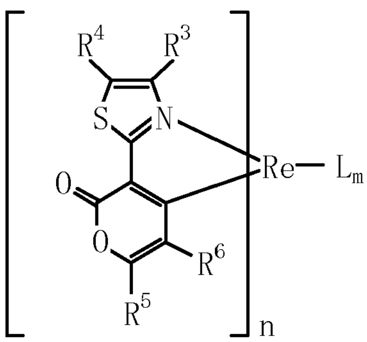

Formula (15)

wherein, in the formula (15), $R^3$ to $R^6$ may be the same or different, each representing a hydrogen atom or a substituent group which may optionally be substituted, wherein an adjacent pair thereof may join together to form an aromatic ring which contains one of a nitrogen atom, a sulphur atom and an oxygen atom; "n" represents an integer of 1 to 3; the letter "L" represents the other ligand which saturates the coordination number of the rhenium (Re) atom, and neutralizes the charge of the whole complex; and "m" represents an integer of 0 to 4.

**10.** An organic EL element comprising a color conversion layer,
wherein the color conversion layer is capable of emitting phosphorescence and is capable of converting incident light into light having a wavelength longer than the wavelength thereof by 100 nm or more.

**11.** An organic EL element according to claim 10, wherein the color conversion layer is capable of converting incident light into light having a wavelength longer than the wavelength thereof by 150 nm or more.

**12.** An organic EL element according to one of claims 10 and 11, wherein the color conversion layer is capable of converting light in the wavelength range of ultraviolet light to blue light into red light.

**13.** An organic EL element according to any one of claims 10 to 12, wherein the color conversion layer comprises at least one selected from (1) an organometallic complex which comprises a rhenium (Re) atom; one ligand which comprises a coordinated nitrogen atom and a coordinated oxygen atom, each coordinated with the rhenium (Re)

atom, and comprises at least one π conjugation part; and the other ligand coordinated with the rhenium (Re) atom in such a way that the ligand saturates the coordination number of the rhenium (Re) atom and the charge of the whole organometallic complex is neutral, (2) an organometallic complex which comprises an rhenium (Re) atom; one ligand which comprises a coordinated nitrogen atom, a coordinated carbon atom, each coordinated with the rhenium (Re) atom, and comprises at least one π conjugation part; and the other ligand coordinated with the rhenium (Re) atom in such a way that the ligand saturate the coordination number of the rhenium (Re) atom and the charge of the whole organometallic complex is neutral, and (3) an organometallic complex which comprises at least one of Group 8 metal atoms selected from Group 8 metal element; one ligand which comprises at least one π conjugation part and is coordinated with the Group 8 metal atom; and a dithiolate ligand which is selected from an aliphatic dithiolate ligand and a heteroaromatic dithiolate ligand, and is coordinated with the Group 8 metal atom.

**14.** An organic EL element according to any one of claims 1 to 13, which is used for lighting units.

**15.** An organometallic complex comprising:

a rhenium (Re) atom;
one ligand which comprises a coordinated nitrogen atom and a coordinated carbon atom, each coordinated with the rhenium (Re) atom, and comprises at least one π conjugation part; and
the other ligand coordinated with the rhenium (Re) atom in such a way that the ligand saturates the coordination number of the rhenium (Re) atom and the charge of the whole organometallic complex is neutral, and
which organometallic complex is used for an organic EL element.

**16.** An organometallic complex according to any one of claim 15, which is used as at least one of a luminescent material and a color conversion material.

**17.** An organic EL display, comprising the organic EL element according to any one of claims 1 to 14.

**18.** An organic EL display according to claim 17, further comprising:

a pair of electrodes;
an organic thin film layer disposed between the pair of electrodes which is capable of emitting EL light; and
a color conversion layer,

wherein at least one of the pair of electrodes is transparent and at least one of the pair of electrodes corresponds to pixels,
wherein the color conversion layer is arranged on at least a green pixel and a red pixel in the pixels.

**19.** An organic EL display according to one of claims 17 and 18, further comprising:

a color conversion layer arranged on a blue pixel; and
a color conversion layer arranged on a red pixel,

wherein light-emitting light due to EL luminescence is white light,
wherein the color conversion layer arranged on a red pixel comprises at least one selected from the organometallic complex according to claim 16.

**20.** An organic EL display according to one of claims 17 and 18, further comprising:

a color conversion layer arranged on a red pixel; and

wherein light-emitting light due to EL luminescence is blue light,
wherein the color conversion layer arranged on a red pixel comprises at least one selected from the organometallic complex according to claim 15 or 16.

FIG. 1

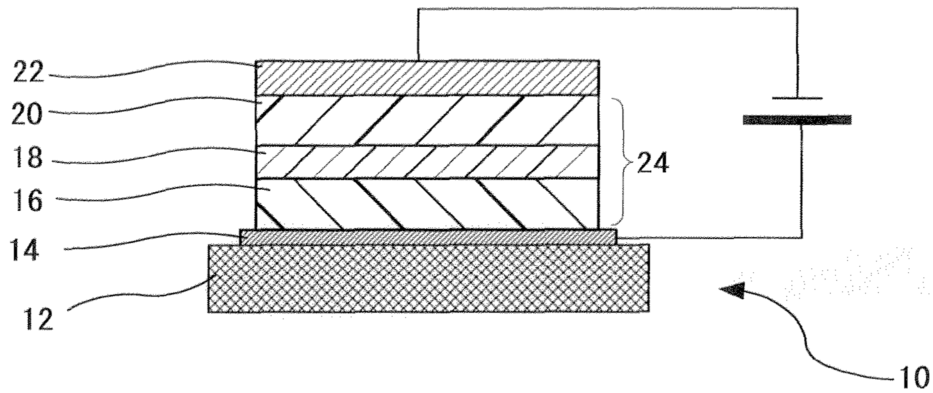


FIG. 2

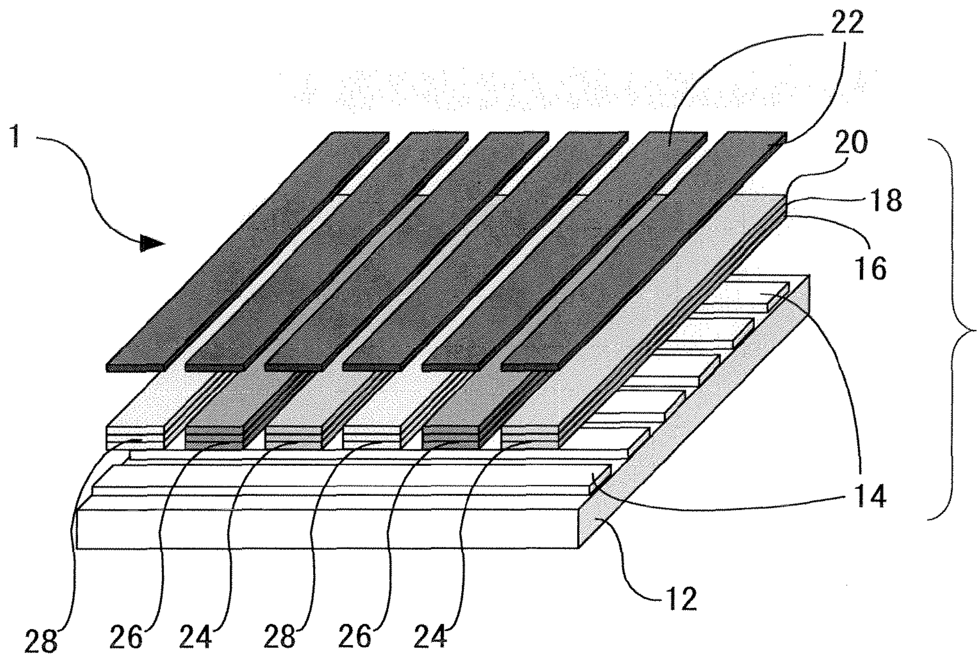

FIG. 3

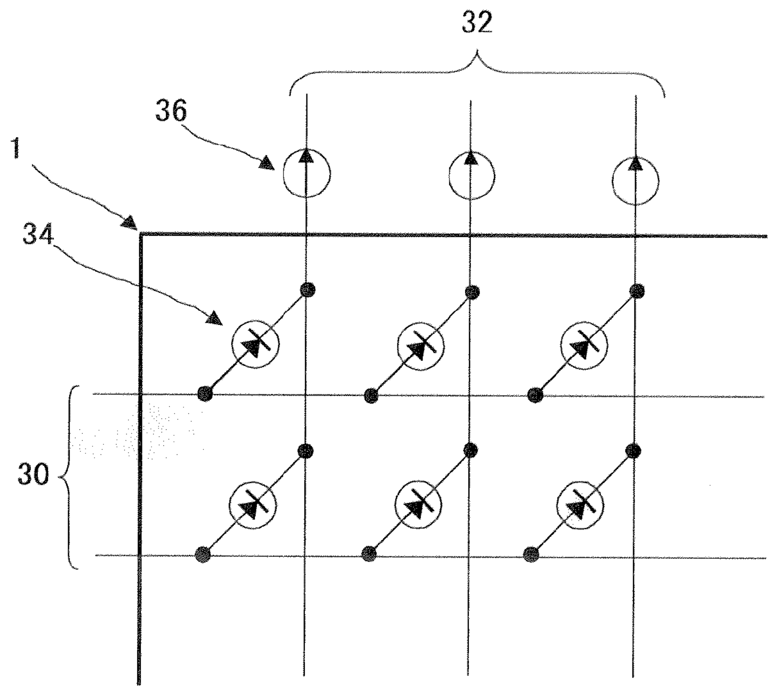


FIG. 4

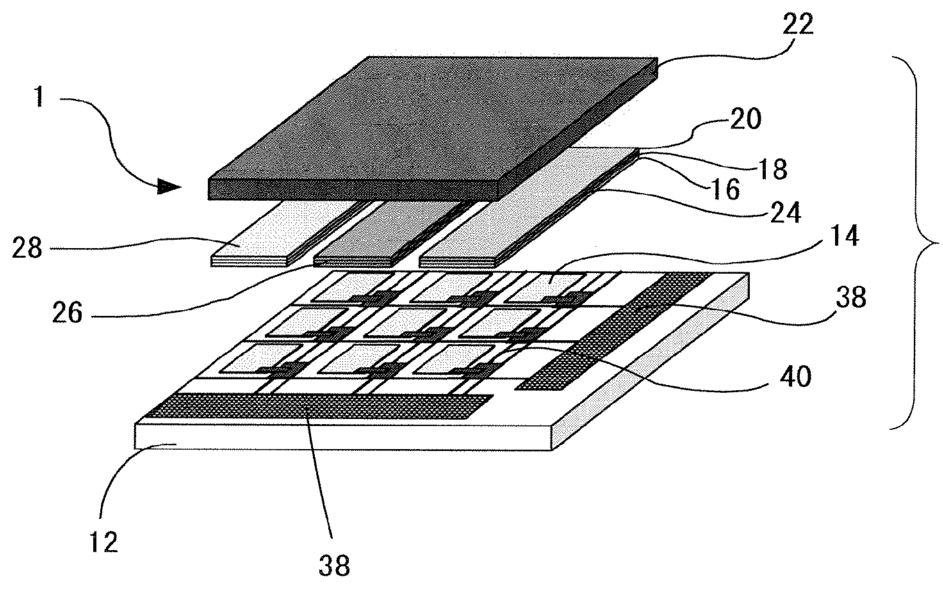

FIG. 5

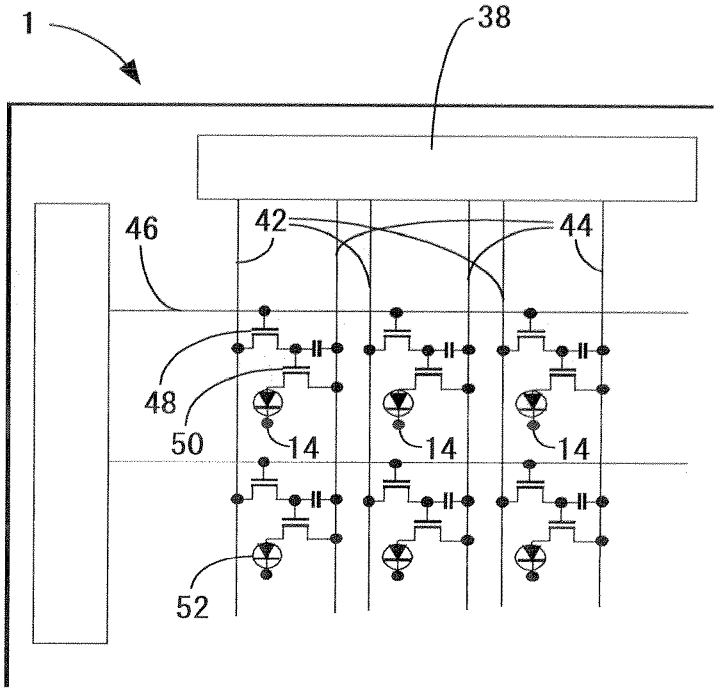


FIG. 6

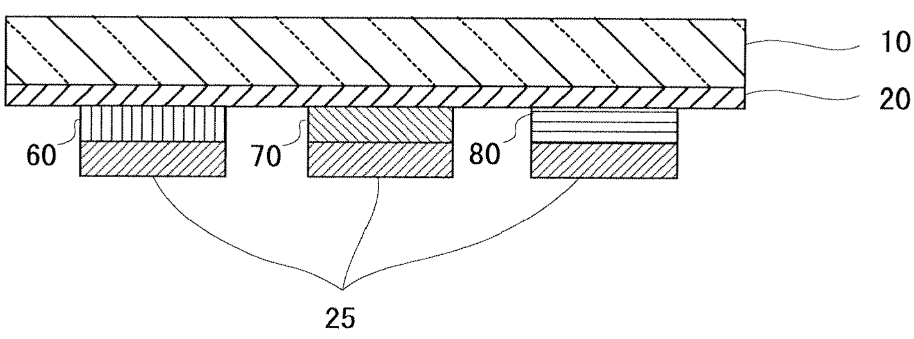

FIG. 7

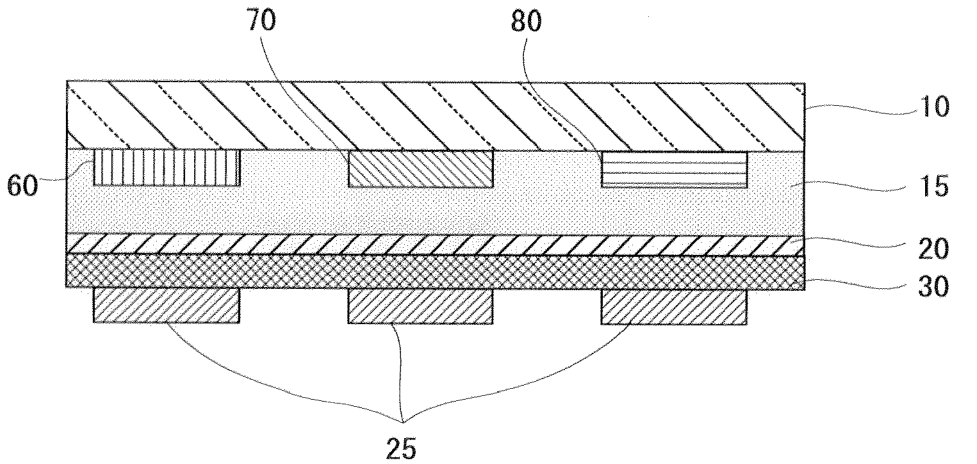


FIG. 8

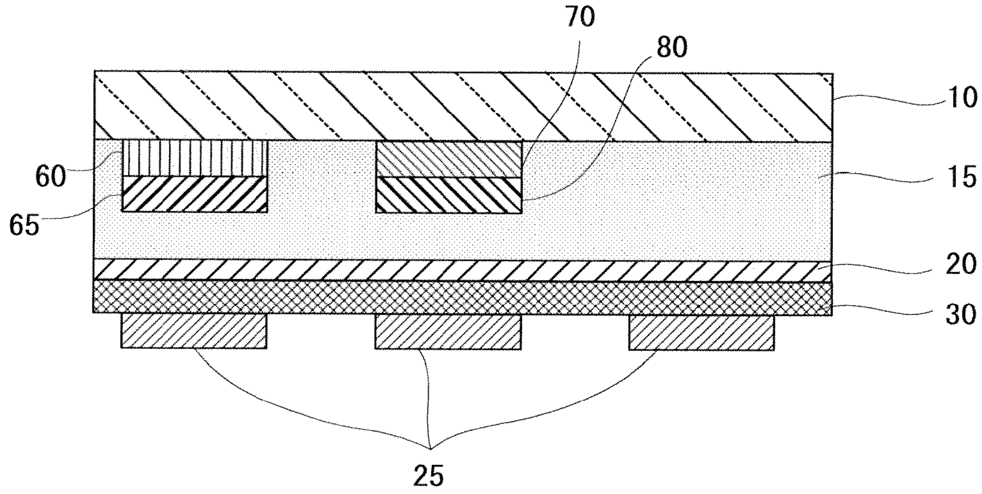

# FIG. 9

(1) Pt (dpphen) (ecda)

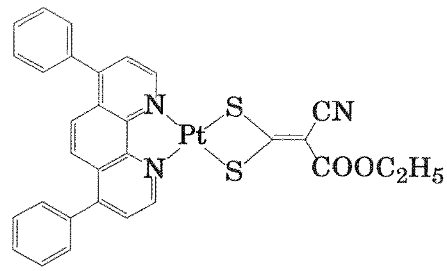

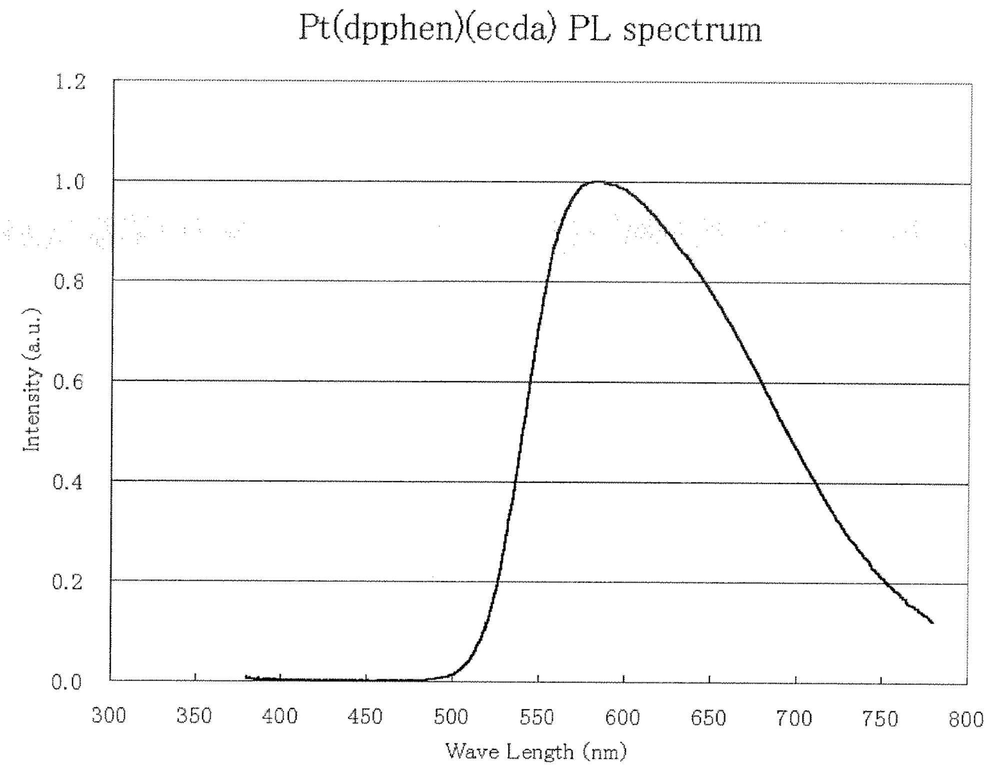

# FIG. 10

(2) Pt(tmphen)(ecda)

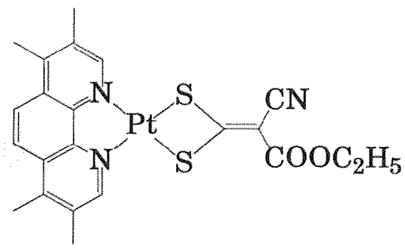

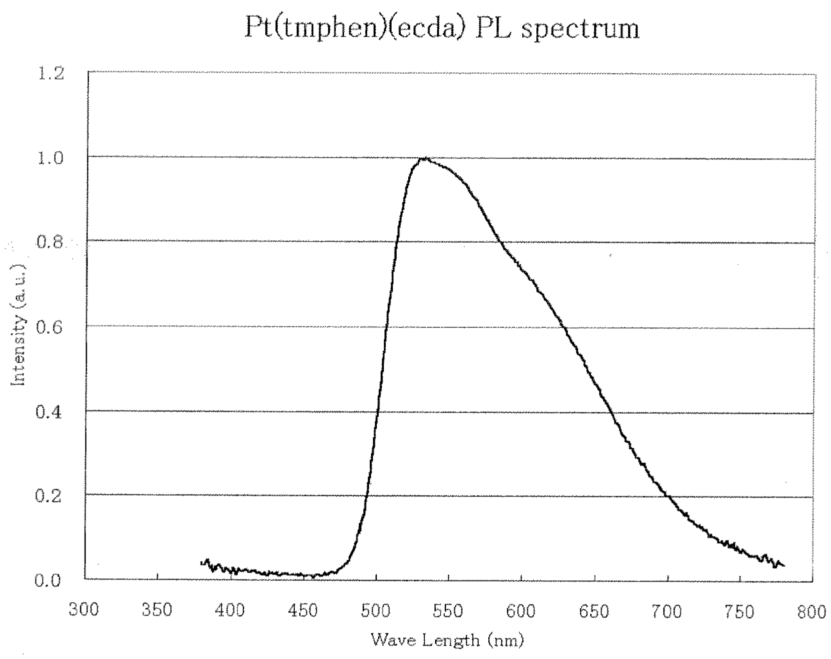

# FIG. 11

(3) Pt (phen) (ecda)

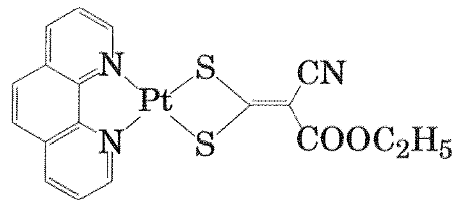

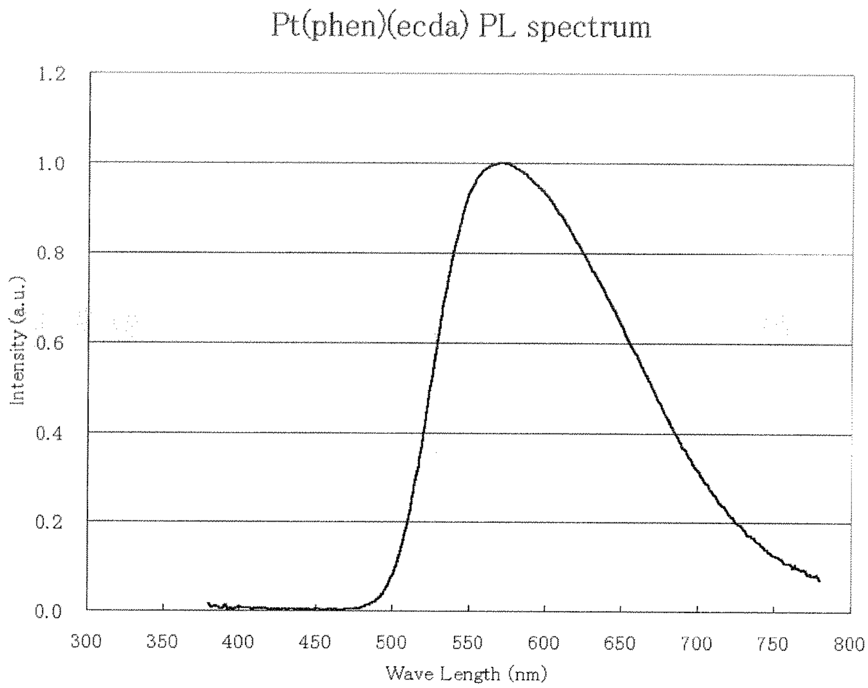

# FIG. 12

(4) Pt(bpy)(ecda)

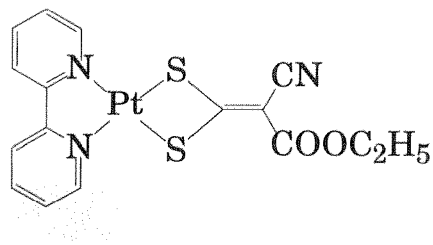

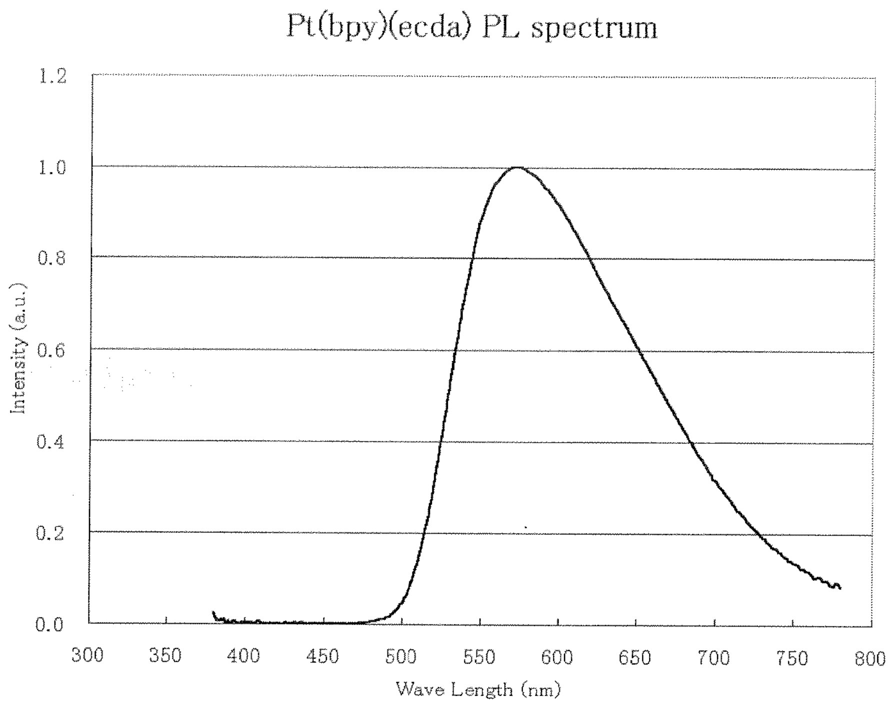

# FIG. 13

(5) Pt(bcp)(ecda)

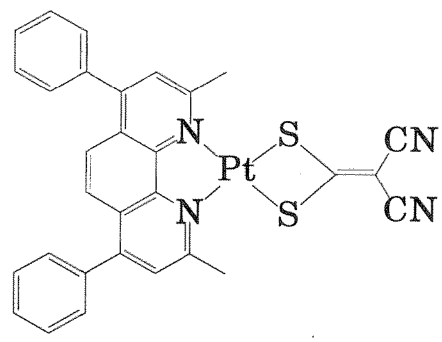

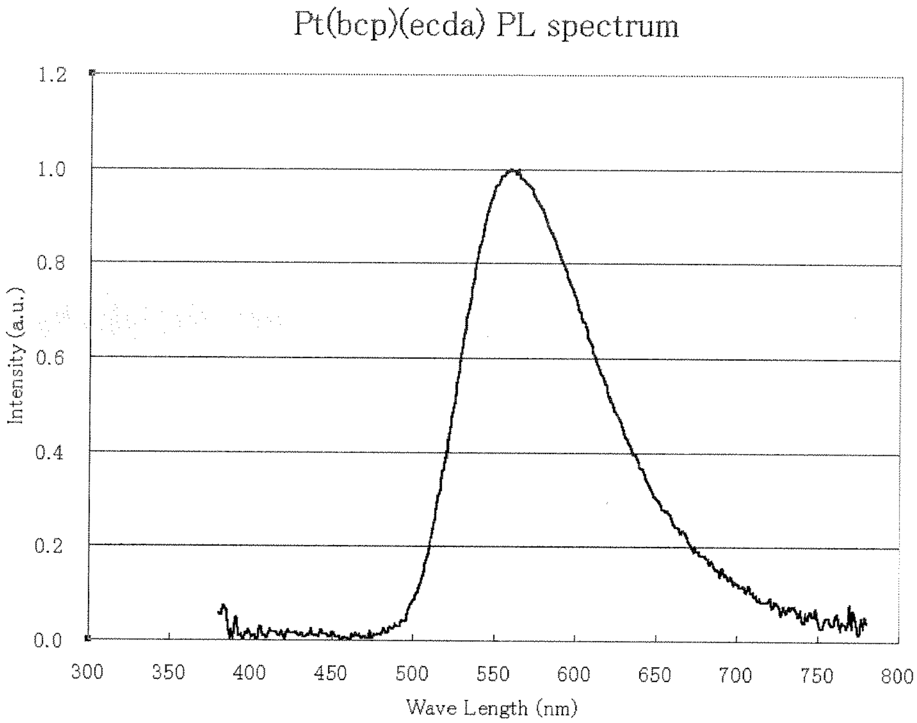

# FIG. 14

(6) Pt(4dmbpy)(ecda)

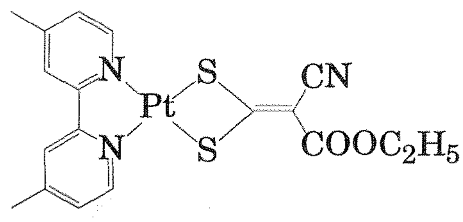

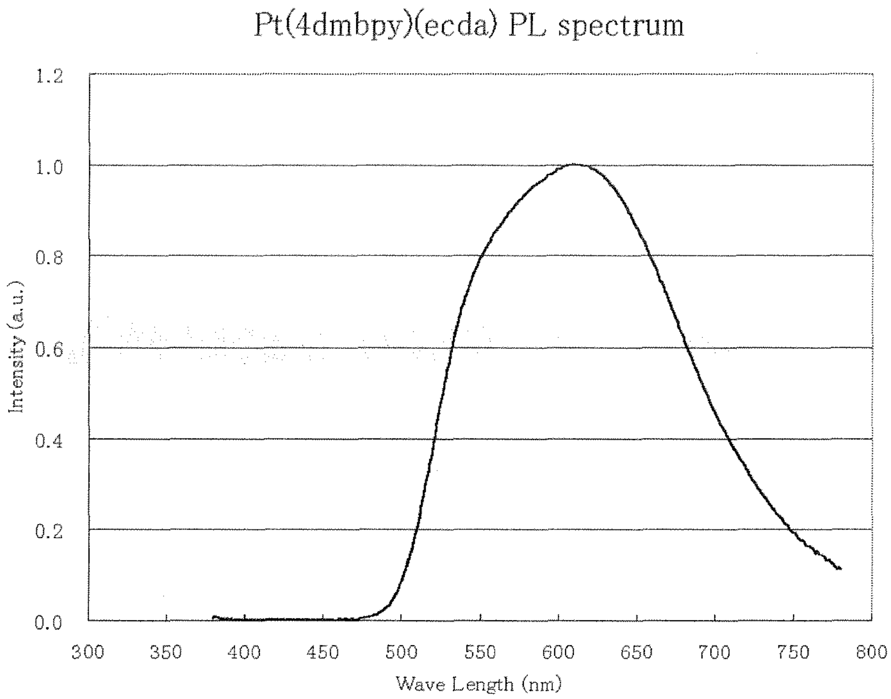

# FIG. 15

(7) Pt(5dmbpy)(ecda)

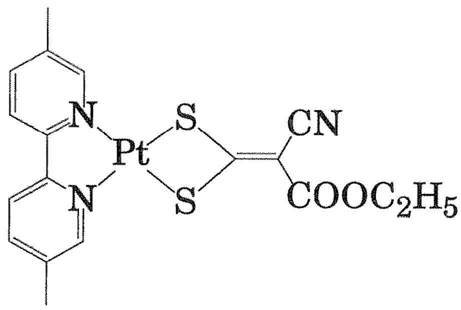

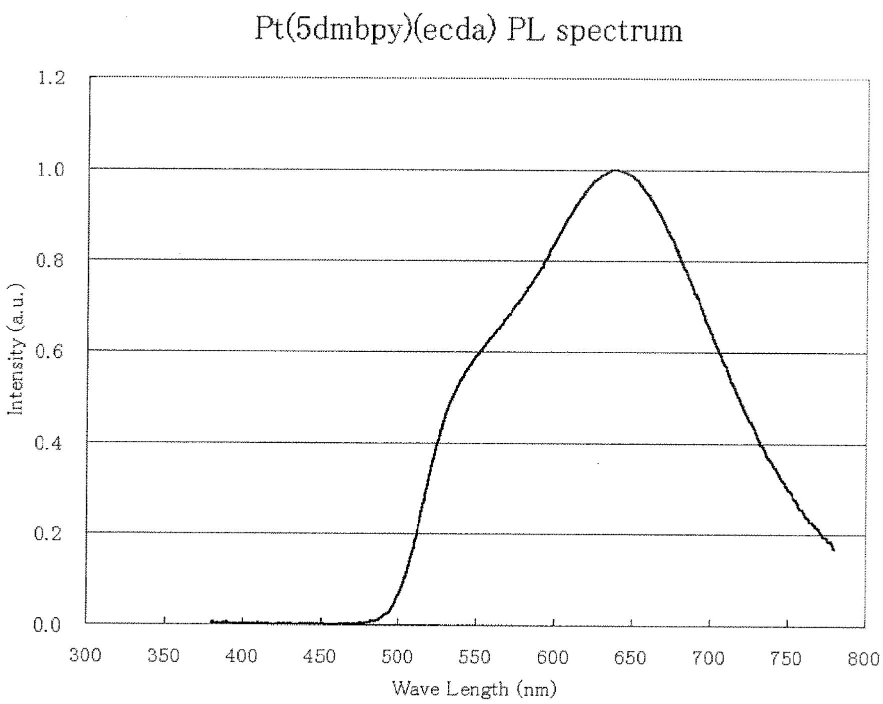

# FIG. 16

(8) Pt(dbbpy)(ecda)

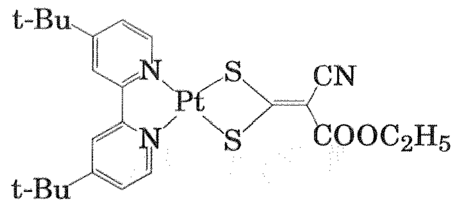

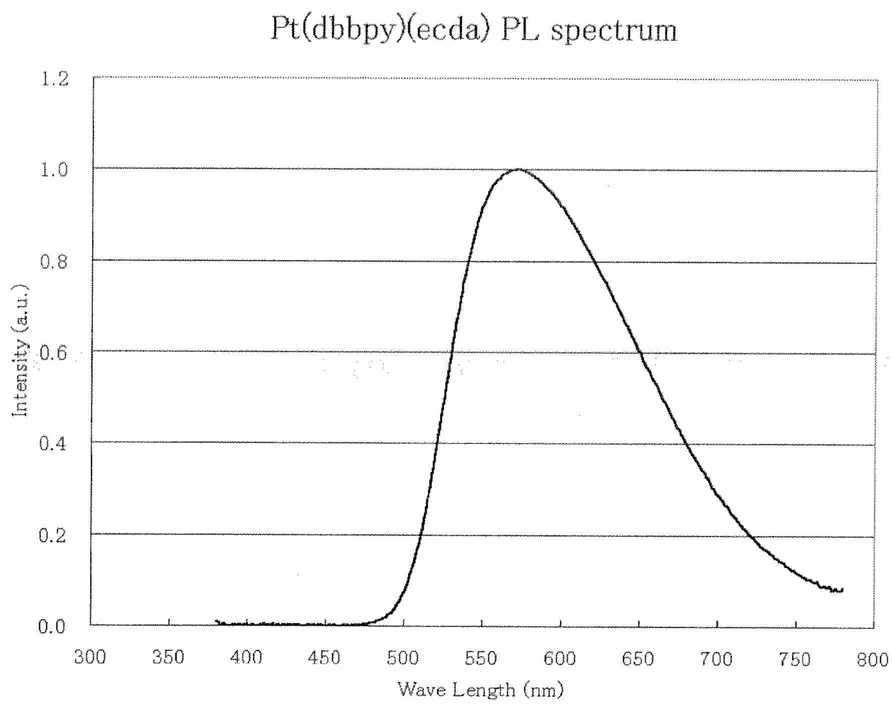

# FIG. 17

(9) Pt(dpphen)(qdt)

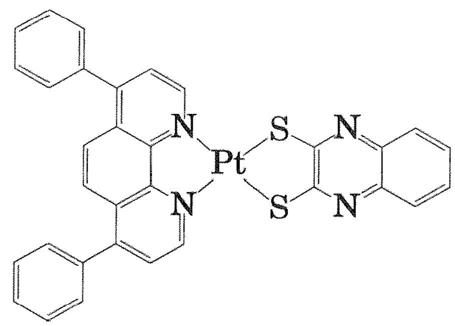

Pt(dpphen)(qdt) PL spectrum

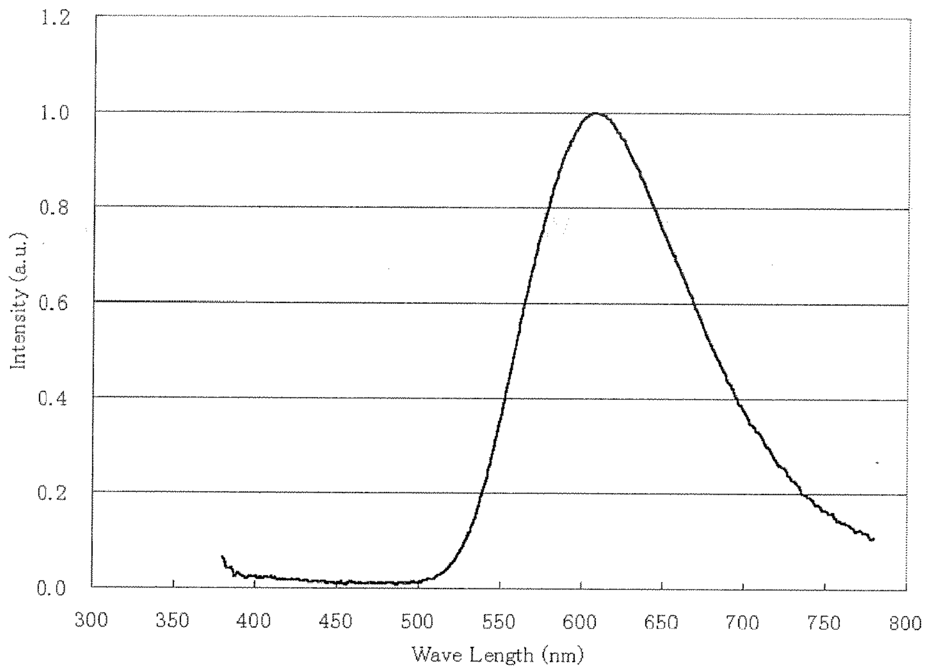

# FIG. 18

(10) Pt(tmphen)(qdt)

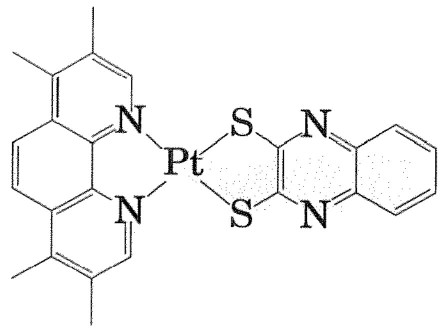

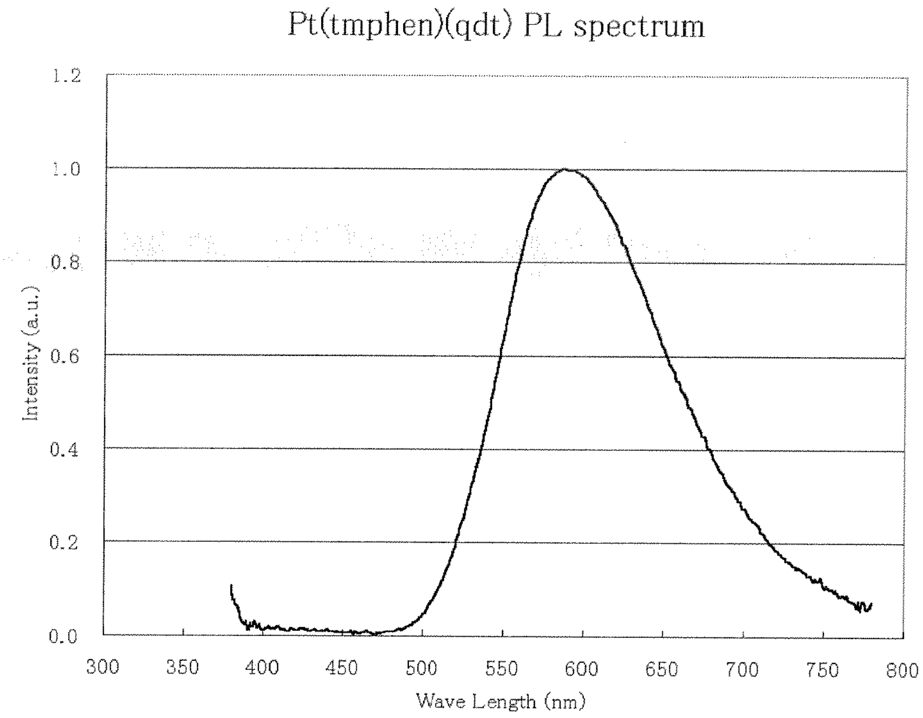

FIG. 19

(11) Pt(phen)(qdt)

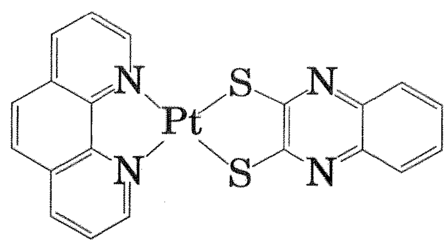

Pt(phen)(qdt) PL spectrum

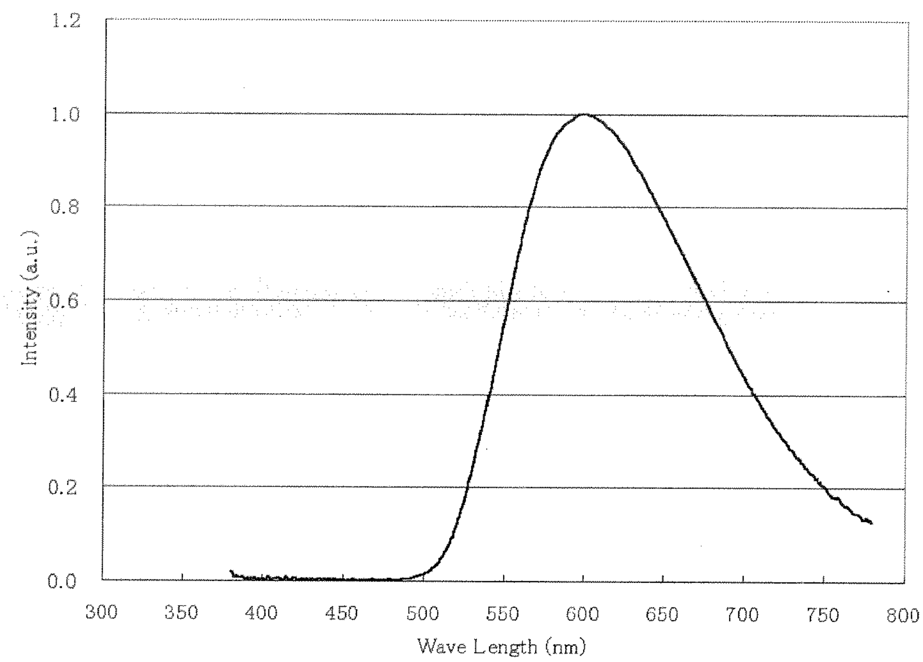

# FIG. 20

(12) Pt(bpy)(qdt)

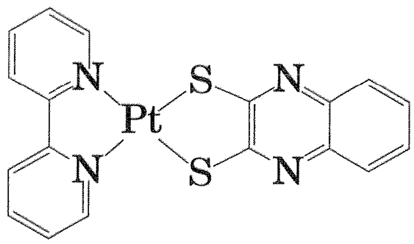

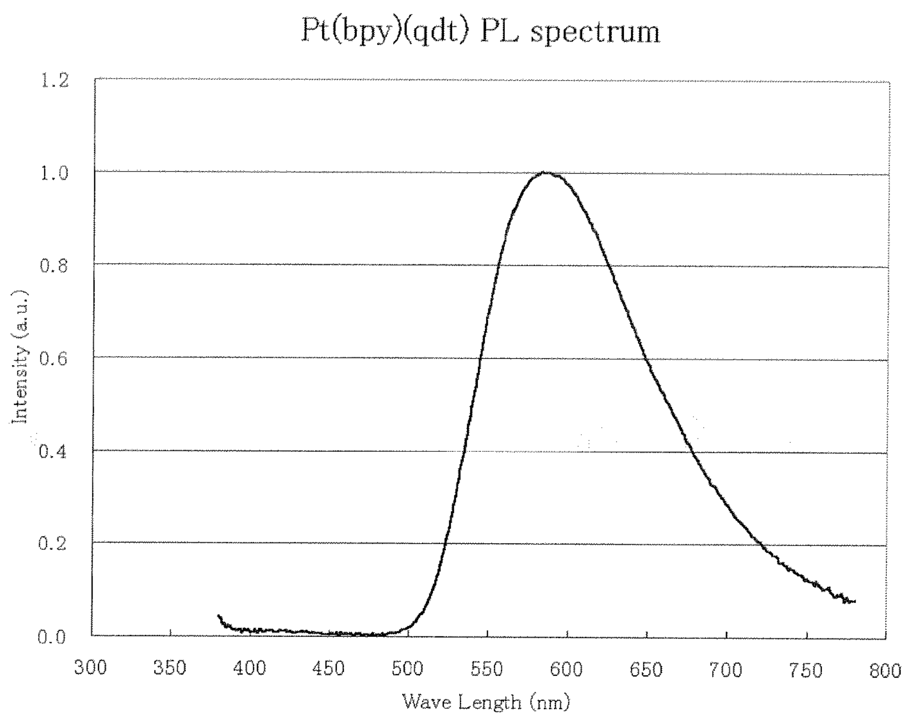

# FIG. 21

(13) Pt(bcp)(qdt)

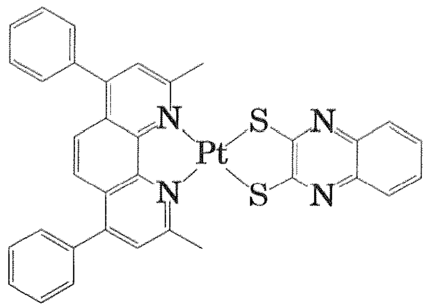

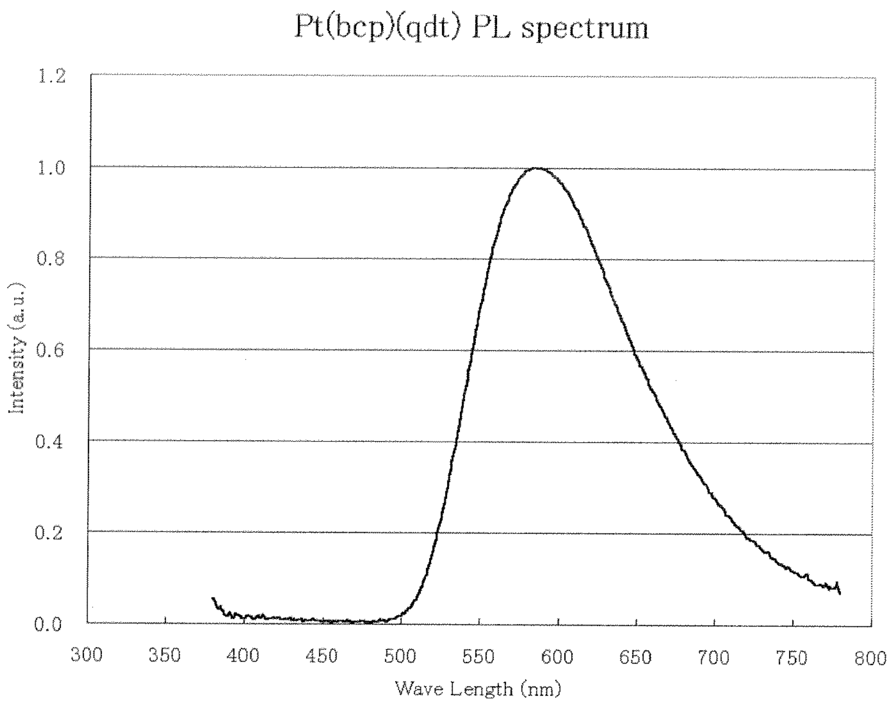

# FIG. 22

(14) Pt(4dmbpy)(qdt)

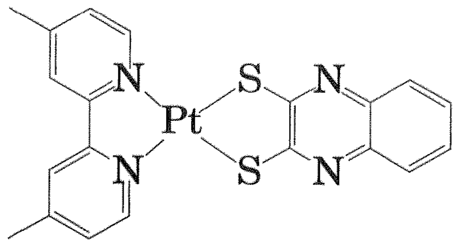

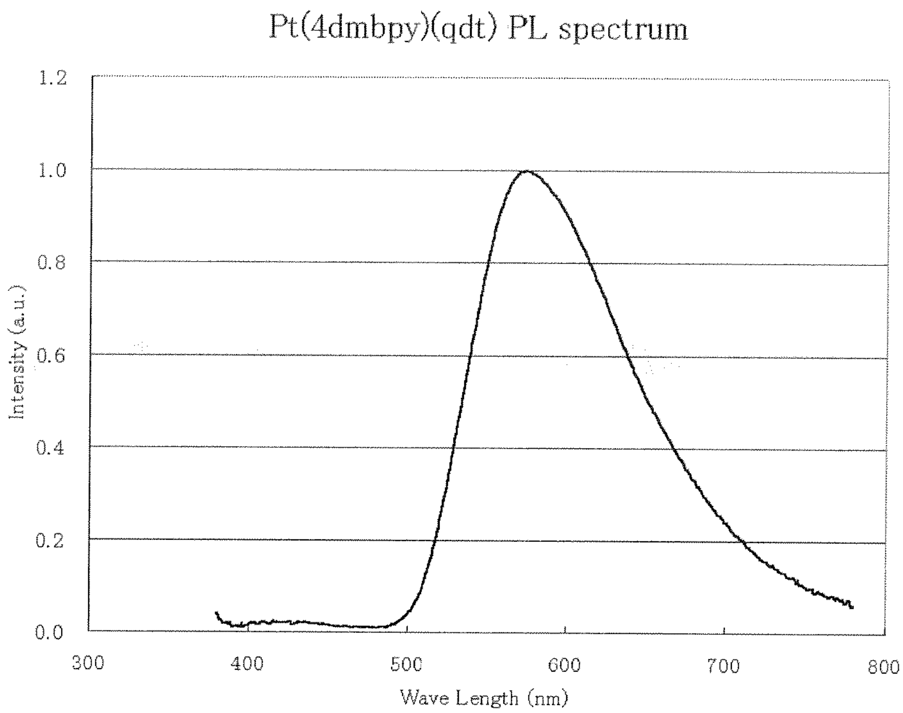

# FIG. 23

(15) Pt(5dmbpy)(qdt)

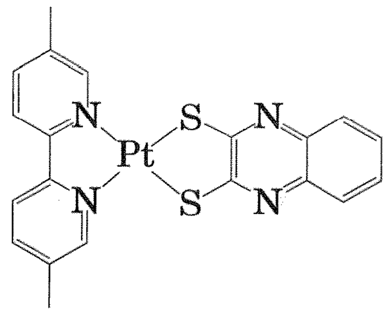

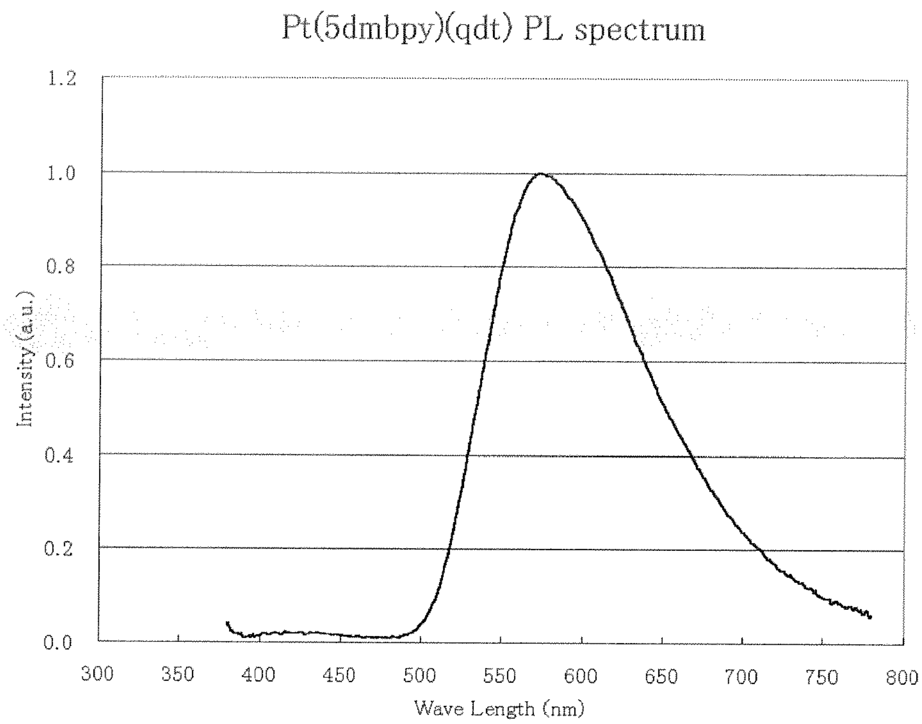

# FIG. 24

(16) Pt(dbbpy)(qdt)

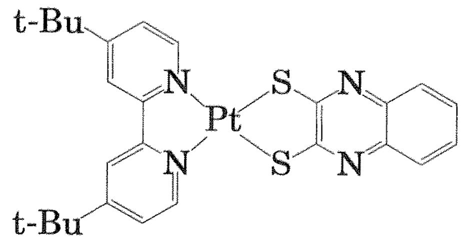

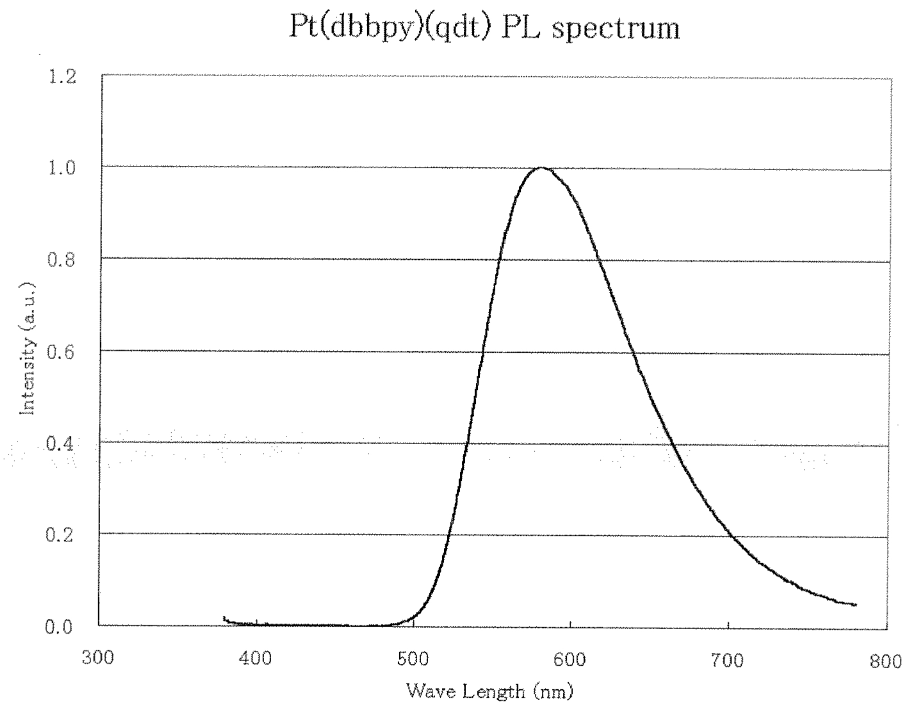

# FIG. 25

(17) Pt(dpphen)(dce)

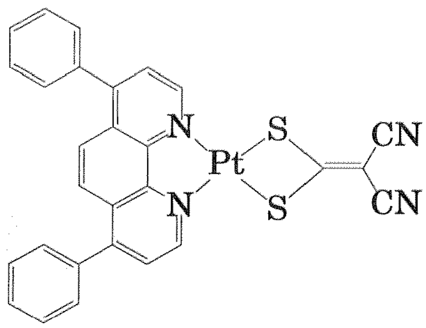

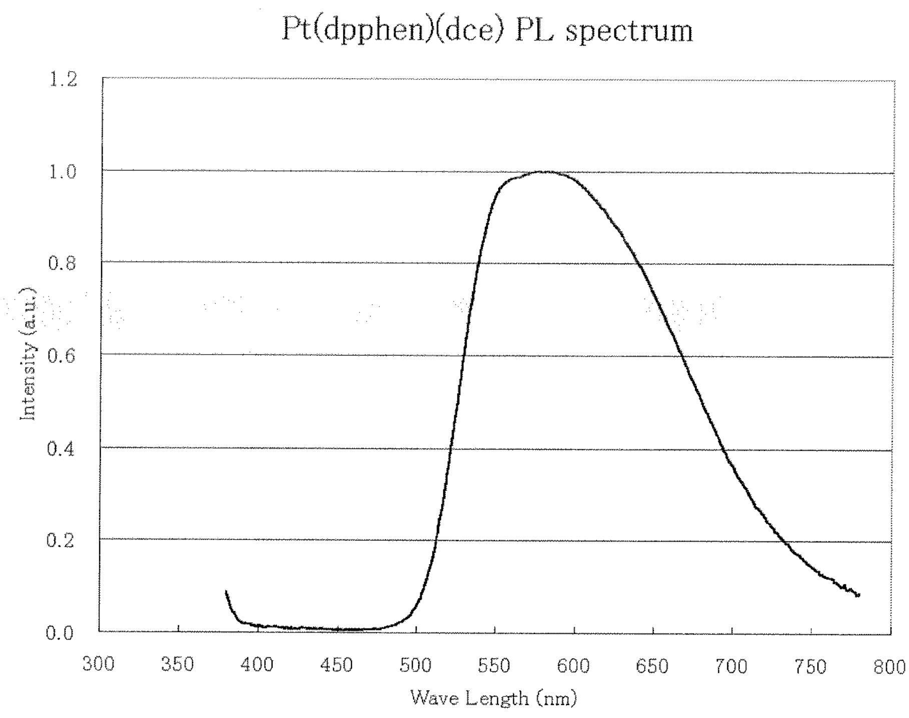

# FIG. 26

(18) Pt(tmphen)(dce)

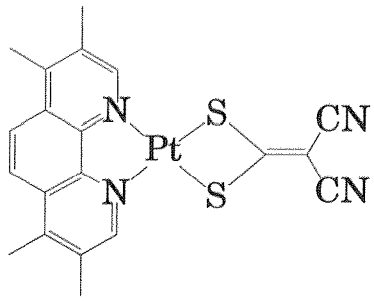

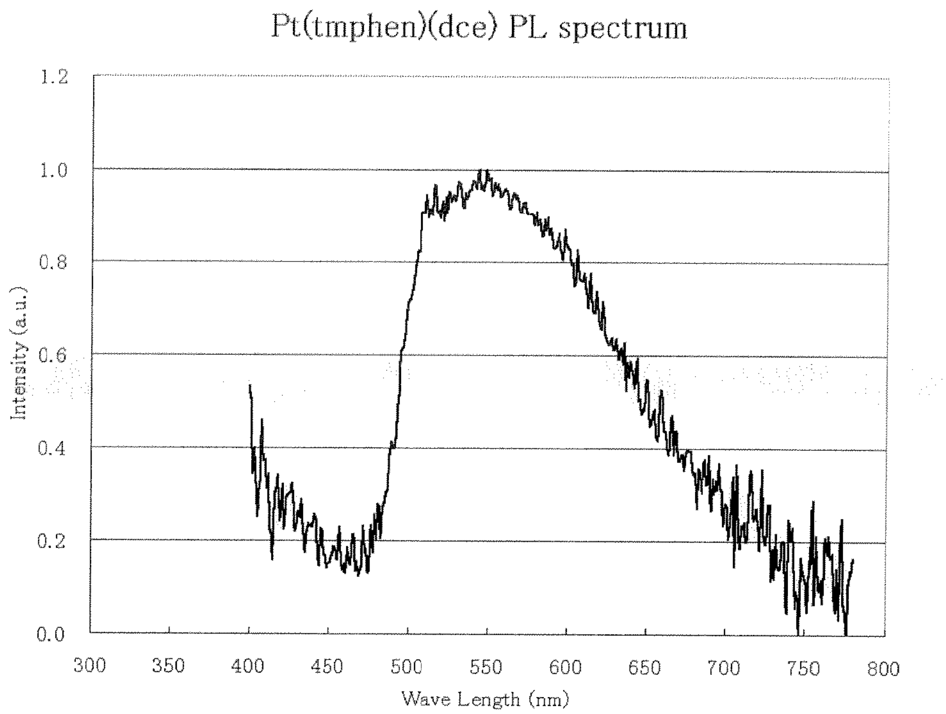

# FIG. 27

(19) Pt(phen)(dce)

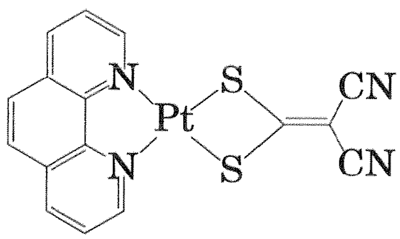

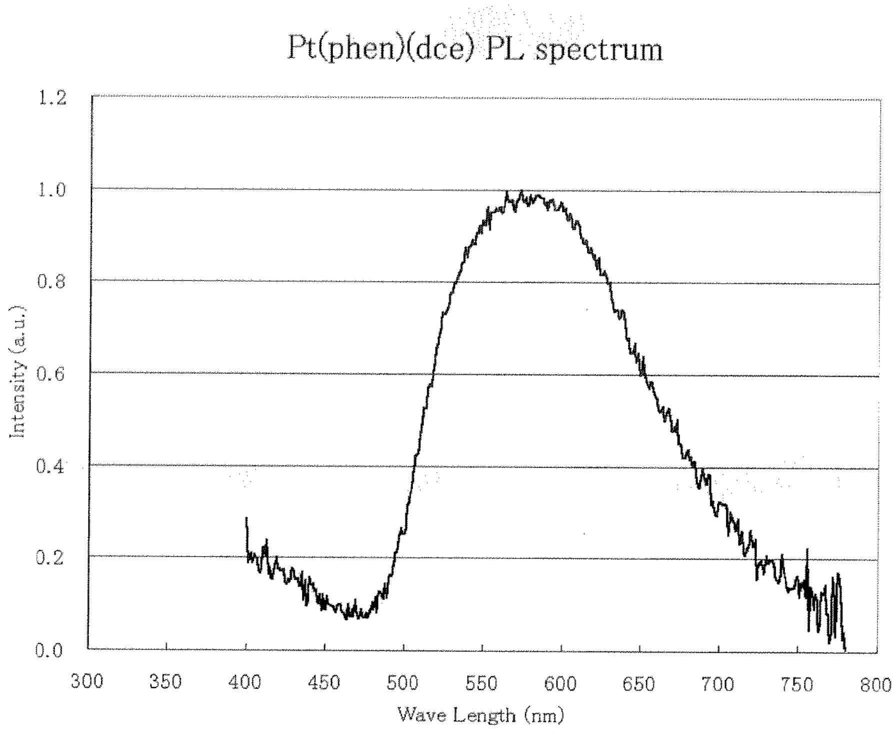

# FIG. 28

(20) Pt(bpy)(dce)

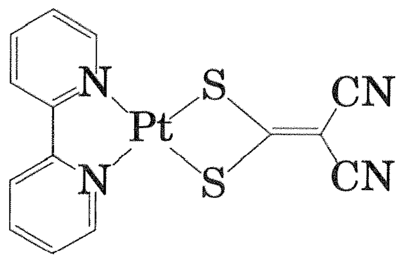

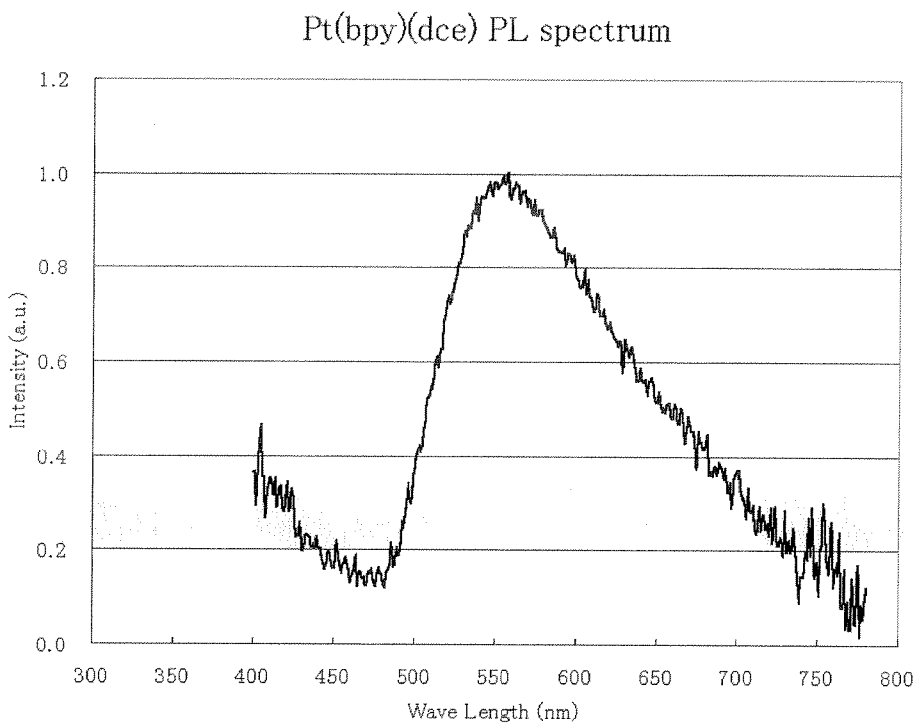

# FIG. 29

(21) Pt(bcp)(dce)

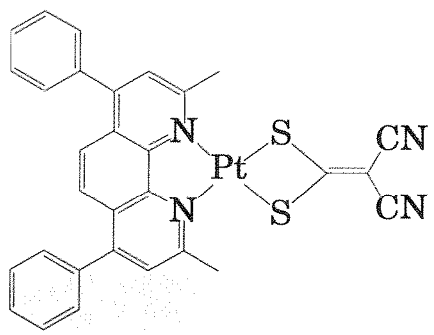

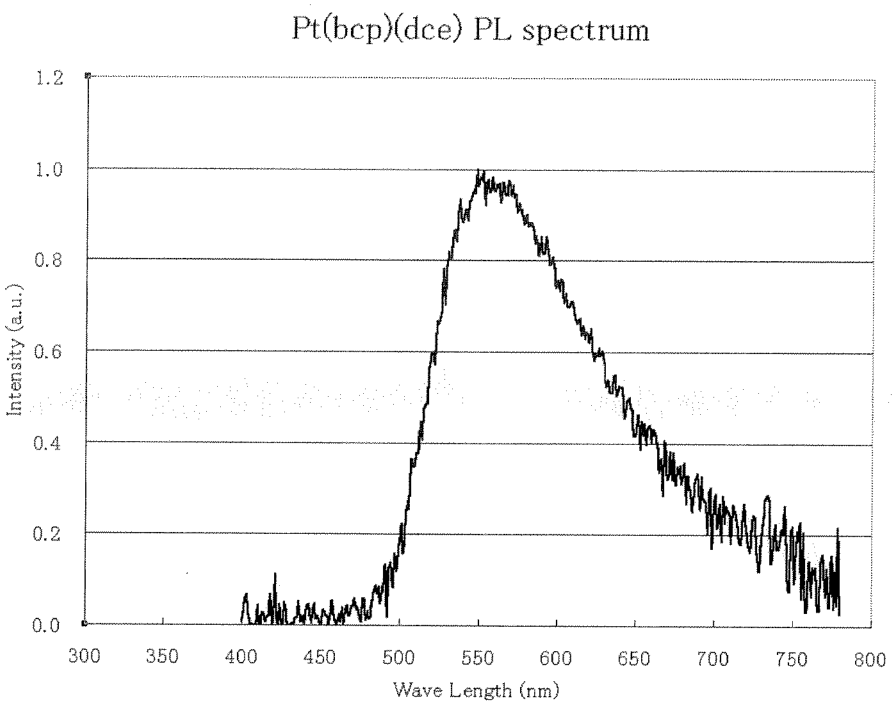

# FIG. 30

(22) Pt(4dmbpy)(dce)

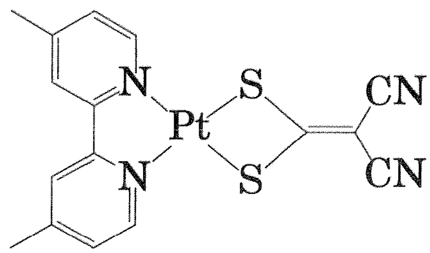

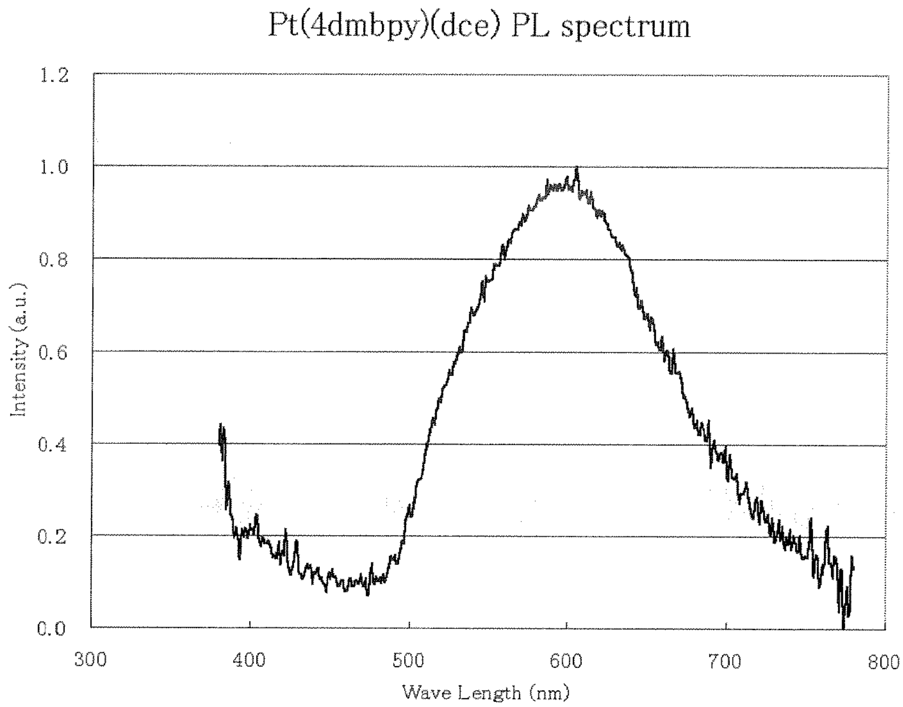

# FIG. 31

(23) Pt(5dmbpy)(dce)

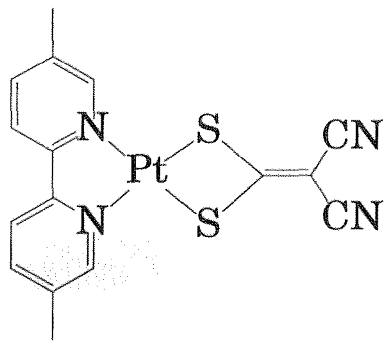

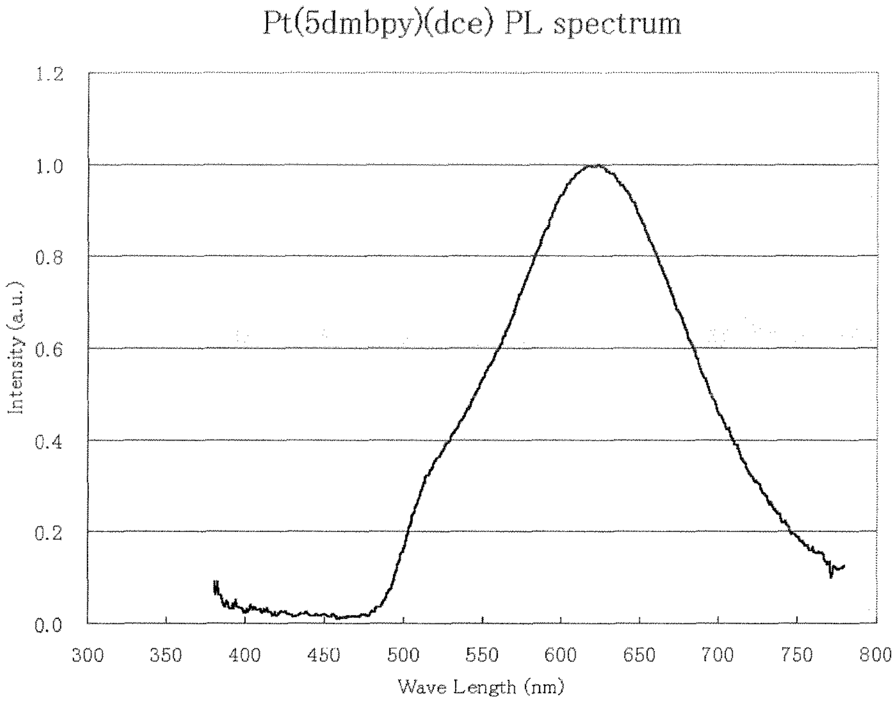

FIG. 32

(24) Pt(dbbpy)(dce)

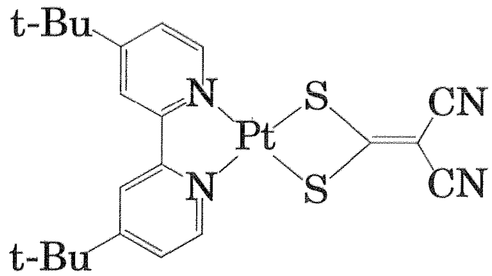

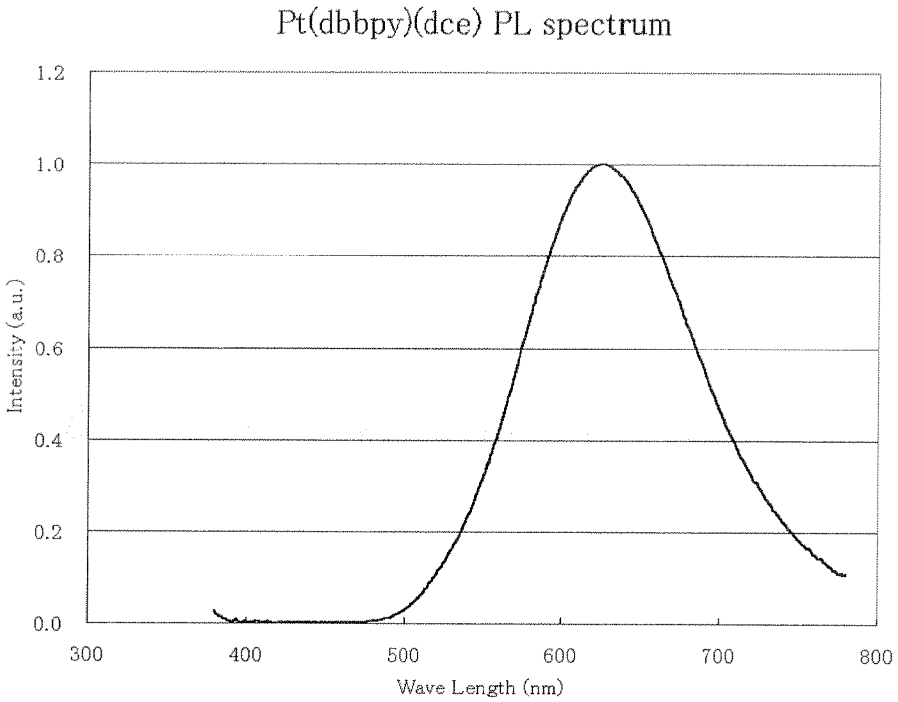

# FIG. 33

(25) Pt(dmbpy)(tdt)

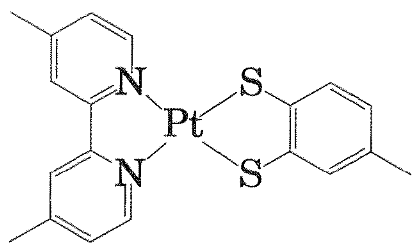

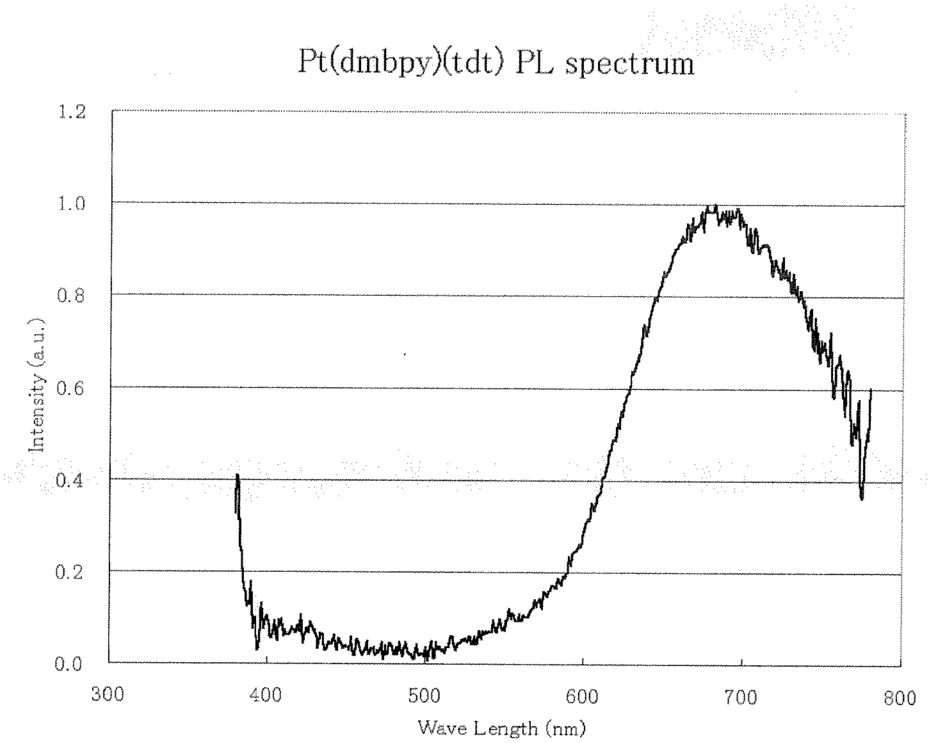

# FIG. 34

(26) Pt(dbbpy)(tdt)

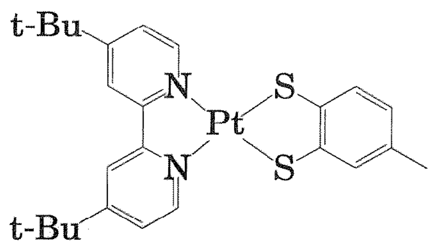

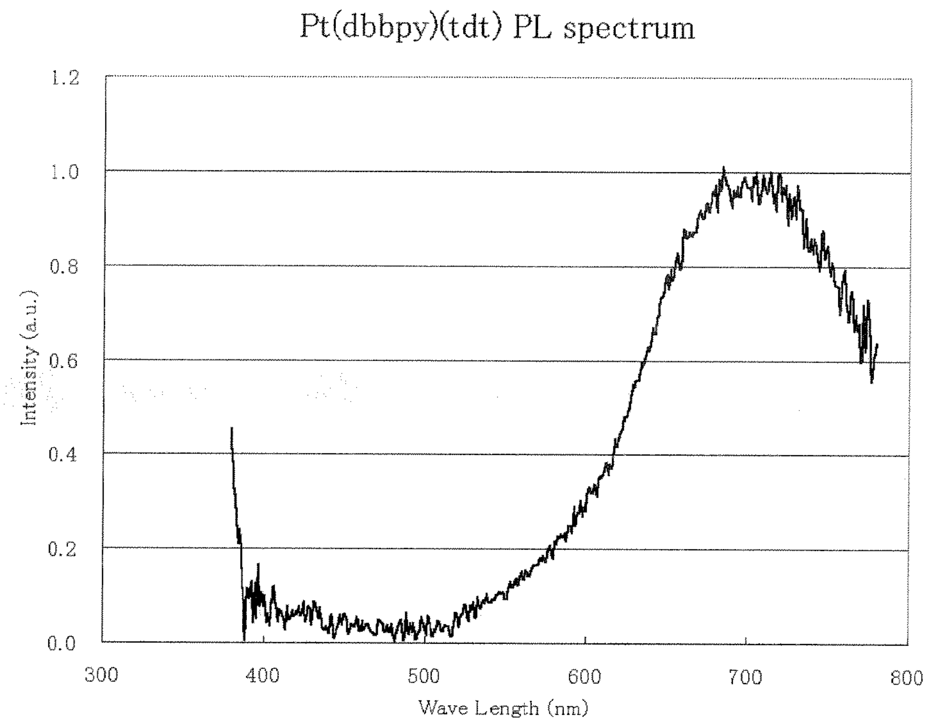

Europäisches Patentamt
European Patent Office
Office européen des brevets

# EUROPEAN SEARCH REPORT

Application Number
EP 10 18 2429

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | WO 03/076549 A (CANON KABUSHIKI KAISHA; TSUBOYAMA, AKIRA; OKADA, SHINJIRO; TAKIGUCHI,) 18 September 2003 (2003-09-18)<br>* the whole document * | 1-4, 10-14, 17-20 | INV. C09K11/06 H05B33/14 |
| X | JP 2002 173674 A (FUJI PHOTO FILM CO LTD) 21 June 2002 (2002-06-21) | 1,2,4, 10-14, 17-20 | |
| Y | * compounds E-43, E-44, E-45, E-46, E-47, E-48, E-49, E-50, E-51, E-52 *<br>* abstract * | 7 | |
| Y | JP 2001 247859 A (FUJI PHOTO FILM CO LTD) 14 September 2001 (2001-09-14)<br>* abstract * | 7 | |
| X | SPELLANE P; WATTS R J: "Luminescence Characterization of Cyclometalated Rhenium(I) Carbonyl Complexes", INORGANIC CHEMISTRY, vol. 32, 1993, pages 5633-5636, XP002368152,<br>* figure 1 * | 1-3, 10-14, 17-20 | |
| X | VOGLER A; KUNKELY H: "Excited state properties of organometallic compounds of rhenium in high and low oxidation states", COORDINATION CHEMISTRY REVIEWS, vol. 200-202, 2000, pages 991-1008, XP002368153,<br>* the whole document * | 1-3, 10-14, 17-20 | TECHNICAL FIELDS SEARCHED (IPC)<br>C09K<br>H05B |
| A | JP 9 176629 A (TOYO INK MFG CO) 8 July 1997 (1997-07-08)<br>* abstract * | 1-20 | |

-/--

The present search report has been drawn up for all claims

| Place of search | Date of completion of the search | Examiner |
|---|---|---|
| The Hague | 26 October 2010 | Lehnert, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2

EPO FORM 1503 03.82 (P04C01)

Europäisches Patentamt
European Patent Office
Office européen des brevets

# EUROPEAN SEARCH REPORT

Application Number
EP 10 18 2429

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CZERWIENIEC RAFAL ET AL: "Monomeric and dimeric Re(I) (tricabonyl) (8-quinolinato) complexes", JOURNAL OF THE CHEMICAL SOCIETY, DALTON TRANSACTIONS, CHEMICAL SOCIETY. LETCHWORTH, GB, no. 19, November 2001 (2001-11), pages 2756-2761, XP002976354, ISSN: 1472-7773 * the whole document * ----- | 1-20 | |
| A | LI Y ET AL: "Carbonyl polypyridyl Re(I) complexes as organic electroluminescent material", SYNTHETIC METALS, ELSEVIER SEQUOIA, LAUSANNE, CH, vol. 99, 1999, pages 257-260, XP002247229, ISSN: 0379-6779 * the whole document * ----- | 1-20 | |
| A | LI Y: "Photoluminescent and electroluminescent properties of phenol-pyridine beryllium and carbonyl polypyridyl Re(I) complexes codeposited films", SYNTHETIC METALS, ELSEVIER SEQUOIA, LAUSANNE, CH, vol. 118, 2001, pages 175-179, XP002247230, ISSN: 0379-6779 * the whole document * ----- | 1-20 | TECHNICAL FIELDS SEARCHED (IPC) |
| A | WO 89/04302 A (IGEN, INC) 18 May 1989 (1989-05-18) * the whole document * ----- | 1-20 | |
| | -/-- | | |

The present search report has been drawn up for all claims

| Place of search | Date of completion of the search | Examiner |
|---|---|---|
| The Hague | 26 October 2010 | Lehnert, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2

EPO FORM 1503 03.82 (P04C01)

Europäisches Patentamt
European Patent Office
Office européen des brevets

# EUROPEAN SEARCH REPORT

Application Number
EP 10 18 2429

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,P | JP 2002 334787 A (SONY CORP) 22 November 2002 (2002-11-22) * abstract * ----- | 1-20 | |
| A,P | JP 2002 334786 A (SONY CORP) 22 November 2002 (2002-11-22) * abstract * ----- | 1-20 | |
| A | US 2001/014391 A1 (FORREST STEPHEN ROSS ET AL) 16 August 2001 (2001-08-16) * paragraphs [0058] - [0060]; claim 21; figure 10 * ----- | 1-20 | |
| A | JOHNSON C E ET AL: "LUMINESCENT IRIDIUM(I), RHODIUM(I), AND PLATINUM(II) DITHIOLATE COMPLEXES", JOURNAL OF THE AMERICAN CHEMICAL SOCIETY, AMERICAN CHEMICAL SOCIETY, WASHINGTON, DC, US, vol. 105, no. 7, 6 April 1983 (1983-04-06), pages 1795-1802, XP000577188, ISSN: 0002-7863 * the whole document * ----- | 1-20 | |

TECHNICAL FIELDS SEARCHED (IPC)

The present search report has been drawn up for all claims

2

| Place of search | Date of completion of the search | Examiner |
|---|---|---|
| The Hague | 26 October 2010 | Lehnert, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 10 18 2429

This annex lists the patent family members relating to the patent documents cited in the above-mentioned European search report.
The members are as contained in the European Patent Office EDP file on
The European Patent Office is in no way liable for these particulars which are merely given for the purpose of information.

26-10-2010

| Patent document cited in search report | Publication date | Patent family member(s) | Publication date |
|---|---|---|---|
| WO 03076549 A | 18-09-2003 | AU 2003213375 A1 | 22-09-2003 |
| | | US 2004013905 A1 | 22-01-2004 |
| JP 2002173674 A | 21-06-2002 | JP 4505162 B2 | 21-07-2010 |
| JP 2001247859 A | 14-09-2001 | JP 3929690 B2 | 13-06-2007 |
| JP 9176629 A | 08-07-1997 | JP 3475620 B2 | 08-12-2003 |
| WO 8904302 A | 18-05-1989 | AT 142622 T | 15-09-1996 |
| | | AT 259064 T | 15-02-2004 |
| | | AU 2827389 A | 01-06-1989 |
| | | CA 1340460 C | 23-03-1999 |
| | | DE 3855535 D1 | 17-10-1996 |
| | | DE 3856567 D1 | 11-03-2004 |
| | | DE 3856567 T2 | 16-12-2004 |
| | | EP 0339086 A1 | 02-11-1989 |
| | | JP 2718618 B2 | 25-02-1998 |
| | | JP 6186164 A | 08-07-1994 |
| | | JP 2538083 B2 | 25-09-1996 |
| | | JP 2501749 T | 14-06-1990 |
| | | SG 54160 A1 | 16-11-1998 |
| JP 2002334787 A | 22-11-2002 | NONE | |
| JP 2002334786 A | 22-11-2002 | NONE | |
| US 2001014391 A1 | 16-08-2001 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3214593 A
- JP 3019485 A
- JP 3152897 A
- JP 10039791 A
- JP 2002334787 A


### Non-patent literature cited in the description


- **C. W. Tang ; S. A. VanSlyke.** *Applied Physics Letters,* 1987, vol. 51, 913
- **C. W. Tang ; S. A. VanSlyke ; C. H. Chen.** *Journal of Applied Physics,* 1989, vol. 65, 3610
- *Inorg. Chem.,* 1993, vol. 1 (32), 398-401
- *Inorg. Chem.,* 1993, vol. 32, 5633-5636
- *Acta Chem. Scand.,* 1968, vol. 22, 1107-1128
- *J. Am. Chem. Soc.,* 1990, vol. 112, 5625-5627
- *J. Chem. Soc. Dalton Trans.,* 1978, 1127
- *Coord. Chem.Rev.,* 1990, vol. 97, 47-64
- Monthly Display. Techno Times Co., Ltd. of Japan, September 2000, 33-37
- Nikkei Electronics. Nikkei Business Publications Inc. of Japan, 13 March 2000, 55-62
- *Cooed. Chem. Rev.,* 1990, vol. 97, 47-64
- *Coord. Chem. Rev.,* 1990, vol. 97, 47-64
- *J. Am. Chem. Soc.,* 1996, vol. 118, 1949-1960
- *J. Chem. Soy. Dalton Trans.,* 1978, 11227
- *Acta. Chem. Scand.,* 1968, vol. 22, 1107-11231128
- **Peter Spellane ; Richard J. Watts.** *Inorg. Chem.,* 1993, vol. 32, 5633